# EUROPEAN PATENT APPLICATION

(11) **EP 4 787 239 A1**
(43) Date of publication of application: **05.08.2026**
(21) Application number: 23958354.5
(22) Date of filing: 30.11.2023
(51) Int. Cl.: G06N 3/0475, G06N 20/00

(54) **CONTROL SYSTEM AND CONTROL METHOD**

(30) Priority: 09.11.2023 JP 2023191481
(71) Applicant: Mitsubishi Electric Corporation, Tokyo 100-8310 (JP)
(72) Inventor: OTOMURA, Kotaro, Tokyo 100-8310 (JP); SUGAMA, Yasushi, Tokyo 100-8310 (JP); MIWA, Shotaro, Tokyo 100-8310 (JP); MAEKAWA, Kiyoshi, Tokyo 100-8310 (JP); NAMMOTO, Takashi, Tokyo 100-8310 (JP)
(74) Representative: Pfenning, Meinig & Partner mbB
(86) International application number: PCT/JP2023/042832
(87) International publication number: WO 2025/099955

(57) **Abstract**

Included are: a user terminal (1) that generates input information (D11) including information indicating control content requested for a target device (2) in response to an operation by a user (1); and a state acquisition unit (130) that acquires information regarding at least one of a control description (D12) generated by a learning model unit 100 that generates the control description (D12) on the basis of the input information (D11) generated by the user terminal (1) or an operation of the target device (2), and feeds back the information to at least one of the user terminal (1) or the learning model unit (100).

## Description

### TECHNICAL FIELD

The present disclosure relates to a control system and a control method.

### BACKGROUND ART

In recent years, artificial intelligence (AI) has been more widely utilized. In particular, AI capable of generating various types of content, which is called generative artificial intelligence (Al), is also beginning to spread, and it is expected that applications of AI will expand. Applications of AI are not limited to work at home but may also be applied to work in various facilities such as buildings, factories, stations, schools, hospitals, and commercial facilities, and work in various places and scenes such as outdoors including roads, outdoor facilities, the sky, or on the sea is under study.

For example, Patent Literature 1 describes a processing program generation device that generates a program for controlling a machine by using a large-scale language model.

### CITATION LIST

### PATENT LITERATURE

Patent Literature 1: JP 2021-060806 A

### SUMMARY OF INVENTION

### TECHNICAL PROBLEM

In order to assist work performed by a person or an object, it is assumed that learning models are responsible for some or all of the tasks included in the work without being limited to the generation of control programs of devices. Note that the "work performed by a person or an object" includes not only work on a real space performed by the person or a machine but also work on a data space such as information processing performed by a processor such as a central processing unit (CPU).

Examples of work by an object include, for example, the following.
· Work by various devices such as robots, machines, devices, and sensors
· Work by various types of mobile objects such as cars, trains, buses, flying objects, and ships
The work may include, for example, work referred to as control, processing, working, instruction, calculation, input, output, display, communication, testing, manufacturing, conversion, generation, measurement, irradiation, release, inhalation, heat dissipation, heating, cooling, recording, readout, shaping, driving, transportation, conveyance, flight, investigation, monitoring, measurement, extraction, and the like.

Examples of work performed by a person include the following.
· Work performed by a person for a person or another creature
· Work performed by a person on various devices

The work may include, for example, work referred to as conversation, viewing, check, operation, monitoring, instruction, arbitration, interpretation, and the like.

Note that the above-described examples are illustrative, and work to be assisted by the present disclosure is not limited thereto.

In a case where some or all of the tasks included in the work performed by a person or an object are executed by an information processing device using any learning model, there are cases where the appropriateness of the output of the model matters. There is also a case where the appropriateness of the input to the model that affects the output of the model matters.

Furthermore, depending on the target device, there are cases where appropriate control cannot be performed unless the current situation is grasped. In such a case, there are cases where how to perform situation recognition matters. In this case, it may be necessary to recognize not only the current situation but also the situation with continuity including the past situation. For example, in such a case where the next control is determined on the basis of the content of the control performed in the past, there are cases where the accuracy of situation recognition matters in order to ensure continuity of the control.

In addition, in such a case where immediacy is required for control of a device, there are cases where a response time from giving an instruction to a learning model to obtaining a result matters.

There are cases where the maintainability of a model may also matter such as that the model needs to be retrained each time a device is modified or added.

As described above, there are still various problems in the use of learning models. Depending on the severity of the problem, even an attempt to improve the efficiency or the performance of work using a learning model may conversely degrade the efficiency or the performance of the work.

These problems when using a learning model are more conspicuous particularly as the work to be assisted is more complicated and as the work to be assisted is more advanced.

Therefore, an object of the present disclosure is to further improve efficiency or performance of work performed by a person or an object using a learning model.

### SOLUTION TO PROBLEM

A control system according to the present disclosure includes: a user terminal to generate input information including information indicating control content requested for a device in response to an operation by a user; and a state acquisition unit to acquire information regarding at least one of a control description generated by a learning model unit that generates the control description on a basis of the input information generated by the user terminal or an operation of the device and to feed back the information to at least one of the user terminal or the learning model unit.

A control system according to the present disclosure is a control system for assisting work by a person or an object using a device, the control system comprising: an input interface to receive input of first information indicating a situation or a request in a work environment that is an environment in which the work is performed; a model processing unit provided to be capable of accessing to a predetermined learning model; and an output interface to output second information for assisting the work on a basis of output from the learning model, wherein the model processing unit inputs model input data based on the first information to the learning model and receives model output data corresponding to the model input data from the learning model, the model output data includes information used for the work, and the output interface outputs the second information based on the model output data.

A control method according to the present disclosure includes: by a user terminal, generating input information including information indicating control content requested for a device in response to an operation by a user; and, by a state acquisition unit, acquiring information regarding at least one of a control description generated by a learning model unit that generates the control description on the basis of the input information generated by the user terminal or an operation of the device, and feeding back the information to at least one of the user terminal or the learning model unit.

A control method according to the present disclosure is a control method for assisting work by a person or an object using a device, the control method comprising: by an input interface, receiving input of first information indicating a situation or a request in a work environment that is an environment in which the work is performed; by a model processing unit provided to be capable of accessing to a predetermined learning model, inputting model input data based on the first information to the learning model and receiving model output data corresponding to the model input data from the learning model, the model output data including information used for the work; and, by an output interface, outputting second information for assisting the work on the basis of output from the learning model, the second information based on the model output data.

### ADVANTAGEOUS EFFECTS OF INVENTION

According to the present disclosure, it is possible to further improve efficiency or performance of work performed by a person or an object using a learning model.

### BRIEF DESCRIPTION OF DRAWINGS

FIG. 1 is a configuration diagram illustrating an example of a control system according to a first embodiment.
FIG. 2 is an explanatory diagram illustrating a configuration example of a learning model unit.
FIG. 3 is an explanatory diagram illustrating another configuration example of the learning model unit.
FIG. 4 is an explanatory diagram illustrating another configuration example of the learning model unit.
FIG. 5 is a configuration diagram illustrating an example of an information processing device which is an operation environment of a control unit including the learning model unit.
FIG. 6 is an explanatory diagram illustrating an example of model learning in a model generating unit.
FIG. 7 is a flowchart illustrating an operation example of a control system according to the first embodiment.
FIG. 8 is a configuration diagram illustrating another example of the control system according to the first embodiment.
FIG. 9 is a configuration diagram illustrating another example of the control system according to the first embodiment.
FIG. 10 is a configuration diagram illustrating another example of the control system according to the first embodiment.
FIG. 11 is a configuration diagram illustrating an example of a control system according to a second embodiment.
FIG. 12 is a configuration diagram illustrating another example of the control system according to the second embodiment.
FIG. 13 is a flowchart illustrating an operation example of the control system according to the second embodiment.
FIG. 14 is a configuration diagram illustrating an example of a control system according to a third embodiment.
FIG. 15 is a flowchart illustrating an operation example of the control system according to the third embodiment.
FIG. 16 is a configuration diagram illustrating another example of the control system according to the third embodiment.
FIG. 17 is a flowchart illustrating an operation example of a modification of the third embodiment.
FIG. 18 is a configuration diagram illustrating another example of the control system according to the third embodiment.
FIG. 19 is a configuration diagram illustrating another example of the control system according to the third embodiment.
FIG. 20 is a configuration diagram illustrating another example of the control system according to the third embodiment.
FIG. 21 is a configuration diagram illustrating another example of the control system according to the third embodiment.
FIG. 22 is a flowchart illustrating an operation example of a modification of the third embodiment.
FIG. 23 is a configuration diagram illustrating an example of a control system according to a fourth embodiment.
FIG. 24 is a flowchart illustrating an operation example of the control system according to the fourth embodiment.
FIG. 25 is a configuration diagram illustrating another example of the control system according to the fourth embodiment.
FIG. 26 is a flowchart illustrating an operation example of a modification of the fourth embodiment.
FIG. 27 is a configuration diagram illustrating an example of a control system according to a fifth embodiment.
FIG. 28 is a flowchart illustrating an operation example of the control system according to the fifth embodiment.
FIG. 29 is a configuration diagram illustrating another example of the control system according to the fifth embodiment.
FIG. 30 is a configuration diagram illustrating another example of the control system according to the fifth embodiment.
FIG. 31 is a configuration diagram illustrating another example of the control system according to the fifth embodiment.
FIG. 32 is a configuration diagram illustrating another example of the control system according to the fifth embodiment.

### DESCRIPTION OF EMBODIMENTS

Hereinafter, in order to describe the present disclosure in more detail, modes for carrying out the present disclosure will be described by referring to the accompanying drawings. Hereinafter, the same elements are denoted by the same reference numerals, and description thereof will be omitted.

### First Embodiment

In the present embodiment, an example of assisting work related to code generation of a target device 2 using a learning model will be described.

Note that the "learning model" mentioned here is not limited to a model that performs learning, and includes trained models. The above similarly applies to other embodiments.

In addition, the "target device" may be simply referred to as a "device".

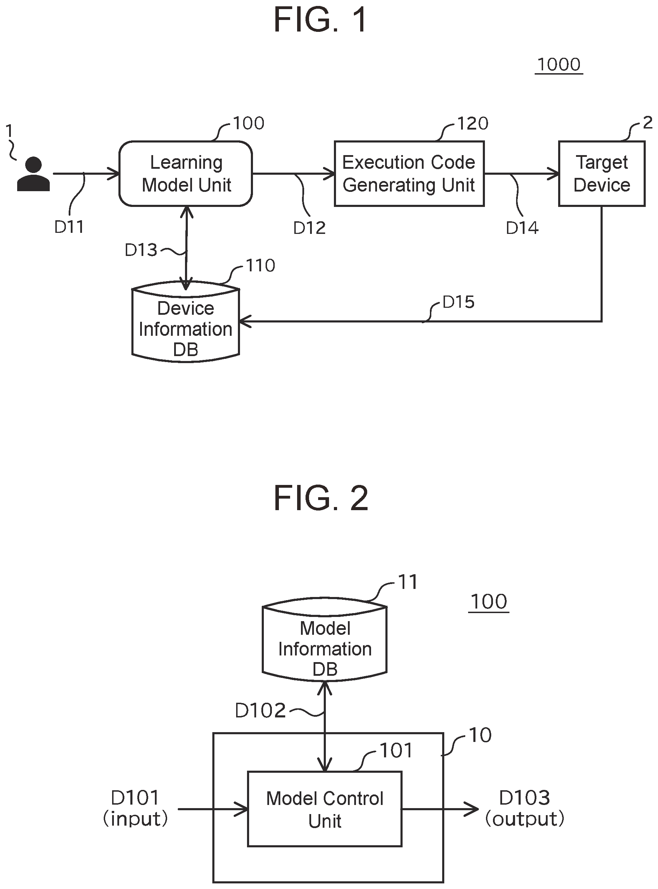

FIG. 1 is a configuration diagram illustrating an example of a control system 1000 according to a first embodiment. The control system 1000 illustrated in FIG. 1 is a control system for controlling a device using a learning model, and includes a learning model unit 100, a device information storing unit 110 (referred to as a device information DB in the drawing), and an execution code generating unit 120.

Note that FIG. 1 illustrates a case where the learning model unit 100 and the device information storing unit 110 are included inside the control system 1000. However, it is not limited thereto, and the learning model unit 100 and the device information storing unit 110 may be provided outside the control system 1000.

Note that, although a user 1 and the target device 2 are illustrated in FIG. 1, the control system 1000 may include the user 1 and the target device 2. In this case, the "user 1" may be replaced with a "user terminal 1". The user terminal 1 is a terminal that performs an operation such as outputting of input information D11 in response to an operation by the user 1. The above similarly applies to other embodiments.

When input information D11 is input, the learning model unit 100 outputs control description D12. When the input information D11 is input, the learning model unit 100 outputs the control description D12 on the basis of model information D102 described later.

In the present embodiment, the learning model unit 100 is a model and an operation environment thereof, the model configured to output the control description D12 corresponding to the input information D11 when the input information D11 is input. Furthermore, the learning model unit 100 may be a model and an operation environment thereof, the model configured to, when the input information D11 is input, generate and output the control description D12 on the basis of the input information D11, device information D13, and/or other information that can be referred to in the learning model unit 100 (such as model reference information D104 described later).

In the present embodiment, the input information D11 includes information indicating control content requested for the target device 2. The input information D11 may be, for example, text, an image (including moving image), audio, or a combination thereof indicating the control content for the target device 2. The input information D11 may be, for example, text, an image, audio, a combination thereof indicating a plurality of pieces of control content for the target device 2, or the like. Furthermore, the input information D11 may include information indicating the content of control performed temporally continuously, and in this case, may be time-series data having a predetermined data structure including text, an image, audio, a combination thereof, or the like indicating the control content as described above. It is based on the premise that the control content is indicated in a manner that matches an input format of the model used by the learning model unit 100; however, this is not the case when error processing, correction processing, or conversion processing is included in the preceding stage of the learning model unit 100.

Examples of how to indicate the control content in the input information D11 include a method of specifying the control to be performed on the target device 2 and then specifying the value of a parameter for performing the control or the state after the control. In that case, the input information D11 may include, for example, information specifying the control and information indicating the value of the parameter for performing the control or the state after the control. Examples of the value of a parameter for performing control may include a value related to the type of the control (ON/OFF or the like), the orientation, the amount, or time. Examples of the control content include "turning on function X" for a programmable logic controller (PLC), "moving the distal end to point A" for a robot arm, "lowering the set temperature by one degree" for an air conditioner, and so on. Furthermore, examples of how to indicate the control content in the input information D11 include a method of using various types of information such as a document character string (docstring) describing specifications of a function or the like, specifications, specifications applied to other devices such as other models, design specifications, an operation command, control codes, or source codes.

Note that the means of indicating the control content in the input information D11 is not limited to the method of explicitly indicating the control content as described above but also includes, for example, in a case where there is control performed by a certain operation, a method of indicating the operation content to indicate the corresponding control content. In addition, for example, there is also a method of implicitly indicating by the speech and behavior of the user 1 associated with specific control, an operation result of the target device 2, a similar control command to another model, or the like. In other words, the input information D11 can include not only information directly indicating the control content for the target device 2 but also information indirectly indicating the control content by using the operation content corresponding to the control content, the speech and behavior of the user 1, an image of the target device 2, or the like. As an example, words such as "hot" from the user 1, or behavior of the user 1 feeling hot, such as wiping off sweat, rolling up sleeves, or waving with a hand, can be used as those indicating the control content related to temperature control of an air conditioner. In this case, as the input information D11, information such as text indicating the utterance, audio, or an image of the user 1, or information such as an image (moving image) indicating the behavior of the user 1 can be used. As another example, as those indicating the control content related to an arm control of a robot device, information designating the posture after the control of the robot device or a destination point to which a predetermined portion is to be moved, information indicating an imitation operation of a robot operation by a person or another object (a simulator that performs a pseudo motion of the robot. An object on a screen is also included.) or an instruction operation for the robot (operation instruction by a gesture such as pointing with a finger) can be used.

Note that, in general, in specifications, although the control content is described in terms of the function, a specific value of a parameter is not shown in many cases. On the other hand, in the image or the like indicating a specific operation of the robot device or the like as described above, the control system 1000 can estimate a specific value of a parameter. Therefore, the control system 1000 can improve the generation accuracy of an execution code D14 by inputting, as the input information D11, not only the information such as the specifications indicating a functional explanation but also the information such as an image indicating a specific operation.

Note that the means of indicating the control content in the input information D11 is not limited to the method of explicitly indicating the control content as described above, but also includes, for example, in a case where there are products such as processed goods obtained by the control, a method of indicating corresponding control content by indicating an image of the product. In other words, the input information D11 can include not only information directly indicating the control content for the target device 2 but also information indirectly indicating the control content by using the image of the product obtained by the control. For example, a 3D image indicating the product, images obtained by photographing the product from a plurality of directions, or the like can be used as the input information D11.

Furthermore, the input information D11 may include information indicating a condition for the control content. For example, in working of a product, it is conceivable that the degree of wear of a tool used for working varies depending on the working speed even when the working contents are the same. Therefore, as the input information D11, in addition to the information indicating the control content (working content), information indicating a condition related to the working speed or the like may be included. As a result, the control system 1000 can generate a more suitable execution code D14.

Note that the format of the input information D11 is not particularly limited. For example, the information may be text, an image, audio, data written in a predetermined design language, control description (including source codes and information written in a predetermined programming platform language), information written in other platform languages, a control command (including a control instruction, a control signal, a control code, and a controller command), or an execution code. Note that these pieces of information can be combined as appropriate. Note that, in the present disclosure, "text" without particular distinction may include, in addition to those expressed in a natural language in text, data described in a predetermined design language that cannot be discriminated by a person, control description (including a source code and information described in a predetermined programming platform language), information described in other platform languages, and data discriminated by a machine, such as a control command (including a control instruction, a control signal, a control code, and a controller command) and an execution code expressed in text.

The control description D12 includes information regarding control described in a predetermined format that can be discriminated by the execution code generating unit 120 in a subsequent stage. The control description D12 is, for example, a source code described in a predetermined programming language. Furthermore, the control description D12 may be, for example, a command group described in a format (platform language) handled on a predetermined programming platform. Note that the predetermined programming platform may include a no-code programming platform and a low-code programming platform.

The device information storing unit 110 stores the device information D13 that is information of the target device 2. The device information D13 may include, for example, information indicating a function, the performance, the structure, dimensions, the operation, and/or the control method of the target device 2. Furthermore, the device information D13 may include, for example, information regarding a program used for controlling the target device 2. The device information D13 may be, for example, an instruction manual or user manual of the target device 2 converted into data. The conversion into data here includes conversion into text, conversion into image data, conversion into data by reading voice, and combinations thereof. The device information D13 is used, for example, as additional information for the learning model unit 100 to output the control description D12.

The device information D13 may also include information indicating the state of the target device 2. The information indicating the state of the target device 2 may include not only the current state of the target device 2 but also information indicating the past state. For example, the device information D13 may include time-series data of a predetermined data structure indicating the state of the target device 2. The information indicating the state of the target device 2 may be, for example, information output from the target device 2 or information input by the user 1 or another device. The information indicating the state of the target device 2 can include various types of information output from the target device 2 (for example, error information, log information, notification information, and the like). Hereinafter, in the present embodiment, in particular, information indicating the state of the target device 2 may be referred to as state information D15.

When the control description D12 is input, the execution code generating unit 120 generates and outputs an execution code D14 executable by the target device 2 on the basis of the control description D12. The execution code D14 may be, for example, a code group described in machine language. The execution code D14 includes, for example, information used when the target device 2 actually performs control. The execution code D14 is only required to be, for example, information related to control described in a format discriminable by the target device 2. The execution code generating unit 120 may be, for example, a compiler that converts the control description D12 into the execution code D14.

The execution code D14 output from the execution code generating unit 120 is input to the target device 2. As a result, the target device 2 operates in accordance with the execution code D14 output from the execution code generating unit 120. The input of the execution code D14 to the target device 2 may be directly input from the execution code generating unit 120, or may be indirectly input via a communication network or another device (such as a server or various conversion devices), manually, or the like.

The target device 2 is not particularly limited. Note that it is based on the premise that the target device 2 is a device that can receive the execution code D14 and actually execute the code; however, it is not limited to this case in a case where an interface that causes the target device 2 to read the execution code, such as a writing device, is included between the execution code generating unit 120 and the target device 2.

The target device 2 is, for example, a PLC, a working machine, a robot, a radar, a sensor, a camera, a projector, or a communication device. The target device 2 may also be, for example, an air conditioner, a refrigerator, a television, a lighting device, or a washing machine. Furthermore, the target device 2 may be, for example, an elevator, a mobile object, a conveyor device, other machines, or a control device that controls such a machine. In addition, the target device 2 may be equipment that operates in a power generation, power conversion, and/or power storage plant, a water treatment plant, and the like, or a control device that controls other equipment. In addition, the learning model unit 100 may generate the execution code D14. For example, in a case where the control description D12 is an interpreted language and the target device 2 can receive the control description D12 and directly execute the control description D12, the control description D12 can be regarded as the execution code D14. In this case, the execution code generating unit 120 can be omitted. Note that the control description D12 may be converted into an execution code D14 more suitable for processing by the target device 2 by the compiling or optimization processing.

FIG. 2 is an explanatory diagram illustrating a configuration example of the learning model unit 100. As illustrated in FIG. 2, the learning model unit 100 may include a model control unit 101 that operates on the information processing device 10 and a model information storing unit 11 (referred to as a model information DB in the drawing) that stores the model information D102. The model information storing unit 11 may include a plurality of databases connected via a network.

The model information D102 includes model information. The model information D102 may include, for example, information indicating the correlation between model input data D101 and model output data D103 as the model information. Furthermore, the model information D102 may include, for example, information indicating a candidate for the model output data D103 as the model information. In addition, the model information D102 may further include, as the model information, information indicating candidates for the model output data D103 and information indicating the relationship between the candidates. Furthermore, the model information D102 may include, for example, a model parameter that is information defining the behavior of the learning model, such as a constraint condition, a weighting variable, or an evaluation function.

The model may be, for example, a model machine-learned by supervised learning, reinforcement learning, or unsupervised learning. The model may be, for example, a model obtained by executing training in accordance with a known algorithm or method such as deep learning, a genetic program, a functional logic program, or the like. In addition, the model may be, for example, a model called a neural network (NN) model, a convolutional neural network (CNN) model, a recurrent neural network (RNN), a variational autoencoder (VAE), a generative adversarial network (GAN), a diffusion model, a transformer model, a large language model (LLM), a visual language model (VLM), a bidirectional encoder representations from transformers (BERT), a generative pre-trained transformer (GPT), or a contrastive language image pre-training (CLIP). Furthermore, the model may be described on a rule basis for obtaining an output result by referring to a predetermined table or making determination on the basis of a predetermined condition. Note that the above-described models are not exclusive, and, for example, LLM, VLM, BERT, and GPT are included in the transformer model. Furthermore, for example, the transformer model is included in the NN model. In addition, the learning algorithm and the model may be a combination of a plurality of types. The model also includes what is called a multimodal model trained by combining a plurality of different types of data.

Upon receiving the model input data D101, the model control unit 101 outputs the model output data D103 corresponding to the model input data D101 on the basis of the model input data D101 and the model information D102. Upon receiving the model input data D101, the model control unit 101 outputs the model output data D103 corresponding to the model input data D101 using, for example, the model indicated by the model information D102.

The model control unit 101 is implemented by, for example, a CPU that operates in accordance with a program included in the information processing device 10. Hereinafter, the learning model unit 100 may be referred to as an artificial intelligence unit. The artificial intelligence unit refers to AI having intelligent functions such as inference and determination and an operation environment thereof. Therefore, the model control unit 101 may include AI having intelligent functions such as inference and determination and an operation environment thereof. The model control unit 101 may be, for example, AI including the learning model as described above and an operation environment thereof. The model control unit 101 may be an element (module) of a control unit 104 included in the information processing device 10.

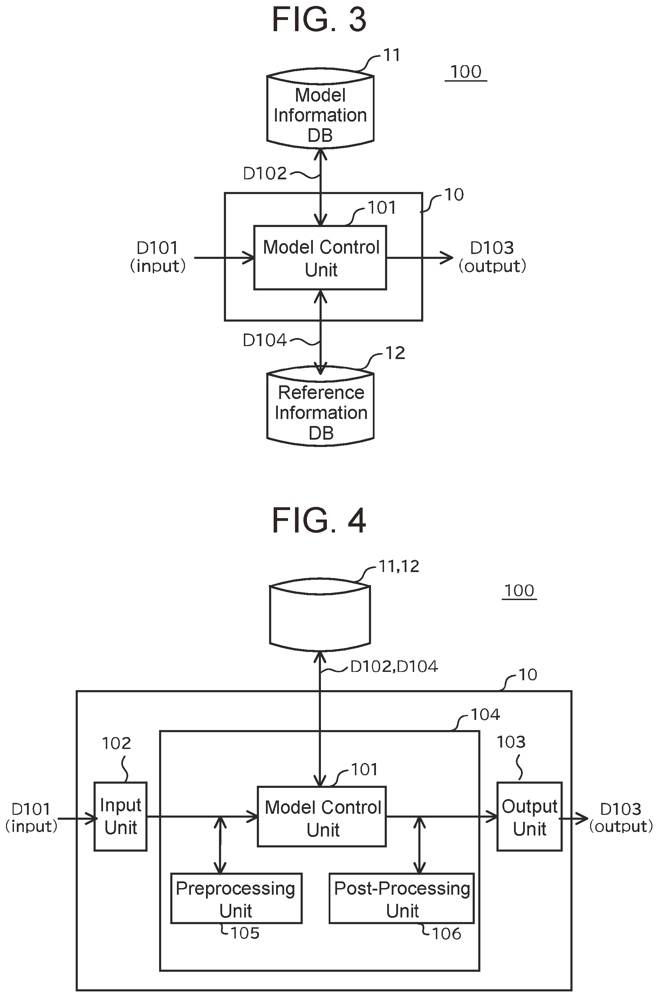

Furthermore, as illustrated in FIG. 3, the learning model unit 100 may further include a reference information storing unit 12(referred to as reference information DB12 in the drawing) that stores the model reference information D104. The reference information storing unit 12 may include a plurality of databases connected via a network. The same applies similarly to other storage units (such as the device information storing unit or the like) described later.

The model reference information D104 is information that is referred to by the model control unit 101 to output the model output data. The model reference information D104 may include a history of model input data having been input in the past and/or a history of model output data having been output in the past. In addition, the model reference information D104 may include information in which the feature included in the past input is associated with the feature included in output having been performed with respect to the input. In addition, the model reference information D104 may include evaluation information for the result having been output for the past input.

The model reference information D104 may also include information related to an expression or a concept included in the model input data D101. The model reference information D104 may include, for example, information in which a specific expression or concept that can be included in the model input data D101 is associated with another expression or concept related to the expression or the concept. Note that the other expression or concept related to the certain expression or concept includes an expression or a concept that is more specific to the certain expression or concept, or other expressions or concepts evoked on the basis of the certain expression or concept. The model reference information D104 may include, for example, information in which a specific expression or concept that can be included in the model input data D101 is associated with an expression or a concept related to the expression or the concept. As an example, the model reference information D104 may include, for example, information in which a specific expression or concept that can be included in the model input data D101 is associated with information related to the expression or the concept. The model reference information D104 may include, for example, information in which a search key and a value extracted from an expression or a concept that can be included in the model input data D101 are associated with each other. The model reference information D104 may include information for so-called grounding. Furthermore, the model reference information D104 may include a so-called knowledge graph that describes entities in the real world and relationships therebetween. In the knowledge graph, various pieces of information are systematically connected and represented by a graph structure.

Furthermore, the model reference information D104 may include information for so-called attention. For example, the model reference information D104 may include information indicating a correlation between an expression or a concept that can be included in the model input data D101 and another expression or concept. Furthermore, the model reference information D104 may include a feature map having key information extracted from an expression or a concept, which can be included in the model output data D103 associated with an expression or a concept that can be included in the model input data D101, as a feature. In addition, the model reference information D104 may include information in which a query extracted from an expression or a concept that can be included in the model input data D101 is associated with key information for search corresponding to the query.

In the example illustrated in FIG. 3, upon receiving the model input data D101, the model control unit 101 outputs the model output data D103 on the basis of the model input data D101, the model information D102, and the model reference information D104.

Note that the learning model unit 100 can include, instead of the reference information storing unit 12, a search engine for searching the model reference information D104 or an interface with the search engine. In such a case, the search range of the search engine may be an external network or a specific network. At this point, a database included in the control system of the present disclosure (such as the device information DB) can be used as one of the external network or the specific network.

The term "learning model" may refer to a computer algorithm that performs some type of output on the basis of learned information with respect to input information or the learned information itself. However, when the term "learning model" is used under an operation environment, it often refers to an actual program for operating such a computer algorithm and the operation environment thereof. In the present disclosure, the latter is adopted, and a model that actually operates on the basis of information or the like stored in the model information D102 is referred to as a "learning model" in order to be distinguished from a mere algorithm or a learned information group. The control system according to the present disclosure includes the learning model unit (in particular, the model control unit 101) as the one that corresponds to such a learning model. Therefore, hereinafter, in the description of the control system, the term "learning model" refers to the learning model unit or the model control unit 101 in particular in the learning model unit.

FIG. 4 is an explanatory diagram illustrating another configuration example of the learning model unit 100. As illustrated in FIG. 4, the learning model unit 100 may include an input unit 102, an output unit 103, and a control unit 104.

The input unit 102 receives model input data D101. The input unit 102 may receive the model input data D101 input by the user 1 or the like. The input unit 102 may receive the model input data D101 constituting time series data. At this point, the input unit 102 may sequentially receive the model input data D101 constituting the time-series data, or may receive the model input data D101 buffered to some extent. The input unit 102 may receive the model input data D101 input from a plurality of input sources. At this point, the input unit 102 may receive the model input data D101 to which information of the input source (such as the user identifier and attribute information of the user 1) is attached, the input unit 102 may discriminate the input source, attach the information of the input source to the model input data D101, and then receive the model input data D101, or may receive the model input data D101 without doing anything in particular. The input unit 102 is implemented by, for example, various input devices (for example, a pointing device, a keyboard, an audio input device, an image input device, a data reading device, a data input device supporting various communication interfaces, and the like.) included in the information processing device 10. Note that the input unit 102 may be implemented by an external device of the information processing device 10. In that case, the information processing device 10 is only required to include an interface with the input unit 102.

The output unit 103 outputs an object generated by a control unit 104. Note that the object includes model output data D103 or data generated from the model output data D103. Furthermore, in a case where the object generated by the control unit 104 includes information to a plurality of output destinations, the output unit 103 may output the object to the plurality of output destinations. At this point, the output unit 103 may output the same data to the plurality of output destinations, or may output different data for each output destination. The output unit 103 is implemented by, for example, various output devices (for example, a display device, an audio output device, an image output device, a data writing device, a data output device supporting various communication interfaces, and the like.) included in the information processing device 10. Note that the output unit 103 may be implemented by an external device of the information processing device 10. In that case, the information processing device 10 is only required to include an interface with the output unit 103.

The control unit 104 operates on the information processing device 10 and includes a preprocessing unit 105 and a post-processing unit 106 in addition to the above-described model control unit 101.

The preprocessing unit 105 performs processing for increasing the accuracy of the object generated by the control unit 104. For example, the preprocessing unit 105 may add, modify, or delete an element, or convert data (including processing) with respect to the model input data D101.

For example, when the input unit 102 receives the model input data D101, the preprocessing unit 105 may modify an element (including addition and deletion) or convert data (including processing) with respect to the model input data D101. Modifying an element or converting data (including processing) includes not only modifying the data format but also modifying the representation or the concept represented by the data. The data having been modified by the preprocessing unit 105 is input to the model control unit 101 in the subsequent stage as the model input data D101. The processing performed by the preprocessing unit 105 includes so-called prompt formatting with respect to the model control unit 101.

For example, the preprocessing unit 105 may perform processing of decomposing the model input data D101 into predetermined unit data. In addition, the preprocessing unit 105 may perform processing of integrating a plurality of pieces of model input data D101, for example. Furthermore, the preprocessing unit 105 may decompose the model input data D101 into predetermined unit data and then modify an element or convert the data, or may integrate a plurality of pieces of model input data D101 and then modify an element or convert the data.

For example, in a case where there is a problem with an object generated by the control unit 104 (particularly, the model control unit 101), the post-processing unit 106 corrects the object. For example, the post-processing unit 106 may determine whether or not there is a problem in the object using the above-described knowledge graph. For example, comparing the similarity between the relationship indicated by the knowledge graph and the relationship between the expression or concept included in the model input data and the expression or concept included in the model output data, and/or the relationship between expressions or concepts included in the model output data, in a case where the object is away from the relationship indicated by the knowledge graph by a predetermined distance or more, it may be determined that there is a problem in the object.

Note that the components other than the model control unit 101 among the above-described components are not essential, and whether or not to mount those components can be selectively determined as appropriate.

Furthermore, the model information D102 and other information used by the learning model may be prepared in advance, or may be acquired via a communication network as necessary.

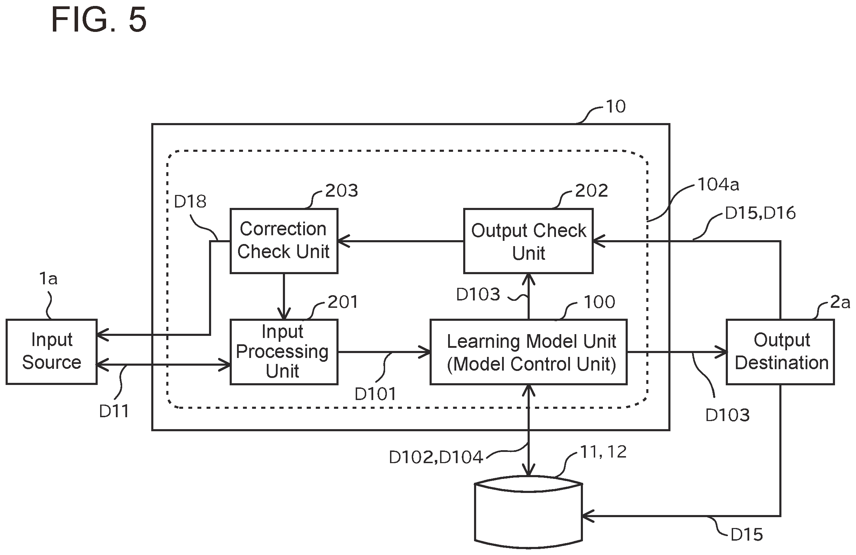

FIG. 5 is a configuration diagram illustrating another example of the information processing device 10 as the operation environment of the control unit 104 including the learning model unit 100 and others. The information processing device 10 illustrated in FIG. 5 may include a control unit 104a including a learning model unit 100 (particularly, a model control unit 101), an input processing unit 201, an output check unit 202, and a correction check unit 203.

The input processing unit 201 receives input information D11 from an input source 1a such as the user 1. In addition, the input processing unit 201 outputs the received input information D11 to the learning model unit 100 as model input data D101.

At this point, for example, the input processing unit 201 may output, as the model input data D101, data obtained by modifying an element or converting data with respect to the input information D11. For example, the input processing unit 201 may remove noise from the input information D11. Furthermore, for example, in a case where qualitative information is included in the input information D11, the input processing unit 201 may convert the information into quantitative information. Furthermore, for example, in a case where quantitative information is included in the input information D11, the input processing unit 201 may correct the amount depending on a device that is a target of a request of the input information D11 or the operation environment thereof. Furthermore, the input processing unit 201 may perform, for example, so-called grounding processing, namely, modify the expression or concept indicated by the input information D11 to a more concrete expression or concept.

Furthermore, in a case where the input information D11 includes unclear or uncertain information, the input processing unit 201 may return an inquiry to the input source. As the inquiry, the input processing unit 201 may output, for example, a message for checking the input content, a message for suggesting a correction proposal of the input information D11, a message for requesting reinput of the input information D11 having a different state or expression, or the like. Furthermore, the correction proposal of the input information D11 may be generated by a correction check unit 203 to be described later. Hereinafter, information indicating correction, addition, and cancellation of the content with respect to the input and output data of the learning model after the input and output may be referred to as supplementary information D18. The correction proposal is an example of the supplementary information D18.

The output check unit 202 performs a simulation that simulates the control and the state of the target device 2 on the basis of the model output data D103 output from the learning model unit 100. The output check unit 202 may perform the simulation after converting the model output data D103 into control information supported by a predetermined simulator (not illustrated) capable of simulating the control and the state of the target device 2. The output check unit 202 may have a simulator function. When performing the simulation, the output check unit 202 may use information acquired from an output destination 2a of the model output data D103. The output destination 2a includes an output destination of information generated from the model output data D103. The information acquired from the output destination 2a may include, for example, state information D15 and/or feedback information D16 to be described later.

The output check unit 202 may check, for example, the state of the target device 2, the state of the system including the target device 2, and/or the state of work of the target device 2. In addition, the output check unit 202 may generate and display an intermediate product that can be understood by a person for the model output data D103 or information generated on the basis of the model output data D103 before performing operation check. Examples of the intermediate product include a source code for a control program and an operation image of a controller of the target device 2 for an operation command to the target device 2. In addition, the output check unit 202 may display the result of the simulation together with a reliability index of the learning model.

The following is an example of the reliability index of the learning model. For example, at the time of preliminary learning or the like, an evaluation network in which a result of evaluation by a person is accumulated every time there is input to the learning model and the input and the evaluation results are learned may be provided. At the time of using the learning model, input to the learning model may also be input to the above-described evaluation network, and the output result may be used as the reliability index.

Alternatively, for example, a learner that clusters output of the learning model at the time of preliminary learning or the like may be provided, and output of the learning model may also be input to the above-described learner at the time of using the learning model, and the result of the clustering may be used as the reliability index.

Furthermore, for example, at the time of preliminary learning or the like, an evaluation network in which a result of evaluation by a person is accumulated every time there is input to the learning model and features of input having good evaluation results are learned may be provided. At the time of using the learning model, input to the learning model may also be input to the above-described evaluation network, and the similarity between the feature as an output result and the feature of the learning result may be used as the reliability index.

Further alternatively, for example, at the time of preliminary learning or the like, a learner that accumulates a result obtained by evaluation on a result made by a person every time there is input to the learning model and clusters input to the learning model having a high evaluation result may be included. At the time of using the learning model, the input to the learning model may also be input to the learner described above, and the result of the clustering may be used as the reliability index.

The correction check unit 203 uses the result of the simulation performed by the output check unit 202 to determine the validity of the model output data D103 and/or the model input data D101. For example, the correction check unit 203 may compare the state of the target device 2 indicated by the simulation result with the state of the target device 2 specified by the input information D11, the model output data D103, and/or the model input data D101, and determine whether or not correct control is performed, thereby determining the validity of the model output data D103 and/or the model input data D101. The correction check unit 203 may determine that correct control is being performed in a case where the state of the target device 2 indicated by the simulation result matches the state of the target device 2 specified by the model output data D103 and/or the model input data D101. The state of the target device 2 to be compared here is not limited to one.

In addition, the correction check unit 203 may determine the validity of the model output data D103 and/or the model input data D101 by checking, for example, whether or not the state or the control locus of the target device 2 indicated by the simulation result matches the control indicated by the input information D11 or whether or not the state or the control locus includes content that is prohibited in advance.

In addition, the correction check unit 203 may determine the validity of the model output data D103 and/or the model input data D101 by presenting the simulation result to the input source 1a of the input information D11 and asking for a response as to whether or not desired control is performed.

In the case of determining that the model output data D103 and/or the model input data D101 is(are) not correct, the correction check unit 203 may correct the model input data D101. In addition, instead of correcting the model input data D101, the correction check unit 203 may generate the supplementary information D18 for the input information D11 and output the supplementary information D18 to the input source 1a.

For example, the control system 1000 may have a configuration illustrated in any one of FIGS. 1 to 5 as the operation environment of the learning model unit 100. Similarly to the learning model unit 100, even in that case, a part or all of the configuration may be an internal configuration or an external configuration of the control system 1000.

Note that the above-described configuration of the learning model unit 100 and its periphery is merely an example, and not all the components are essential, and it is sufficient to selectively determine whether or not to mount those components as appropriate depending on a desired function.

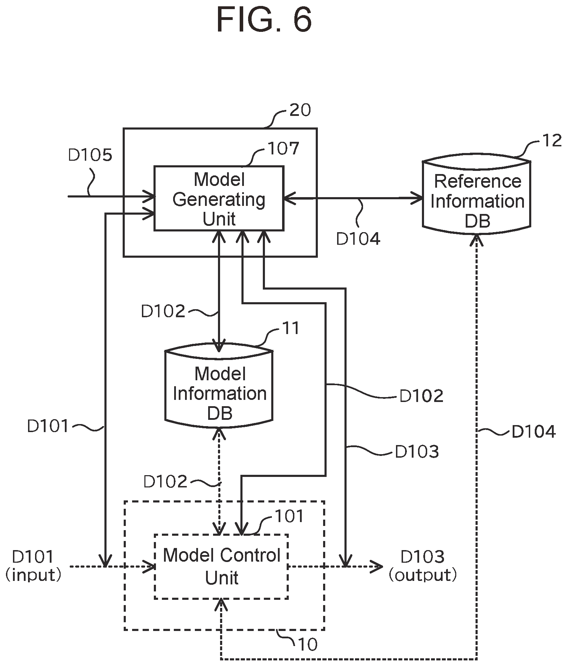

FIG. 6 is an explanatory diagram illustrating an example of model learning. As illustrated in FIG. 6, the model information D102 may be generated, for example, by the model generating unit 107 performing machine learning using model training data D105.

The model generating unit 107 is a processing unit that generates or updates the model information D102 on the basis of the input model training data D105 in accordance with a predetermined algorithm. The model generating unit 107 is implemented by, for example, a CPU that operates in accordance with a program included in the information processing device 20. Note that the algorithm followed by the model generating unit 107 may be a machine learning algorithm supporting to the learning model, for example, supervised learning, reinforcement learning, or unsupervised learning, or may be deep learning, a genetic program, a functional logic program, or other known algorithms.

Furthermore, the model generating unit 107 may generate or update the model information D102 for the input model training data D105 further on the basis of the model reference information D104. In addition, the model generating unit 107 may generate and update the model information D102 for the input model training data D105 further on the basis of the model output data D103 from the model control unit 101.

The model training data D105 is not particularly limited. For example, in a case where supervised learning is used as a learning algorithm, the model training data D105 may include a candidate for the model input data D101 that can be input and a candidate for the model output data D103 corresponding thereto. In addition, the model training data D105 may include the model input data D101 having been actually input and/or the model output data D103 having been actually output. Feedback control can be performed by appropriately using the actual model input data D101 and/or the model output data D103. Furthermore, the model training data D105 may include information acquired from a device or a processing unit included in a system in which the learning model actually operates.

The model information D102 generated or updated by the model generating unit 107 is stored in the model information storing unit 11 and is thereby provided to the model control unit 101. Alternatively, the model generating unit 107 can directly output the model information D102 to the model control unit 101.

The model generating unit 107 may generate the model information D102 by using the input model training data D105 by preliminary learning, for example, before the model control unit 101 uses the model information D102, and store the model information D102 in the model information storing unit 11.

The update of the model information D102 by the model generating unit 107 may be processing called FineTune.

Note that the model generating unit 107 may be included in the control system 1000 or may be included in a system different from the control system 1000.

In addition, in FIG. 1, the learning model unit 100, the device information storing unit 110, and the device information D13 are illustrated separately; however, the device information storing unit 110 and the device information D13 may be a part of the learning model unit 100. That is, the learning model unit 100 may include the device information storing unit 110 and the device information D13. For example, the learning model unit 100 may include the device information storing unit 110 as one example of the reference information storing unit 12 to be described later. In addition, the device information D13 may be used in a model learning phase in which the model used by the learning model unit 100 is learned, whereby the device information D13 may be incorporated in the model in advance. In this case, the device information storing unit 110 may be omitted.

In addition, a part or all of the learning model unit 100 may be an internal configuration of the control system 1000 or an external configuration of the control system 1000. In the case of an external configuration of the control system 1000, the control system 1000 is only required to include an interface capable of exchanging information with an external system including a part or all of the learning model unit 100 instead of the part or all of the learning model unit 100. For example, the control system 1000 may externally configure the model information storing unit 11 referred to as the core of the learning model. Furthermore, for example, the control system 1000 may externally configure the model information storing unit 11 referred to as the core of the learning model and the model control unit 101 responsible for the algorithm of the model.

Hereinafter, in the control system 1000, in order to distinguish between the model control unit 101 responsible for the algorithm of the learning model and a portion that performs processing of sending a request to such a model control unit 101 to obtain a response, the portion that performs the latter processing may be referred to as "model processing unit". More specifically, the model processing unit corresponds to a portion other than the model control unit 101 in the information processing device 10, the control unit 104, or the control unit 104a described above. Note that, for example, in a case where the model control unit 101 is in the internal environment, the model processing unit may be implemented by an operating system (OS) that calls a learning model application and a prompt application (and a control unit that is an operation environment thereof) operating on the information processing device 10. Note that, for example, in a case where the model control unit 101 is in the external environment, the model processing unit may be implemented by a browser and a client application (and a control unit that is an operation environment thereof) operating on the information processing device 10.

Note that the configuration of the information processing device as the learning model and the operation environment thereof described above, and the relationship between the learning model and the control system including the learning model are similar in other embodiments.

In the present embodiment, the input information D11 corresponds to the model input data D101. The control description D12 corresponds to the model output data D103. For example, the learning model unit 100 (in particular, the model control unit 101) may be configured to output the control description D12 corresponding to the input information D11 on the basis of the model information D102 and the model reference information D104 as necessary when receiving the input information D11.

Furthermore, in such a case, the model generating unit 107 provided to correspond to the learning model unit 100 may perform machine learning using, for example, the model training data D105 including candidates for the input information D11 that can be input to the model control unit 101, and generate or update the model information D102. Furthermore, the model generating unit 107 may generate or update the model information D102, for example, by performing machine learning using the model training data D105 including a candidate for the input information D11 that can be input to the model control unit 101 and a candidate for the control description D12 corresponding thereto.

In the present embodiment, the learning model unit 100 may be, for example, a language learning model such as LLM that receives input in natural language and obtains an output result and the operation environment thereof. Furthermore, the learning model unit 100 may be, for example, an image learning model such as a VLM that receives input of an image and outputs a result, and the operation environment thereof. Furthermore, the learning model unit 100 may be, for example, a multimodal model and the operation environment thereof, the multimodal and the operation environment thereof model for receiving input in natural language and an image and obtaining an output result. In this case, the input information D11 may be input in text data, image data, a combination of text data and image data, or a data format (such as audio data or a moving image which is a combination of audio data and image data) that can be converted into the text data, image data, or a combination of text data and image data. Note that the learning model used in the present embodiment is not limited to the above-described model.

In the present embodiment, the input information D11 received by the control system 1000 can be regarded as information regarding a request in a work environment, in this example, an environment in which the target device 2 operates (in this example, the control content requested for the target device 2). Therefore, the input information D11 received by the control system 1000 can be regarded as an example of first information indicating the request in the work environment. In addition, the control description D12 and the execution code D14 can be regarded as information used for the work (work related to control of the target device 2) corresponding to such input information D11. Hereinafter, the control description D12 output to a predetermined output destination from the operation environment of the learning model to which model input data based on the input information D11 is input may be referred to as second information.

In the relationship between the input information D11 and the model input data, the model input data based on the input information D11 may include the input information D11 itself, the input information D11 obtained by converting the input information D11 into a format that supports input of the learning model, and the input information D11 that has been supplemented. In the relationship between the model output data and the second information, the second information based on the model output data may include the model output data itself, data obtained by converting the model output data into a format that matches input to an output destination, and data obtained by supplementing the model output data. The same applies similarly to the relationship between the input and output information and the model input and output data in other embodiments.

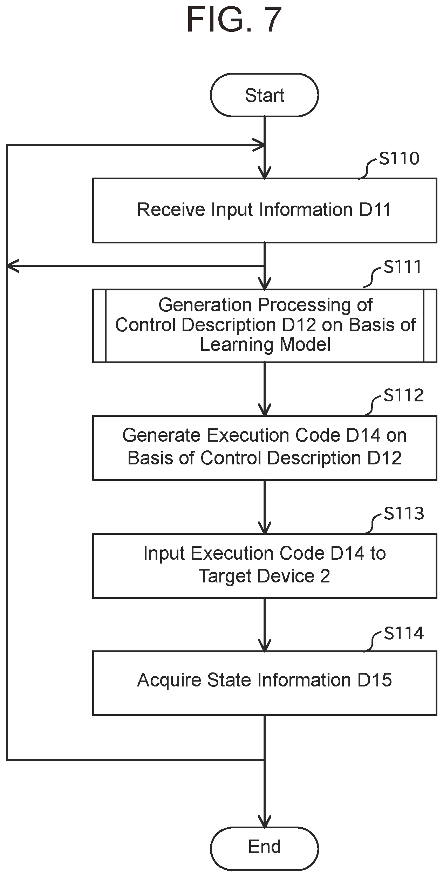

Next, an operation of the control system 1000 of the present embodiment will be described. FIG. 7 is a flowchart illustrating an operation example of the control system 1000.

In the example illustrated in FIG. 7, first, the control system 1000 receives the input information D11 (step S110). For example, the input unit 102 or the input processing unit 201 described above may receive the input information D11. The received input information D11 is input to the learning model unit 100 as the model input data D101.

In step S110, the control system 1000 may receive a plurality of pieces of input information D11. Furthermore, the control system 1000 may receive the input information D11 that satisfies the request of the user 1 more interactively with the user 1, namely, while repeating input and output of information related to the input information D11 with the user 1.

Next, the control system 1000 performs generation processing of the control description D12 using the learning model unit 100 (step S111). In step S111, the learning model unit 100 generates and outputs the control description D12 corresponding to the input information D11 having been input. For example, the learning model unit 100 (more specifically, the model control unit 101) outputs the control description D12 corresponding to the input information D11 on the basis of the model reference information D104 including the model information D102 and the input information D11 having been input, as well as the device information D13 as necessary. For example, the learning model unit 100 may generate the control description D12 of text data from the input information D11 having been input by using a learning model capable of generating text data.

In step S111, the learning model unit 100 (more specifically, the preprocessing unit 105 or the input processing unit 201) may further add, modify, or delete an element or convert data (including processing) with respect to the input information D11 in order to enhance the accuracy of the control description D12 before the processing by the model control unit 101. Furthermore, in step S111, the learning model unit 100 (more specifically, the post-processing unit 106) may further determine whether or not there is a problem in the control description D12 after the processing by the model control unit 101, and perform processing of correcting the control description D12 if it is determined that there is a problem.

The control description D12 output from the learning model unit 100 is input to the execution code generating unit 120. When the control description D12 is input, the execution code generating unit 120 generates the execution code D14 on the basis of the control description D12 having been input (step S112).

Next, the execution code D14 generated by the execution code generating unit 120 is input to the target device 2 (step S113). As described above, the input of the execution code D14 to the target device 2 may be directly performed from the control system 1000 (more specifically, the execution code generating unit 120), or may be indirectly input via a communication network or another device (such as a server or various conversion devices), or manually.

As a result, the target device 2 operates in accordance with the input execution code D14.

If there is a change in the state of the target device 2 due to control or the like of the target device 2 as a result of outputting the execution code D14, the control system 1000 may acquire the state information D15 (step S114). The acquired state information D15 is stored in the device information storing unit 110 as a part of the device information D 13, for example. For example, the control system 1000 may update the device information D13 stored in the device information storing unit 110 using the acquired state information D15. Furthermore, for example, the control system 1000 may output the acquired state information D15 to the user 1, the learning model unit 100, or another device (not illustrated) as information indicating the control result. Note that, in a case where the control system 1000 does not use the state information D15, the processing of step S114 can be omitted.

The control system 1000 may repeat the processing of steps S110 to S114 a plurality of times (for example, until the desired control for the target device 2 is completed).

Note that the control system 1000 may output the control description D12 to an operation terminal or the like of the user 1 such that the user 1 checks the content and that subsequent processing (such as code generation in the execution code generating unit 120) is then executed by operation by the user 1.

The state information D15 input to the learning model unit 100 is used for additional training of the learning model unit 100, for example. For example, the learning model unit 100 may update the model information D102 and/or the model reference information D104 on the basis of the input state information D15.

As described above, according to the present embodiment, since the execution code D14 can be generated from the input information D11 input from the user 1 without the user 1 creating the control description D12, it is possible to improve the efficiency of the work of controlling the target device 2.

Furthermore, in the present embodiment, since the input information D11 may be text, an image, audio, or a combination thereof explicitly or implicitly indicating the control content for the target device 2, it is possible to improve the efficiency of the operation of controlling the target device 2 while further suppressing the trouble of inputting the input information D11.

In addition, according to the present embodiment, since the control description D12 can be generated from the input information D11 using the learning model, the control description D12 corresponding to the input information D11 can be generated even if the user 1 does not know information for controlling the target device 2 such as detailed specifications of the target device 2 or specifications of the control description D12, and thus, it is possible to improve the performance of the work of controlling the target device 2. Note that the improvement of the performance of the work of controlling the target device 2 includes increasing the accuracy of controlling the target device 2.

In addition, in the present embodiment, the state information D15 acquired after the target device 2 is controlled on the basis of the input information D11 can be used for generation of the next control description D12 and the like, and thus, it is possible to further improve the performance of the work of controlling the target device 2.

Although only one target device 2 is illustrated in the above example, a plurality of target devices 2 may be controlled by the control system 1000. In such a case, for example, information by which the target device 2 can be discriminated may be included in the input information D11, an input side of the learning model unit 100 (input unit 102, preprocessing unit 105, and input processing unit 201) may perform processing of discriminating the target device 2 on the basis of the input information D11, or the learning model unit 100 may output control content in which the target device 2 is discriminated as a result of learning.

Note that a large number of programming languages are used in the target device 2. For example, there are five types of programming languages defined as international standards for PLCs, there are several types of programming languages even in a single company for working machines, and there are a large number of programming languages for robots depending on the model.

Meanwhile, in the control system 1000, the user 1 can input, to the learning model unit 100, information that allows the target device 2 to be discriminated, such as specifications, by including the information in the input information D11, and the learning model unit 100 can also refer to the device information D13. As a result, in the control system 1000, the learning model unit 100 can generate the control description D12 after appropriately selecting the programming language necessary for the target device 2, whereby program conversion work in a subsequent stage can be omitted.

In addition, even in a case where the learning model unit 100 does not support all programming languages, by adding a conversion unit as a subsequent stage of the learning model unit 100, the control description D12 from the learning model unit 100 can be changed by the conversion unit to a required program, which can be output to the execution code generating unit 120.

Furthermore, the learning model unit 100 may output, to the user 1 side, control description information related to the control description D12, such as a document character string or an annotation related to the generated control description D12, or information referred to when the control description D12 has been generated, and the user 1 may check the control description information displayed on a display device (not illustrated). As a result, the user 1 can easily check the content of the control description D12 generated by the learning model unit 100, and the learning model unit 100 itself can also easily perform self-evaluation.

This can be implemented, for example, by issuing an output request of the control description information in addition to a generation request of the control description D12 when the user 1 outputs the input information D11 to the learning model unit 100.

In addition, the user 1 may determine whether or not the control description D12 satisfies the request content of the input information D11 by determining whether or not the control description information satisfies the request content of the input information D11 on the basis of the control description information from the learning model unit 100. Then, in a case where it is determined that the control description information does not satisfy the request content of the input information D11, the user 1 corrects the input information D11 and reinputs the corrected input information to the learning model unit 100. As a result, in the control system 1000, the accuracy of the control description D12 generated by the learning model unit 100 can be improved.

In addition, the user 1 may set the display device not to display control description information that does not satisfy the request content of the input information D11 among the control description information from the learning model unit 100, or may set the display device to display only a predetermined number of pieces of the latest control description information. As a result, the user 1 can easily check the control description information that is closer to the request content.

Note that the case where the input information D11 is input to the learning model unit 100 and the control description D12 generated by the learning model unit 100 is input to the execution code generating unit 120 has been described above.

On the other hand, in the learning model unit 100, there may be cases where response is late, cost is required, or others.

Therefore, the user 1 may determine whether or not the input information D11 matches specific rules, and determine whether or not to input the input information D11 to the learning model unit 100 on the basis of the determination result.

For example, rules indicating the correspondence relationship between existing input information and the control description can be used as the above rules. In this case, in a case where it is determined that the input information D11 does not match the rules, that is, in a case where it is determined that there is no input information that is similar to the input information D11 in the rules, the user 1 outputs the input information D11 to the learning model unit 100. On the other hand, in a case where it is determined that the input information D11 matches the rules, that is, in a case where it is determined that there is input information similar to the input information D11 in the rules, the user 1 extracts a control description corresponding to the corresponding existing input information and inputs the control description to the execution code generating unit 120. That is, in this case, the input information D11 is not input to the learning model unit 100. In addition, the execution code generating unit 120 generates the execution code D14 on the basis of the control description from the user 1. As a result, in a case where the generated input information D11 is similar to input information whose correspondence relationship with a control description is already clear, the control system 1000 can perform processing without passing through the learning model unit 100, whereby processing can be performed at higher speed and lower cost.

Furthermore, for example, rules indicating input information that can be directly input to the execution code generating unit 120 can be used as the above rules. In this case, in a case where it is determined that the input information D11 does not match the rules, the user 1 outputs the input information D11 to the learning model unit 100. On the other hand, in a case where it is determined that the input information D11 matches the rules, the user 1 inputs the input information D11 to the execution code generating unit 120. That is, in this case, the input information D11 is not input to the learning model unit 100. In addition, the execution code generating unit 120 generates the execution code D14 on the basis of the input information D11 from the user 1. As a result, in a case where the generated input information D11 can be directly input to the execution code generating unit 120, the control system 1000 can perform processing without passing through the learning model unit 100, whereby the processing can be performed at higher speed and lower cost.

Note that the user 1 may make the above determination on a rule basis such as by referring to a preset table, or by using a learning model unit different from the learning model unit 100.

The other learning model unit is presumed to be a lightweight and high-speed learning model unit or the like although having a lower processing capability than that of the learning model unit 100. Note that, in a case where the determination is difficult, the other learning model unit may request the learning model unit 100 to make the determination, that is, the other learning model unit and the learning model unit 100 may jointly perform processing.

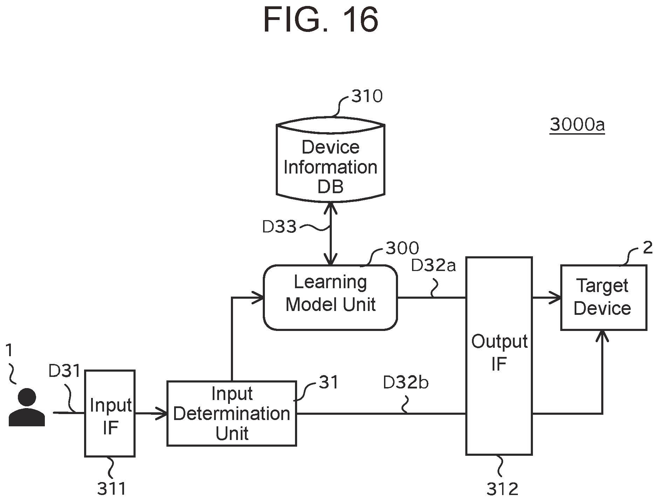

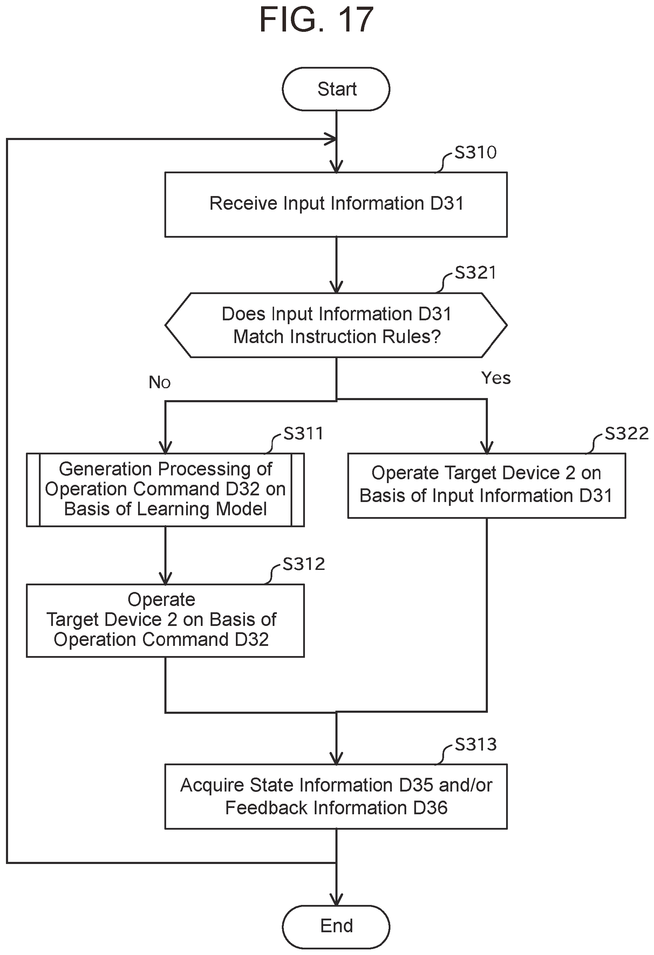

Note that similar methods, particularly the methods described in Modification 3-1, FIG. 16, and FIG. 17 may be adopted in other embodiments as appropriate.

### Modification 1-1

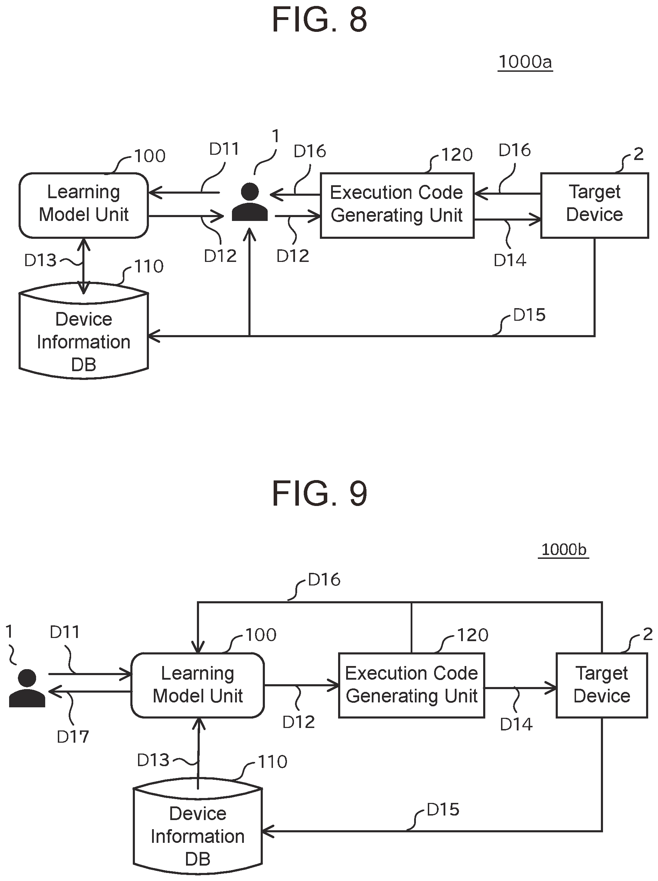

Next, a modification of the control system 1000 will be described. FIG. 8 is a configuration diagram illustrating an example of a control system 1000a as a modification of the control system 1000 according to the present embodiment. Note that the same elements as those of the control system 1000 are denoted by the same reference numerals, and description thereof is omitted.

In the control system 1000a illustrated in FIG. 8, output from a learning model unit 100 is input to an execution code generating unit 120 in the subsequent stage after being checked by the user 1.

In the present embodiment, the user 1 can check a control description D12 output from the learning model unit 100 and input input information D11 on the basis of the check result. In addition, the user 1 may check feedback information D16 from an execution code generating unit 120 and/or the target device 2 in addition to the control description D12 output from the learning model unit 100, and input the input information D11 on the basis of the check result of these. At this point, the user 1 may input input information D11 having new content or input input information D11 indicating correction, addition, or cancellation of content that has already been input. At this point, the input information D11 can include a command to the learning model unit 100. For example, the user 1 may input, as the input information D11, a command for removing a defect included in the input information D11 or a defect included in the output control description D12 together with the feedback information D16. Note that the command for removing a defect includes input for searching for the cause of the defect or a method for solving the defect.

The feedback information D16 may include a response to the request returned from the processing unit in a subsequent stage when control is requested to a processing unit in the subsequent stage after the learning model unit 100. Furthermore, the feedback information D16 may include information obtained from the processing unit after the learning model unit 100 requests control to the processing unit in the subsequent stage. For example, the feedback information D16 may include a response to the request returned from the execution code generating unit 120 when the control description D12 is input to the execution code generating unit 120 to request generation of the execution code D14. For example, the feedback information D16 may include the execution code D14 generated by the execution code generator 120. In addition, the feedback information D16 may include a response to a request returned from the target device 2 when the execution code D14 is input to the target device 2 to request the target device 2 to execute the code. The feedback information D16 may include the state information D15. The feedback information D16 may be directly output to the user 1 or may be output to the user 1 via an output device (not illustrated) included in the execution code generating unit 120 or the control system 1000.

Furthermore, the feedback information D16 can include information for determining whether or not control requested from the learning model unit 100 to the processing unit in the subsequent stage is correctly executed in the processing unit. The information is not limited to information directly obtained from the processing unit. For example, the information may be obtained from another person, device, network, or AI (none of which is illustrated). The feedback information D16 can include, for example, analysis information for determining whether or not the execution code D14 can correctly execute the intended control, such as execution time or control locus information. For example, the user 1 can instruct the learning model unit 100 to control the timing of the flow in the control description D12, to adjust the lead time, or the like on the basis of such information included in the feedback information D16.

Furthermore, for example, the user 1 may exchange information a plurality of times with the learning model unit 100 using the feedback information D16 and determine the validity (presence or absence of a problem) of the output control description D12 each time. In a case where the user 1 determines that there is no problem in the control description D12, the user 1 may output the control description D12 to the execution code generating unit 120.

The feedback information D16 can be acquired, for example, in step S114 described above.

Note that, although FIG. 8 illustrates an example in which the user 1 inputs the control description D12 to the execution code generating unit 120, the input of the control description D12 to the execution code generating unit 120 can also be performed by the learning model unit 100 that has received an instruction from the user 1.

In the present example, the control description D12 may include, for example, a description supporting low-code or no-code development.

The exchange of information between the user 1 and the learning model unit 100 in the present example may be performed, for example, via a terminal of the user 1 or via a user interface (for example, the input unit 102) included in the information processing device 10 in which the learning model unit 100 operates.

Furthermore, the input information D11 in the present example may be updated not by the user 1 but by the control system 1000 (for example, the correction check unit 203 or the like).

Furthermore, the feedback information D16 may be input to the learning model unit 100. The feedback information D16 input to the learning model unit 100 is used for additional training of the learning model unit 100, for example. The learning model unit 100 may update the model information D102 and/or the model reference information D104 on the basis of the input feedback information D16.

Other points may be similar to those of other control systems of the present embodiment.

As described above, in the present modification, the user 1 can correct the input information D11 while checking the control description D12 output from the learning model unit 100 and exchanging additional instructions, bug consultation, and the like with the learning model unit 100, and thus, it is possible to increase the accuracy of the control description D12 to be output. As a result, it is possible to improve the efficiency and the performance of the work of controlling the target device 2.

### Modification 1-2

Next, a second modification of the control system 1000 will be described. FIG. 9 is a configuration diagram illustrating an example of a control system 1000b as a modification of the control system 1000. Note that the same elements as those of the control system 1000 and the control system 1000a are denoted by the same reference numerals, and description thereof is omitted.

The control system 1000b illustrated in FIG. 9 is different in that the learning model unit 100 returns an inquiry D17 to the user 1. Examples of the inquiry D17 include an inquiry for reasking about an unclear or uncertain input information D11, an inquiry for a solution, and an inquiry for requesting reinput of a modified state or expression. As reasking for the unclear or uncertain input information D11, the learning model unit 100 may output an inquiry D17 requesting input of more specific information to the user 1 together with presentation of a reference portion. In addition, the learning model unit 100 may output the inquiry D17 to give a solution candidate as an option to the user 1 together with presentation of the reference portion as an inquiry about the solution. Furthermore, the learning model unit 100 may output the inquiry D17 asking for information of a solution that is most likely to be correct together with whether or not the solution is correct to the user 1 together with presentation of a reference portion as an inquiry about the solution. Furthermore, the learning model unit 100 may first generate an intermediate control description which is a control description in an intermediate form that is easily understood by a person, and output an inquiry D17 asking whether or not the generated intermediate control description is correct to the user 1 together with the generated intermediate control description.

The output of the inquiry D17 may be performed, for example, after the above-described step S110.

Upon receiving a response to the inquiry D17 from the user 1, the learning model unit 100 may update the input information D11 or confirm interpretation (meaning) of the input information D11.

For example, in a case where an image is included in the input information D11, there are many pieces of unclear content as to what is specifically referred to, such as "this," "that," "this one," or "that one".

In a case where such unclear content is detected, the learning model unit 100 may make an inquiry to the user 1 to resolve the unclear content.

Alternatively, the learning model unit 100 may update the input information D11 or confirm the interpretation of the input information D11 after selecting the most likely content for the unclear content. Furthermore, the learning model unit 100 may inquire of the user 1 about the validity of the most likely content selected above, and update the input information D11 or confirm the interpretation of the input information D11 on the basis of the selection determined to be valid by the user 1.

In addition, in a case where there is a plurality of options for the most likely content for the unclear content, the learning model unit 100 may update the input information D11 or confirm the interpretation of the input information D11 for each option in different cases.

Note that the inquiry method by the learning model unit 100 is not limited to the above, and various methods can be used.

Furthermore, for example, in a case where specifications do not indicate specific processing, the user 1 may cause the learning model unit 100 to extract specific processing with a template on the basis of information such as the device information D13.

In this case, for example, first, the user 1 causes the learning model unit 100 to extract a control description close to the content of the specifications with a template on the basis of information such as the device information D13. At this point, information may be given to the learning model unit 100 to present information such as a docstring regarding the extracted control description or the referred device information D13 itself to the user 1. Next, the user 1 causes the learning model unit 100 to extract a control description that can be discriminated in the specifications from the extracted control description. Next, the user 1 checks whether the control description D12 obtained by combining control descriptions extracted by the learning model unit 100 is correct or incorrect.

The processing of the learning model unit 100 described above in the present example can also be implemented as, for example, a part of the function of the input unit 102 or the preprocessing unit 105 of the learning model unit 100 or the input processing unit 201 (not illustrated) included in the information processing device 10.

As described above, in the present modification, the inquiry D17 is output to the user 1 with respect to the input information D11 that has been input, and the update or interpretation of the input information D11 is confirmed on the basis of the response, and thus the uncertainty of the input information D11 can be resolved. As a result, the accuracy of the output control description D12 can be improved, and furthermore, the efficiency and performance of the work of controlling the target device 2 can be improved.

Note that, in the above description, a case where the learning model unit 100 returns the inquiry D17 to the user 1 has been described. However, it is not limited thereto, and in a case where the control system 1000 includes the user terminal 1, the user terminal 1 may return an inquiry to the user 1. In this case, when receiving a response from the user 1 to the inquiry, the user terminal 1 may update the input information D11 or confirm the interpretation of the input information D11.

In the above description, the case where the configuration of the control system 1000 is modified to obtain the configuration of the control system 1000b has been described. However, it is not limited thereto, and the configuration of the control system 1000a may be modified to obtain the configuration of the control system 1000b, in which similar effects to those described above can be obtained.

### Modification 1-3

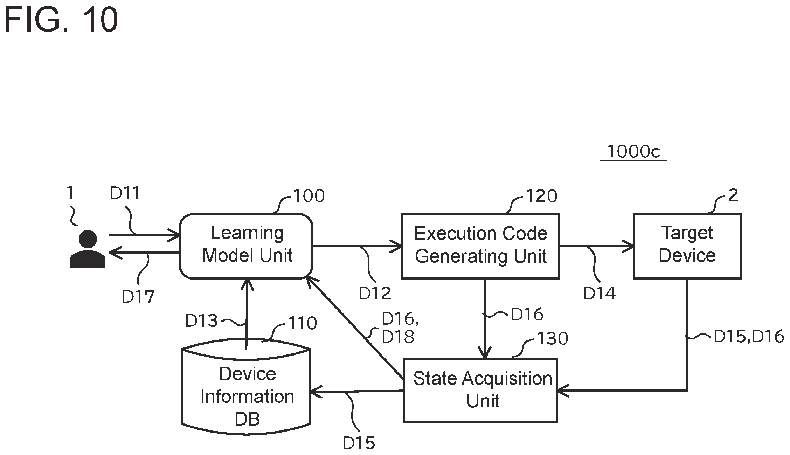

Next, a third modification of the control system 1000 will be described. FIG. 10 is a configuration diagram illustrating an example of a control system 1000c as a modification of the control system 1000. Note that the same elements as those of the control systems 1000, 1000a, and 1000b are denoted by the same reference numerals, and description thereof is omitted.

The control system 1000c illustrated in FIG. 10 further includes a state acquisition unit 130. The state acquisition unit 130 acquires feedback information D16 indicating a processing result or state information D15 indicating the state of the device after processing from a processing destination of the control description D12 output from a learning model unit 100 and execution code D14 generated therefrom. Note that the feedback information D16 or the state information D15 can include information for determining whether or not the execution code D14 has been able to correctly execute the intended control, such as execution time or control locus information. The state acquisition unit 130 may also acquire the control description D12 output from the learning model unit 100.

For example, the state acquisition unit 130 may input the acquired information to the learning model unit 100. In addition, the state acquisition unit 130 may update device information D13 on the basis of the acquired information, for example. Furthermore, for example, the state acquisition unit 130 may generate information that supplements (including addition, modification, and cancellation of) the input information D11 on the basis of the acquired information and input the generated information to the learning model unit 100 as supplementary information D18. Furthermore, for example, the state acquisition unit 130 may generate information that supplements (including addition, modification, and cancellation of) the control description D12 on the basis of the acquired information and input the generated information to the learning model unit 100 as supplementary information D18.

For example, the state acquisition unit 130 may generate a control command having new content or a command indicating addition, correction, or cancellation of an already input content indicated by the input information D11 as the supplementary information D18 and input the generated command to the learning model unit 100. In addition, for example, the state acquisition unit 130 may input, together with the acquired information, a command for removing a defect included in the input information D11 or a defect included in the output control description D12 to the learning model unit 100 as the supplementary information D18.

For example, the state acquisition unit 130 may determine whether or not the acquired information indicates normal processing or the normal state in the processing destination, and otherwise input, together with the acquired information, supplementary information D18 indicating correction, addition, or cancellation of the content indicated by the input information D11 that has already been input, to the learning model unit 100.

For example, the learning model unit 100 may update the model information D102 and/or the model reference information D104 on the basis of the input information (state information D15, feedback information D16, supplementary information D18, and the like).

The generation of the supplementary information D18 may be performed, for example, in step S115 described above. Furthermore, the output destination of the supplementary information D18 may include components other than the learning model unit 100. For example, the control system 1000 may output the supplementary information D18 generated by the state acquisition unit 130 to the user 1 or another device (not illustrated).

In addition, the state acquisition unit 130 may acquire an operation result by a simulator (not illustrated) of the target device 2 or an operation result in a debug mode of the target device 2 without actually operating the target device 2. The debug mode of the target device 2 refers to a mode in which an execution code is executed on a control board of the target device 2 with no actual device control performed, and only the internal state is updated, which is also referred to as an idle operation mode. By using the debug mode, the execution code D14 can be safely tried in a state close to the actual control on the target device 2.

Without being limited to the present modification, as a method for determining the validity of the control description D12 output from the learning model unit 100 and the execution code D14 generated from the control description D12 without actually operating the target device 2, the execution code generating unit 120 may be connected in such a manner that enables switching between the target device 2 and the simulator as the output destination of the execution code D14. The simulator includes a simulator that operates an icon of the target device 2 in an augmented reality space. In addition, when outputting the execution code D14 to the target device 2, the execution code generating unit 120 may add information instructing execution either in a normal mode or the debug mode.

For example, in a case where a compiling error occurs by compiling in the execution code generating unit 120, the state acquisition unit 130 acquires the feedback information D16 indicating that the compiling error has occurred, and inputs the feedback information D16 to the learning model unit 100. As a result, the learning model unit 100 can correct the control description D12 in such a manner as to resolve the compiling error.

In addition, for example, in a case where the target device 2 does not move by the execution code D14 generated by the execution code generating unit 120, the state acquisition unit 130 acquires the state information D15 indicating that the target device 2 does not move and inputs the state information D15 to the learning model unit 100. As a result, the learning model unit 100 can correct the control description D12 in such a manner that the target device 2 moves.

The processing of the state acquisition unit 130 in the present example can also be implemented as some functions of, for example, the input unit 102, the preprocessing unit 105, and the post-processing unit 106 of the learning model unit 100, or as some functions of the input processing unit 201, the output check unit 202, and the correction check unit 203 (all not illustrated) included in the information processing device 10.

Other points may be similar to those of other control systems of the present embodiment.

As described above, in the present modification, with respect to the input information D11 having been input, the state acquisition unit 130 acquires the feedback information D16 indicating the processing result or the state information D15 indicating the state of the device after the processing from the target device 2 or the execution code generating unit 120 serving as the output destination of the model output data D103 and/or the information generated on the basis of the model output data D103, and issues the supplementary information D18 as appropriate to the learning model unit 100 on the basis of the acquired information. As a result, the accuracy of the control description D12 can be improved, and furthermore, the efficiency and performance of the work of controlling the target device 2 can be improved.

Note that, in the above description, the case where the state acquisition unit 130 outputs the acquired information or information based on the information to the learning model unit 100 or the like has been described. However, it is not limited thereto, and in a case where the control system 1000 includes the user terminal 1, the state acquisition unit 130 may output the acquired information or information based on the information to the user terminal 1. In this case, the user terminal 1 may update the input information D11 on the basis of information having been input such as the state information D15, the feedback information D16, or the supplementary information D18.

Furthermore, in the present modification, for example, a person and a machine (state acquisition unit 130) cooperate with each other, whereby the accuracy of input to the learning model unit 100 can be improved, which can also contribute to reduction of the work load of the user 1.

In the above description, the case where the configuration of the control system 1000 is modified to obtain the configuration of the control system 1000c has been described. However, it is not limited thereto, and the configuration of the control system 1000a or the control system 1000b may be modified to obtain the configuration of the control system 1000c, in which similar effects to those described above can be obtained.

Note that, in a case where the user 1 checks the output from the learning model unit 100 as in the control system 1000a, the state acquisition unit 130 may not acquire the control description D12 output from the learning model unit 100.

As described above, according to the first embodiment, the control system 1000 includes: the user terminal 1 that generates the input information D11 including the information indicating the control content requested for the target device 2 in response to the operation by the user 1; and the state acquisition unit 130 that acquires information regarding at least one of the control description D12 generated by the learning model unit 100 that generates the control description D12 on the basis of the input information D11 generated by the user terminal 1 or the operation of the target device 2 and feeds back the information to at least one of the user terminal 1 or the learning model unit 100.

Furthermore, according to the first embodiment, the control system 1000 includes the execution code generating unit 120 that generates the execution code D14 for the target device 2 on the basis of the control description D12 generated by the learning model unit 100, the learning model unit 100 outputs the generated control description D12 to the execution code generating unit 120, and the state acquisition unit 130 acquires information regarding at least one of the control description D12 generated by the learning model unit 100, the execution code D14 generated by the execution code generating unit 120, or the operation of the target device 2, and feeds back the information to at least one of the user terminal 1 or the learning model unit 100.

Furthermore, according to the first embodiment, the control system 1000 includes the execution code generating unit 120 that generates the execution code D14 for the target device 2 on the basis of the control description D12 generated by the learning model unit 100, the learning model unit 100 outputs the generated control description D12 to the user terminal 1, the user terminal 1 outputs the control description D12 output by the learning model unit 400a to the execution code generating unit 120 or causes the learning model unit 400a to output the control description D12 to the execution code generating unit 120 in response to an operation by the user 1, and the state acquisition unit 130 acquires information regarding at least one of the execution code D14 generated by the execution code generating unit 120 or the operation of the target device 2 and feeds back the information to at least one of the user terminal 1 or the learning model unit 100.

In addition, according to the first embodiment, the learning model unit 100 uses information stored in the device information storing unit 110 that stores information regarding the target device 2 as additional information for generating the control description D12.

Furthermore, according to the first embodiment, the input information D11 generated by the user terminal 1 is at least one of a document character string describing specifications, specifications, specifications applied to another device, design specifications, an operation command, control codes, or source codes.

As a result, the control system 1000 according to the first embodiment can improve the accuracy of the control description D12, which results in further improvement of the efficiency and performance of the work of controlling the target device 2.

Furthermore, according to the first embodiment, the user terminal 1 outputs the generated input information D11 to the learning model unit 100 in a case where it is determined that the generated input information D11 does not match the rules, and outputs the generated input information D11 or a corresponding control description to the execution code generating unit 120 in a case where it is determined that the generated input information D11 matches the rules.

As a result, the control system 1000 according to the first embodiment can omit the processing of the learning model unit 100 in a case where the input information D11 matches existing rules, and can perform the processing at higher speed and lower cost.

As described above, according to the first embodiment, the control method includes: by the user terminal 1, generating the input information D11 including the information indicating the control content requested for the target device 2 in response to an operation by the user 1; and, by the state acquisition unit 130, acquiring information regarding at least one of the control description D12 generated by the learning model unit 100 that generates the control description D12 on the basis of the input information D11 generated by the user terminal 1 or the operation of the target device 2 and feeding back the information to at least one of the user terminal 1 or the learning model unit 100.

As a result, the control method according to the first embodiment can improve the accuracy of the control description D12, which results in further improvement of the efficiency and performance of the work of controlling the target device 2.

### Second Embodiment

Next, a second embodiment will be described. In the present embodiment, an example of assisting work related to control of a target device using a learning model will be described.

Hereinafter, it is assumed that various control devices, such as a control device for a PLC, a working machine, a robot, a sensor, a conveyance device, and other machine control devices, for example, in a factory are controlled. Skilled workers may be familiar with control methods of a wide variety of control devices and complex control devices; however, there are cases where workers with less skill need to control a control device due to transfer or the like. In addition, when a new control device (including version upgrade) is introduced, it is necessary to notify all the workers of a control method corresponding to the new control device, and if the control method is not sufficiently made known, it may lead to a mistake.

In such a case, it is preferable to reliably perform desired control without knowing a specific control method, for example, a control command to be performed on the control device, a control signal, a control code, a command to a controller supporting the control device, or the like, since this leads to improvement in work efficiency and performance.

Note that the scene of controlling a device is not limited to the inside of a factory, nor is the utilization scene of the present embodiment limited to the inside of a factory.

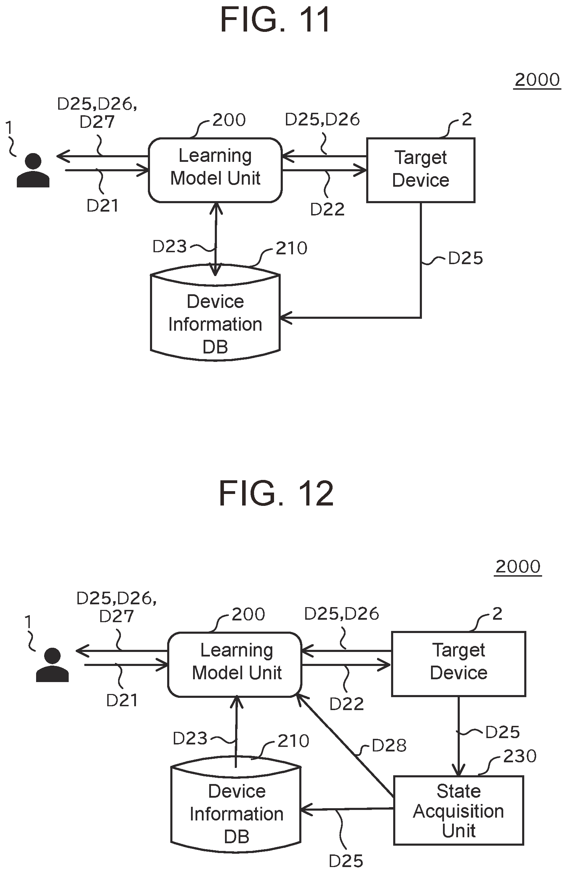

FIG. 11 is a configuration diagram illustrating an example of a control system 2000 according to the second embodiment. The control system 2000 illustrated in FIG. 11 is a control system for controlling a device using a learning model, and includes a learning model unit 200 and a device information storing unit 210 (referred to as a device information DB in the drawing).

When input information D21 is input, the learning model unit 200 outputs a control command D22. When the input information D21 is input, the learning model unit 200 outputs the control command D22 on the basis of model information D102. The configuration of the learning model unit 200 may be basically similar to that of the learning model unit 100 of the first embodiment.

In the present embodiment, the learning model unit 200 is a model and an operation environment thereof, the model configured to output the control command D22 corresponding to the input information D21 when the input information D21 is input. Furthermore, the learning model unit 200 may be a model and an operation environment thereof, the model configured to, when the input information D21 is input, generate and output the control command D22 on the basis of the input information D21, device information D23, and other information that can be referred to in the learning model unit 200.

In the present embodiment, the input information D21 includes information indicating the control content for the target device 2. The input information D21 may be, for example, text, an image, audio, or a combination thereof indicating the control content for the target device 2. The input information D21 may be, for example, text, an image, audio, or a combination thereof indicating a plurality of pieces of control content for the target device 2. Furthermore, the input information D21 may include information indicating the content of control performed temporally continuously, and in this case, may be time-series data having a predetermined data structure including text, an image, audio, a combination thereof, or the like indicating the control content as described above. It is based on the premise that the control content is indicated in a manner that matches an input format of the model used by the learning model unit 200; however, this is not the case when error processing, correction processing, or conversion processing is included in the preceding stage of the learning model unit 200.

The control content may be indicated in the input information D21 in a similar manner to, for example, that of the first embodiment. For example, after specifying the control to be performed on the target device 2, the value of a parameter for performing the control or the state after the control may be specified. In that case, the input information D21 may include, for example, information specifying the control and information indicating the value of the parameter for performing the control or the state after the control. In addition, the input information D21 can include not only information directly indicating the control content for the target device 2 but also information indirectly indicating the control content by using the operation content corresponding to the control content, the speech and behavior of the user 1, an image of the target device 2, a similar control command in another model, or the like.

The control command D22 includes information related to control of the target device 2 which is indicated in a predetermined format which can be discriminated by the target device 2 or an interface requesting control to the target device 2. The control command D22 may include information indicating a control request to the target device 2. The control command D22 is, for example, a control command, a control signal, or a control code for the target device 2. In addition, the control command D22 may be, for example, a command described in a format handled by a predetermined controller supporting the target device 2.

The device information storing unit 210 stores the device information D23 that is information of the target device 2. Handling of the device information storing unit 210 and the device information D23 is basically similar to that of the device information storing unit 110 and the device information D13 of the first embodiment. Note that the device information D23 in the present embodiment may include, for example, information used for controlling the target device 2. The device information D23 is used, for example, as additional information for the learning model unit 200 to output the control command D22. Hereinafter, in the present embodiment, in particular, information indicating the state of the target device 2 may be referred to as state information D25.

In the present embodiment, the learning model unit 200 may be, for example, a language learning model and the operation environment thereof, the language learning model such as LLM that receives input in natural language and obtains an output result. Furthermore, the learning model unit 200 may be, for example, an image learning model and the operation environment thereof, the image learning model such as a VLM that receives input of an image and outputs a result. Furthermore, the learning model unit 200 may be, for example, a multimodal model and the operation environment thereof, the multimodal model for receiving input in natural language and an image and obtaining an output result. In this case, the input information D21 may be input in text data, image data, a combination of text data and image data, or a data format (such as audio data or a moving image which is a combination of audio data and image data) that can be converted into the text data, image data, or a combination of text data and image data. Note that the learning model used in the present embodiment is not limited to the above-described model.

In the present embodiment, in order to simplify the description, there are cases where the components provided corresponding to the learning model unit 200 are described using the reference numerals of the components provided corresponding to the learning model unit 100 as they are; however, it should be noted that they are provided only corresponding to the learning model unit 200. Note that the above similarly applies to other embodiments as well.

In the present embodiment, the input information D21 corresponds to the model input data D101. The control command D22 corresponds to the model output data D103. For example, the learning model unit 200 (in particular, the model control unit 101) may be configured to output the control command D22 corresponding to the input information D21 on the basis of the model information D102 and the model reference information D104 as necessary when receiving the input information D21.

Furthermore, in such a case, the model generating unit 107 provided to correspond to the learning model unit 200 may perform machine learning using, for example, the model training data D105 including candidates for the input information D21 that can be input to the model control unit 101, and generate or update the model information D102. Furthermore, the model generating unit 107 may generate or update the model information D102, for example, by performing machine learning using the model training data D105 including a candidate for the input information D21 that can be input to the model control unit 101 and a candidate for the control command D22 corresponding thereto.

Reference numeral D26 denotes feedback information indicating a control result in the target device 2. Also in the present embodiment, state information D25 and/or the feedback information D26 may be acquired from the output destination of the model output data D103 and/or information generated on the basis of the model output data D103. For example, the control system 2000 may output the acquired state information D25 and/or the feedback information D26 to the user 1, the learning model unit 200, or another device (not illustrated) as information indicating the control result. Furthermore, the control system 2000 can generate supplementary information D28 for the input and output data of the learning model unit 200 on the basis of the acquired state information D25 and/or feedback information D26, and issue the supplementary information D28 to the user 1, the learning model unit 200, or another device (not illustrated). In addition, the control system 2000 may be configured to return an inquiry D27 to the user 1 in a case where the input information D21 includes unclear or uncertain information. The handling of the inquiry D27 is similar to that of the inquiry D17 of the first embodiment.

FIG. 12 is a configuration diagram illustrating another example of the control system 2000. As illustrated in FIG. 12, the control system 2000 may further include a state acquisition unit 230 that acquires state information D25 and/or feedback information D26 and issues supplementary information D28. The state acquisition unit 230 is similar to the state acquisition unit 130 of the first embodiment.

Also in the present embodiment, the target device 2 is not particularly limited. Although it is based on the premise that the target device 2 is a device that can actually be controlled by receiving a control command D22, it is not limited thereto in a case where a conversion device that converts various signals such as a controller or a converter is included between a learning model unit and the target device 2. In this case, it suffices that the conversion device receives the control command D22 to control the target device 2.

In the present embodiment, the input information D21 received by the control system 2000 can be rephrased as information regarding a request in a work environment, in this example, an environment in which the target device 2 operates (in this example, the control content requested for the target device 2). Therefore, the input information D21 received by the control system 2000 can be regarded as an example of first information indicating the request in the work environment. In addition, the control command D22 can be regarded as information used for the work (work related to control of the target device 2) corresponding to such input information D21. Hereinafter, the control command D22 output to a predetermined output destination from the operation environment of the learning model to which model input data based on the input information D21 is input may be referred to as second information.

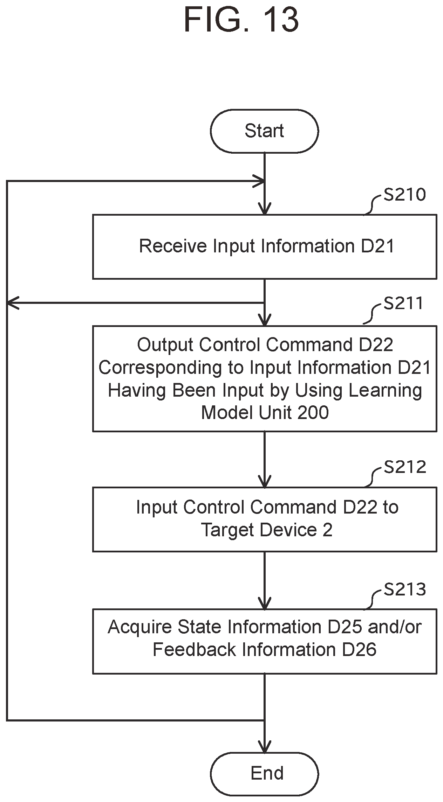

Next, an operation of the control system 2000 of the present embodiment will be described. FIG. 13 is a flowchart illustrating an operation example of the control system 2000.

In the example illustrated in FIG. 13, first, the control system 2000 receives the input information D21 (step S210). For example, the input unit 102 or the input processing unit 201 described above may receive the input information D21. The received input information D21 is input to the learning model unit 200 as the model input data D101.

Next, the control system 2000 performs generation processing of the control command D22 using the learning model unit 200 (step S211). In step S211, the learning model unit 200 (more specifically, the model control unit 101) outputs the control command D22 corresponding to the input information D21 on the basis of the model reference information D104 including the model information D102 and the input information D21 having been input, as well as the device information D23 as necessary.

In step S211, the learning model unit 200 may generate the control command D22 for binary data from the input information D21 that has been input, for example, by using a learning model capable of generating binary data. Furthermore, the learning model unit 200 may generate the control command D22 for text data from the input information D21 that has been input, for example, by using a learning model capable of generating text data. Furthermore, the learning model unit 200 may generate the control command D22 for image data from the input information D21 that has been input, for example, by using a learning model capable of generating image data. Furthermore, the learning model unit 200 may generate the control command D22 for audio data from the input information D21 that has been input, for example, by using a learning model capable of generating audio data.

In step S211, the preprocessing unit 105 and/or the post-processing unit 106 of the learning model unit 200 may further perform the above-described processing.

The control command D22 output from the learning model unit 200 is input to, for example, the target device 2 (step S212). The input of the control command D22 to the target device 2 may be directly performed from the control system 2000 (more specifically, the learning model unit 200 or the information processing device 10 serving as the operation environment thereof), or may be indirectly performed via a communication network or another device (such as a server or various conversion devices).

As a result, the target device 2 operates in accordance with the input control command D22.

In a case where there is a change in the state of the target device 2 due to control of the target device 2 or the like as a result of outputting the control command D22, and there is feedback from the target device 2, the control system 2000 may acquire the state information D25 and the feedback information D26 (step S213). Note that the processing in step S213 is not essential and may be omitted as appropriate.

The control system 2000 may repeat the processing of steps S210 to S213 a plurality of times (for example, until the desired control for the target device 2 is completed).

As described above, according to the present embodiment, even if the user 1 does not know a specific control method for the target device 2, the control command D22 can be generated from the input information D21 input from the user 1, whereby the target device 2 can be controlled on the basis of the generated control command D22. Therefore, it is possible to improve efficiency and sophistication of work related to control of the target device 2.

Furthermore, according to the present embodiment, a device can be controlled to an appropriate state even from ambiguous information.

### Third Embodiment

Next, a third embodiment will be described. In the present embodiment, an example of assisting work related to operation of a target device using a learning model will be described.

Hereinafter, for example, it is assumed that various devices such as an air conditioner, a refrigerator, a television, a lighting, a washing machine, a projector, various sensors, or a communication device are operated in a home or a building. In recent years, even these devices for consumers have advanced functions to be provided, and control has become complicated. Although a controller such as an operation screen or a remote controller is devised such that complicated control can be easily performed, it is still difficult to memorize all the operations, and there is a case where a desired function cannot be easily reached although the desired function is provided.

In addition, despite the same type of functions, there are many cases where function names provided are different by models, there are differences in detailed functions, or there are differences in control methods, and in a scene where different models are introduced by replacement or the like, it is necessary to learn these differences from scratch, which is troublesome.

In addition, some devices automatically perform control to be in an appropriate state by memorizing a past operation history, grasping the operation environment, or the like. However, there is a case where it is difficult to perform accurate control in such a scene where a plurality of people gather in a case where the appropriate state varies depending on a person, or in a scene where the appropriate state varies depending on a change in the physical condition or the like even for one person.

In such a case, it is preferable to be able to easily perform the operation for setting the state to a desired state even if the operator does not know a specific operation method or the operator does not know an appropriate state since this leads to improvement in work efficiency and performance.

Note that the scene of operating a device is not limited to the home or building and the utilization scene of the present embodiment is not limited to the home or building.

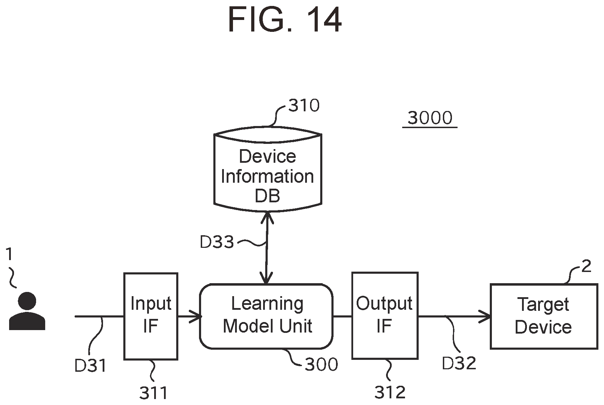

FIG. 14 is a configuration diagram illustrating an example of a control system 3000 according to the third embodiment. The control system 3000 illustrated in FIG. 14 is a control system for operating a device using a learning model, and includes a learning model unit 300, a device information storing unit 310 (referred to as device information DB in the drawing), an input interface 311 (referred to as input IF in the drawing), and an output interface 312 (referred to as output IF in the drawing).

When input information D31 is input, the learning model unit 300 outputs an operation command D32. When the input information D31 is input, the learning model unit 300 outputs the operation command D32 on the basis of model information D102. The configuration of the learning model unit 300 may be basically similar to that of the learning model unit 100 of the first embodiment.

In the present embodiment, the learning model unit 300 is a model and an operation environment thereof, the model configured to output the operation command D32 corresponding to the input information D31 when the input information D31 is input. Furthermore, the learning model unit 300 may be a model and an operation environment thereof, the model configured to, when the input information D31 is input, generate and output the operation command D32 on the basis of the input information D31, device information D33, and other information that can be referred to in the learning model unit 300.

In the present embodiment, the input information D31 includes information indicating the operation content requested for the target device 2. The input information D31 may be, for example, text, an image, audio, or a combination thereof indicating the operation content for the target device 2. The input information D31 may be, for example, text, an image, audio, or a combination thereof indicating a plurality of pieces of operation content for the target device 2. Furthermore, the input information D31 may include information indicating the content of operation performed temporally continuously, and in this case, may be time-series data having a predetermined data structure including text, an image, audio, a combination thereof, or the like indicating the operation content as described above. It is based on the premise that the operation content is indicated in a manner that matches an input format of the model used by the learning model unit 300; however, this is not the case when error processing, correction processing, or conversion processing is included in the preceding stage of the learning model unit 300.

As an example of how to indicate the operation content in the input information D31, the operation to be performed on the target device 2 may be specified, and then the value of a parameter for performing the operation or the state after the operation may be specified. In that case, the input information D31 may include, for example, information specifying the operation and information indicating the value of the parameter for performing the operation or the state after the operation. Examples of the value of a parameter for performing the operation may include a value related to the type of the operation (ON/OFF or the like), the orientation, the amount, or time. In addition, the input information D31 can include not only information directly indicating the operation content for the target device 2 but also information indirectly indicating the operation command content by using the control content corresponding to the operation content, the speech and behavior of the user 1, an image of the target device 2, a similar operation command in another model, or the like.

The operation command D32 includes information related to operation of the target device 2 which is indicated in a predetermined format that can be discriminated by the target device 2 or an interface (including a person) requesting control of the target device 2. The operation command D32 may include information indicating an operation request or a control request to the target device 2. The operation command D32 is, for example, an operation command, an operation signal, an operation code, a control command, a control signal, or a control code for the target device 2. In addition, the operation command D32 may be, for example, a command described in a format handled by a predetermined controller supporting the target device 2. The operation command D32 can be said to be a concept obtained by adding information regarding the operation to the above-described control command D22. For example, in a case where the interface is a person, namely, in a case where control is requested for the target device 2 via the person, the operation command D32 may be information indicating an operation method of the target device 2 indicated in a format that can be discriminated by a person.

The device information storing unit 310 stores the device information D33 that is information of the target device 2. Handling of the device information storing unit 310 and the device information D33 is basically similar to that of the device information storing unit 110 and the device information D13 of the first embodiment. Note that the device information D33 in the present embodiment may include, for example, information used for operating the target device 2. The device information D33 can include, for example, information indicating a procedure of an operation actually performed on the target device 2 for the operation content. Furthermore, the device information D33 can include, for example, a command, a signal, a code, and the like issued to the target device 2. The device information D33 is used, for example, as additional information for the learning model unit 300 to output the operation command D32. Hereinafter, in the present embodiment, in particular, information indicating the state of the target device 2 may be referred to as state information D35.

The input interface 311 is an interface that receives the input information D31 from the user 1 and inputs the input information D31 to the learning model unit 300. The input interface 311 may, for example, convert the input information D31 input from the user 1 into data that matches input of the learning model unit 300 and outputs the converted data. Note that the input interface 311 may be provided as an example of the input unit 102 described above, for example.

The output interface 312 receives the operation command D32 from the learning model unit 300 and outputs the operation command D32 to a predetermined output destination. Note that the output interface 312 may be provided, for example, as an example of the output unit 103 described above. The output interface 312 may be, for example, an interface that converts the operation command D32 output from the learning model unit 300 into data supported by the predetermined output destination and outputs the data. In the present embodiment, the output destination of the output interface 312 can include the target device 2, a controller 4 (not illustrated), a predetermined display 7 (not illustrated), and an operation terminal of the user 1 (not illustrated).

In the present embodiment, the learning model unit 300 may be, for example, a language learning model such as LLM that receives input in natural language and obtains an output result, and the operation environment thereof. Furthermore, the learning model unit 300 may be, for example, an image learning model such as a VLM that receives input of an image and outputs a result, and the operation environment thereof. Furthermore, the learning model unit 300 may be, for example, a multimodal model that receives input in natural language and an image and obtains an output result, and the operation environment thereof. In this case, the input information D31 may be input in text data, image data, a combination of text data and image data, or a data format (such as audio data or a moving image which is a combination of audio data and image data) that can be converted into the text data, image data, or a combination of text data and image data. Note that the learning model used in the present embodiment is not limited to the above-described model.

In the present embodiment, the input information D31 corresponds to the model input data D101. The operation command D32 corresponds to the model output data D103. For example, the learning model unit 300 (in particular, the model control unit 101) may be configured to output the operation command D32 corresponding to the input information D31 on the basis of the model information D102 and the model reference information D104 as necessary when receiving the input information D31.

Furthermore, in such a case, the model generating unit 107 provided to correspond to the learning model unit 300 may perform machine learning using, for example, the model training data D105 including candidates for the input information D31 that can be input to the model control unit 101, and generate or update the model information D102. Furthermore, the model generating unit 107 may generate or update the model information D102, for example, by performing machine learning using the model training data D105 including a candidate for the input information D31 that can be input to the model control unit 101 and a candidate for the operation command D32 corresponding thereto.

Although not illustrated, also in the present embodiment, state information D35 and/or feedback information D36 may be acquired from the output destination of the model output data D103 of the learning model unit 300 and/or information generated on the basis of the model output data D103. For example, the control system 3000 may output the acquired state information D35 and/or the feedback information D36 to the user 1, the learning model unit 300, or another device (not illustrated) as information indicating the response result. In addition, the control system 3000 may be configured to return an inquiry D37 to the user 1 in a case where the input information D31 includes unclear or uncertain information. Furthermore, the control system 3000 can generate supplementary information D38 for the input and output data of the learning model unit 300 on the basis of the acquired state information D35 and/or feedback information D36, and issue the supplementary information D38 to the user 1, the learning model unit 300, or another device (not illustrated). Handling of the state information D35, the feedback information D36, the inquiry D37, and the supplementary information D38 may be basically similar to that of the first embodiment.

In addition, the control system 3000 may further include a state acquisition unit 330 (not illustrated) that acquires the state information D35 and/or the feedback information D36 and issues the supplementary information D38 as necessary. The state acquisition unit 330 is similar to the state acquisition unit 130 of the first embodiment.

Also in the present embodiment, the target device 2 is not particularly limited. Note that it is based on the premise that the target device 2 is a device capable of receiving the operation command D32 and can be controlled in a manner corresponding to the operation content indicated by the operation command D32; however, it is not limited thereto in a case where a conversion device or an operator that converts various signals such as the controller 4 or a converter between the learning model unit and the target device 2. In this case, it suffices that the conversion device or the operator receives the operation command D32 and operates the target device 2.

In the present embodiment, the input information D31 received by the control system 3000 can be rephrased as information regarding a request in a work environment, in this example, an environment in which the target device 2 operates (in this example, the operation content requested for the target device). Therefore, the input information D31 received by the control system 3000 can be regarded as an example of first information indicating the request in the work environment. In addition, the operation command D32 can be regarded as information used for the work (work related to operation of the target device 2) corresponding to such input information D31. Hereinafter, the operation command D32 output to a predetermined output destination from the operation environment of the learning model to which model input data based on the input information D31 is input may be referred to as second information.

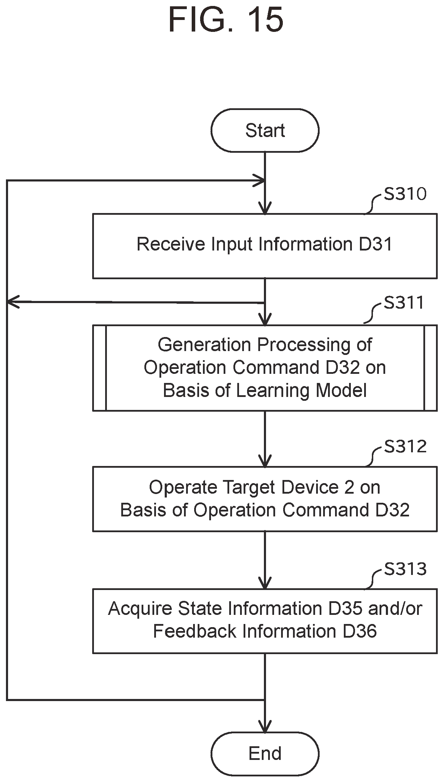

Next, an operation of the control system 3000 of the present embodiment will be described. FIG. 15 is a flowchart illustrating an operation example of the control system 3000.

In the example illustrated in FIG. 15, first, the input interface 311 of the control system 3000 receives the input information D31 (step S310). The received input information D31 is input to the learning model unit 300 as the model input data D101.

Next, the control system 3000 performs generation processing of the operation command D32 using the learning model unit 300 (step S311). In step S311, the learning model unit 300 (more specifically, the model control unit 101) generates and outputs the operation command D32 corresponding to the input information D31 on the basis of the model reference information D104 including the model information D102 and the input information D31 having been input, as well as the device information D33 as necessary.

In step S311, the learning model unit 300 may generate the operation command D32 for binary data from the input information D31 that has been input, for example, by using a learning model capable of generating binary data. Furthermore, the learning model unit 300 may generate the operation command D32 for text data from the input information D31 that has been input, for example, by using a learning model capable of generating text data. Furthermore, the learning model unit 300 may generate the operation command D32 for image data from the input information D31 that has been input, for example, by using a learning model capable of generating image data. Furthermore, the learning model unit 300 may generate the operation command D32 for audio data from the input information D31 that has been input, for example, by using a learning model capable of generating audio data.

In step S311, the preprocessing unit 105 and/or the post-processing unit 106 of the learning model unit 300 may further perform the above-described processing.

The operation command D32 output from the learning model unit 300 is output to a predetermined output destination via the output interface 312, for example. The predetermined output destination may be the target device 2, the controller 4, the predetermined display 7, or the operation terminal (not illustrated) of the user 1. When the operation command D32 is input to the predetermined output destination, the target device 2 is operated in accordance with the input operation command D32 (step S312).

For example, the output interface 312 may output the operation command D32 to the target device 2. In this case, the target device 2 that has received the operation command D32 (for example, an operation command, an operation signal, an operation code, a control command, a control signal, a control code, or the like) may execute actual control in accordance with the operation command D32. Alternatively, the output interface 312 may output the operation command D32 to the controller 4 supporting the target device 2. In this case, the controller 4 that has received the operation command D32 (indirect control information for the target device 2, such as a command, an operation command, an operation signal, or an operation code for the controller 4, for example) may operate the target device 2 in accordance with the operation command D32. The controller 4 may operate the target device 2 by outputting direct control information such as a control code to the target device 2 on the basis of the control information indicated by the received operation command D32. Note that the controller 4 may be, for example, an operation panel provided in the target device 2 or a remote controller supporting the target device 2 directly operated by the user 1. The controller 4 includes a controller unique to the target device 2 and a general-purpose controller. In addition, the output interface 312 may output the operation command D32 to the operation terminal of the user 1 or the predetermined display. In this case, the operation terminal of the user 1 or the display which has received the operation command D32 (for example, information indicating an operation method) displays the operation command D32. Then, the user 1 may operate the target device 2 or the controller 4 by referring to the displayed operation command D32.

The input of the operation command D32 to the output destination may be directly performed from the control system 3000 (more specifically, the learning model unit 300 or the information processing device 10 serving as the operation environment thereof), or may be indirectly performed via a communication network or another device (such as a server or various conversion devices).

As a result, the target device 2 operates in accordance with the operation command D32.

In a case where there is a change in the state of the target device 2 due to operation of the target device 2 or the like as a result of outputting the operation command D32, and there is feedback from the target device 2, the control system 3000 may acquire the state information D35 and the feedback information D36 (step S313). Note that the processing in step S313 is not essential and may be omitted as appropriate.

The control system 3000 may repeat the processing of steps S310 to S313 a plurality of times (for example, until the desired operation for the target device 2 is completed).

As described above, according to the present embodiment, even if the user 1 does not know a specific operation method for the target device 2, the operation command D32 can be generated from the input information D31 input from the user 1, whereby the target device 2 can be operated on the basis of the generated operation command D32. Therefore, it is possible to improve efficiency and sophistication of work related to the operation of the target device 2.

Furthermore, according to the present embodiment, a device can be operated to an appropriate state even from ambiguous information. Furthermore, according to the present embodiment, it is possible to operate a device into an appropriate state without depending on the device and without learning the operation method of the device.

### Modification 3-1

Next, a modification of the control system 3000 will be described. FIG. 16 is a configuration diagram illustrating an example of a control system 3000a as a modification of the control system 3000 according to the present embodiment. Note that the same elements as those of the control system 3000 are denoted by the same reference numerals, and description thereof is omitted.

The control system 3000a illustrated in FIG. 16 further includes an input determination unit 31. Upon receiving input information D31, the input determination unit 31 analyzes the input information D31 and switches the control destination for the input information D31. In the present modification, the input determination unit 31 switches the control destination for the input information D31 between a learning model unit 300 and an output interface 312.

The input determination unit 31 may switch the control destination for the input information D31 depending on, for example, whether or not the input information D31 satisfies instruction rules of operation for the target device 2. In a case where the input information D31 satisfies the instruction rules of the operation on the target device 2, the input determination unit 31 may directly input the input information D31 to the output interface 312. On the other hand, in a case where the input information D31 does not satisfy the instruction rules of the operation on the target device 2, the input determination unit 31 may input the input information D31 to the learning model unit 300.

Whether or not the instruction rules of the operation are satisfied may be determined using, for example, a model described on a rule basis. The input determination unit 31 may be a learning model having a relatively low capacity with respect to the learning model unit 300.

Hereinafter, in order to distinguish the information input in the output interface 312, the operation command D32 output from the learning model unit 300 may be referred to as an operation command D32a, and the input information D31 output to the output interface 312 may be referred to as an operation command D32b.

In the present example, the output interface 312 may be any interface that receives the operation command D32a or the operation command D32b and outputs the operation command D32a or the operation command D32b to a predetermined output destination.

Next, the operation of the control system 3000a of the present modification will be described. FIG. 17 is a flowchart illustrating an operation example of the control system 3000a.

In the example illustrated in FIG. 17, first, the input interface 311 of the control system 3000a receives the input information D31 (step S310). The received input information D31 is input to the input determination unit 31.

Next, the input determination unit 31 determines whether or not the input information D31 satisfies the instruction rules of the operation on the target device 2 (step S321). At this point, if it is determined that the input information D31 satisfies the instruction rules of the operation on the target device 2 (Yes in step S321), the input information D31 is input to the output interface 312 (the process proceeds to step S322). On the other hand, if it is determined that the input information D31 does not satisfy the instruction rules of the operation on the target device 2 (No in step S321), the input information D31 is input to the learning model unit 300 (the process proceeds to step S311).

The processing in steps S311 to S313 is similar to that in the example illustrated in FIG. 15.

In step S322, the output interface 312 outputs the input information D31, having been input, to a predetermined output destination as the operation command D32b. As a result, the target device 2 operates in accordance with the operation command D32b.

Other points may be similar to those of other control systems of the present embodiment.

As described above, according to the present modification, in a case where the input from the user 1 satisfies the instruction rules of the operation on the target device 2, the target device 2 can be operated in accordance with the input, whereas in a case where the input does not satisfy the instruction rules, the target device 2 can be operated using the learning model. Therefore, it is possible to further improve the efficiency of work related to the operation of the target device 2.

### Modification 3-2

Next, another modification of the control system 3000 will be described. In the present modification, an operation command including arbitration of a plurality of pieces of input is generated using a learning model.

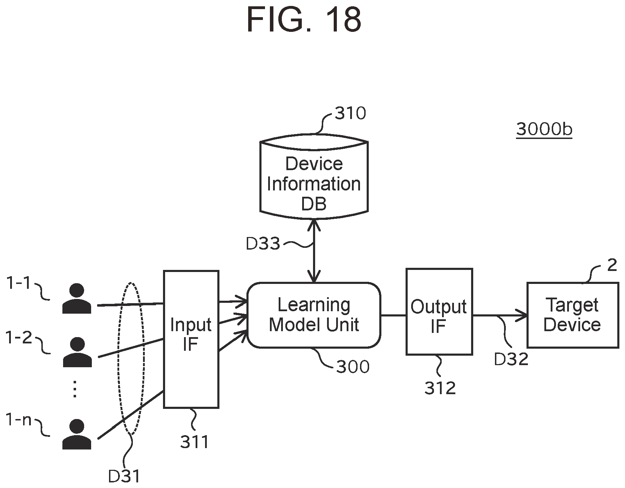

FIG. 18 is a configuration diagram illustrating an example of a control system 3000b as a modification of the control system 3000 according to the present embodiment. Note that the same elements as those of the control system 3000 are denoted by the same reference numerals, and description thereof is omitted.

In the control system 3000b illustrated in FIG. 18, an input interface 311 receives input information D31 from a plurality of users 1.

The input interface 311 receives the input information D31 from the plurality of users 1 and inputs the input information D31 to a learning model unit 300. At this point, the input interface 311 may receive the input information D31 to which information of the users 1 who are input sources is attached, or the input interface 311 may discriminate the users 1 as the input sources, attach the information of the input sources, and then receive the input information D31, or may receive the input information D31 without doing anything.

The learning model unit 300 is only required to be a model configured to output an operation command D32 corresponding to the group of pieces of input information D31 when the group of pieces of input information D31 received by the input interface 311 is input, and the operation environment thereof. The learning model unit 300 may be a model and an operation environment thereof, the model configured to, when the group of pieces of input information D31 is input, generate and output the operation command D32 on the basis of the group of pieces of input information D31, device information D33, and other information that can be referred to in the learning model unit 300.

For example, the learning model unit 300 may perform processing of extracting a suitable solution on a language space (more specifically, on a feature vector space having information about the language space) by using a language learning model such as LLM that receives input of a natural language and obtains an output result, thereby generating and outputting the operation command D32 that is a compromise for different operation content indicated by the group of pieces of input information D31. At this point, the learning model unit 300 may refer to a history of the input information D31 for each user 1 as the input source and/or a history of the operation command D32 for each user 1 as the input source.

Other points may be similar to those of other control systems of the present embodiment.

As described above, according to the present modification, even in a case where information regarding different operation content is input from a plurality of users 1, it is possible to generate a more appropriate operation command D32 in which pieces of the different operation content are mediated using the learning model unit 300, and thus it is possible to further enhance the functionality of work related to the operation of the target device 2.

### Modification 3-3

Next, another modification of the control system 3000 will be described. In the present modification, an operation screen user interface is generated using a learning model.

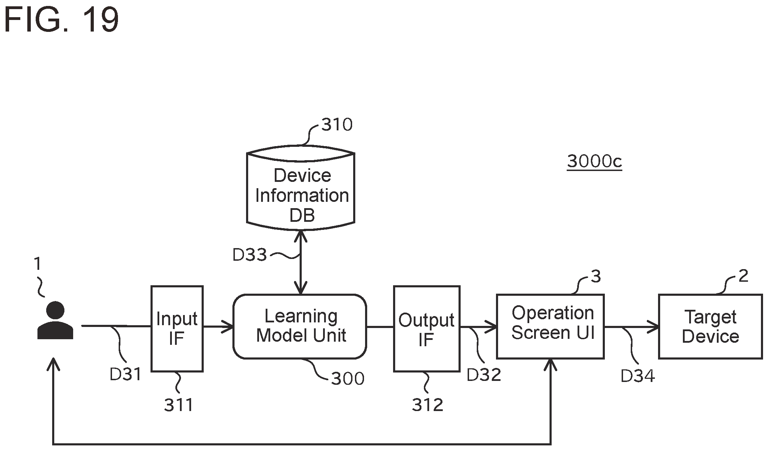

FIG. 19 is a configuration diagram illustrating an example of a control system 3000c as a modification of the control system 3000 according to the present embodiment. Note that the same elements as those of the control system 3000 are denoted by the same reference numerals, and description thereof is omitted.

The control system 3000c illustrated in FIG. 19 further includes an operation screen user interface 3 (referred to as operation screen UI in the drawing). In addition, the learning model unit 300 generates an operation screen for actually operating the target device 2 with the operation content corresponding to input information D31 as an operation command D32.

The operation screen generated by the learning model unit 300 may be, for example, a screen application programming interface (API) having a function of receiving operation input from the user 1 together with the description of the operation content and outputting a control command D34 such as a control code corresponding to the received operation input. Note the output of the control code and the like corresponding to the operation input also includes an aspect in which a plurality of control commands D34 are sequentially output corresponding to one time of operation input. In addition, the operation screen may be a screen API including operation explanation, operation input reception, and control command output corresponding to two or more pieces of different operation content. For example, the learning model unit 300 may extract two or more pieces of operation information indicating different operation content as the operation command D32 corresponding to the input information D31, and generate a screen API including operation input reception and control command output corresponding to each of the pieces of operation information.

Furthermore, the operation screen generated by the learning model unit 300 may be one in which the display mode of an existing operation screen is modified such that an operation portion corresponding to the corresponding operation content is displayed in a highlighted manner, the operation function is displayed in a restricted manner, and the position and the form (shape, size, color, etc.) of a UI component on the screen are modified and displayed.

The operation screen user interface 3 displays an operation screen for the target device 2 and receives input by a user operation on the operation screen. The operation screen user interface 3 may be implemented by, for example, a controller including a touch panel display, an operation button, and a display unit. Furthermore, the operation screen user interface 3 may be implemented by a display device such as a display that cooperates with an operation input device such as a mouse.

In addition, the output interface 312 in the present modification outputs the operation command D32 (operation screen) output from the learning model unit 300 to the operation screen user interface 3.

Furthermore, in the present modification, the learning model unit 300 may have a function of interactively checking an operation expected by the user 1. In such a case, for example, when receiving information requesting reacquisition of the operation command D32 after presenting the operation screen as the operation command D32, the learning model unit 300 may modify a part of the input information, some of model parameters, or a reference destination of reference information, and then reacquire the operation command D32.

As described above, in the present modification, since the operation screen on which the treatment (configuring the screen API, modifying the display mode, or the like) has been applied such that a desired operation can be easily or intelligibly performed can be generated using the learning model unit 300, it is possible to further improve the efficiency of work related to the operation of the target device 2. In addition, according to the present modification, since the user 1 can perform an actual operation while checking the description of the operation command generated by the learning model unit 300 and the like, the operation can be performed without a mistake.

### Modification 3-4

Next, another modification of the control system 3000 will be described. In the present modification, a learning model further uses environmental information to generate an operation command.

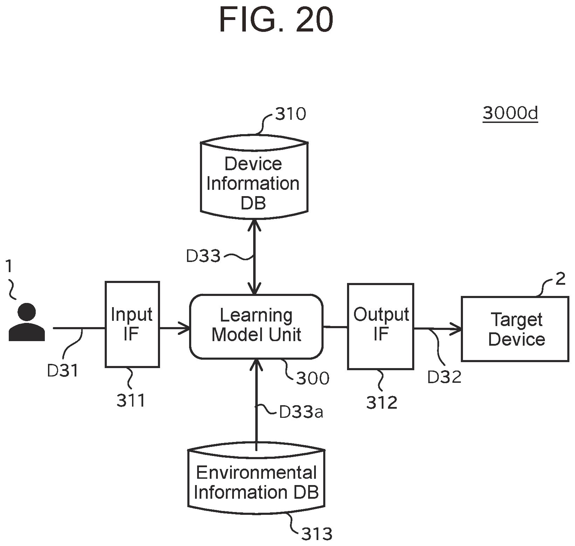

FIG. 20 is a configuration diagram illustrating an example of a control system 3000d as a modification of the control system 3000 according to the present embodiment. Note that the same elements as those of the control system 3000 are denoted by the same reference numerals, and description thereof is omitted.

The control system 3000d illustrated in FIG. 20 further includes an environmental information storing unit 313(referred to as environmental information DB in the drawing).

The environmental information storing unit 313 stores environmental information D33a that is information of the environment of an operation destination of the target device 2. The environmental information D33a may include information of a space in which the target device 2 operates. In the present modification, information of an object or a person present in the space in which the target device 2 operates and the user 1 who is an operator of the target device 2 are also a part of the environment. Therefore, the environmental information D33a may include information regarding the object, the person, or the user 1.

The environmental information D33a may include, for example, information such as an attribute, the temperature, the position, the posture, and the heartbeat of a person as information regarding the person. Furthermore, the environmental information D33a may include, for example, information such as the location, the temperature, the humidity, and the brightness of the space as information regarding the space. Furthermore, in a case where such information regarding the space or the person changes, the environmental information D33a may hold information indicating the transition. The information indicating the transition is also referred to as time series data or history information. The environmental information D33a may be a part of the model reference information D104 of the learning model, for example.

The environmental information D33a may be acquired by, for example, a sensor (not illustrated) or the like.

For example, the learning model unit 300 is a model and an operation environment thereof, the model configured to generate and output the operation command D32 on the basis of the input information D31, device information D33, the environmental information D33a, and other information that can be referred to in the learning model unit 300 when the input information D31 is input.

As described above, according to the present modification, since the learning model can generate the operation command D32 using the environmental information D33a related to the space in which the target device 2 operates, it is possible to further enhance the functionality of the work related to the operation of the target device 2.

### Modification 3-5

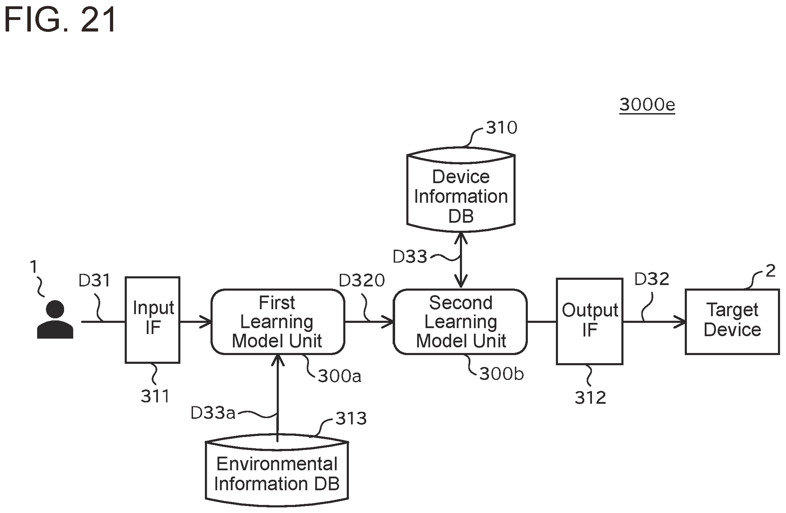

Next, another modification of the control system 3000 will be described. In the present modification, an operation command is generated by combining two learning models. FIG. 21 is a configuration diagram illustrating an example of a control system 3000e as a modification of the control system 3000 according to the present embodiment. Note that the same elements as those of the control system 3000 are denoted by the same reference numerals, and description thereof is omitted.

In the control system 3000e illustrated in FIG. 21, a learning model unit 300a as a first learning model unit 300 and a learning model unit 300b as a second learning model unit 300 are included instead of the learning model unit 300 illustrated in FIG. 20.

When input information D31 is input, the learning model unit 300a outputs operation information D320. The learning model unit 300a may be a model and an operation environment thereof, the model configured to generate and output the operation information D320 on the basis of at least the input information D31 and environmental information D33a when the input information D31 is input.

The operation information D320 includes information regarding the operation of the target device 2 indicated in a predetermined format discriminable by the learning model unit 330b in the subsequent stage. The operation information D320 may be information obtained by supplementing (including addition, correction, and cancellation of) the operation content indicated by the input information D31 depending on the environmental information D33a. The operation information D320 may be information in which the operation content indicated by the input information D31 or the expression thereof is modified depending on the situation of the space in which the target device 2 is driven. The learning model unit 300a may be a model that performs grounding mainly for the input information D31.

For example, even if the desired operation is the same, it is conceivable that a difference occurs in the linguistic representation or a difference occurs in the way of recognizing an event depending on the environment in which the target device 2 is driven. For example, the operation content indicated by the input information D31 may be different depending on a dialect or a habit of wording, use of an in-house term or a word used in a family, a difference in perception such as heat or cold, or the like.

The learning model unit 300a serves to absorb, for example, such differences in the linguistic representation and/or differences in recognition of events and to correct them to more generalized or concrete content. The learning model unit 300a may be a local learning model that obtains an output result on the basis of local information such as by limiting the database to be referred to.

The operation information D320 generated by the learning model unit 300a is input to the learning model unit 300b.

The learning model unit 300b may be basically similar to the learning model unit 300 described above. However, instead of the input information D31, the operation information D320 generated by the learning model unit 300a is input.

When the operation information D320 is input, the learning model unit 300b outputs an operation command D32. The learning model unit 300b may be a model and an operation environment thereof, the model configured to generate and output the operation command D32 on the basis of the operation information D320, device information D33, and information that can be referred to in the learning model unit 300b when the operation information D320 is input. The learning model unit 300b may be a global learning model that obtains an output result on the basis of global information such as by enabling free access to an external network.

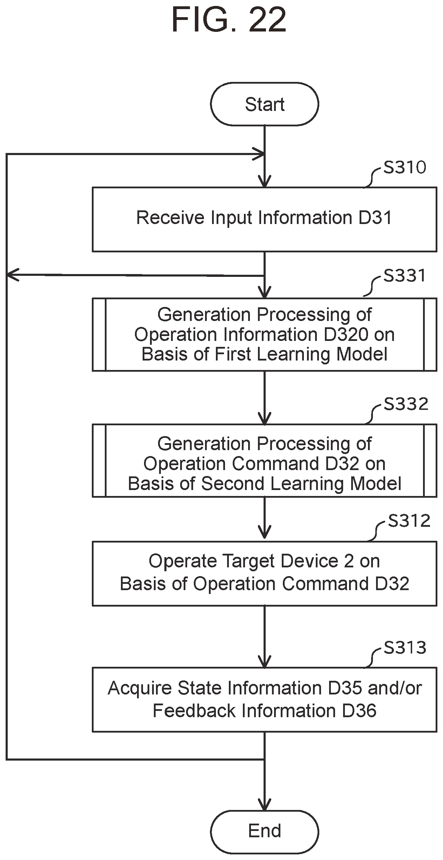

FIG. 22 is a flowchart illustrating an operation example of the present modification. In the example illustrated in FIG. 22, when the input interface 311 of the control system 3000e receives the input information D31 in step S310, the input information D31 is input to the learning model unit 300a.

Next, the control system 3000e performs generation processing of the operation information D320 using the learning model unit 300a (step S331). In step S331, the learning model unit 300a (more specifically, the model control unit 101) generates and outputs the operation information D320 corresponding to the input information D31 on the basis of the model information D102 and the input information D31 having been input and the model reference information D104 including the environmental information D33a as necessary. The operation information D320 output from the learning model unit 300a is input to the learning model unit 300b.

Next, the control system 3000e performs generation processing of the operation command D32 using the learning model unit 300b (step S332). In step S332, the learning model unit 300b (more specifically, the model control unit 101) generates and outputs the operation command D32 corresponding to the operation information D320 on the basis of the model reference information D104 including the model information D102 and the operation information D320 having been input, as well as the device information D33 as necessary.

The subsequent processing may be similar to that of the other control systems of the present embodiment.

As described above, according to the present modification, the operation command D32 can be generated after the input information D31 input from the user 1 is modified to more generalized or concrete content by absorbing the difference in the linguistic representation and/or the difference in recognition of events, and thus it is possible to further enhance the functionality of work related to the operation of the target device 2.

Note that, also in the configuration illustrated in Modification 3-4, the learning model unit 300 can generate the operation command D32 in which differences in the linguistic representation and/or differences in recognition of events are averaged out on the basis of the environmental information D33a, the device information D33, the model reference information D104 including the past operation history, and the like. However, according to the present modification, since the role of the learning model can be clearly divided into absorption of a difference in expression and conversion into an operation command, the learning models can be made to learn in a specialized manner, whereby a compact design such as suppression of the scale of learning can be implemented.

### Fourth Embodiment.

Next, a fourth embodiment will be described. In the present embodiment, an example of assisting work related to monitoring of a certain work situation using a learning model will be described.

For example, it is assumed that an abnormality of a factory automation (FA) system including a control device of a robot, a PLC, or the like is monitored in a factory. For example, in a case where there is a clear installation error in target work of a control device, an existing monitoring algorithm on a rule basis or the like can cope with the installation error. However, a case where an abnormality is found in a later step triggered by a slight installation error is conceivable. In such a case, for example, even if analysis or the like is performed using abnormality detection as a trigger, it is difficult to accurately grasp the situation and acquire an improvement method.

In this embodiment, efficiency and performance of the monitoring work are enhanced by assisting such work related to monitoring of the work environment where there may be a case where the occurrence situation does not match the existing rules and it is difficult to investigate the cause, such as a case where a relatively small defect grows into a large abnormality.

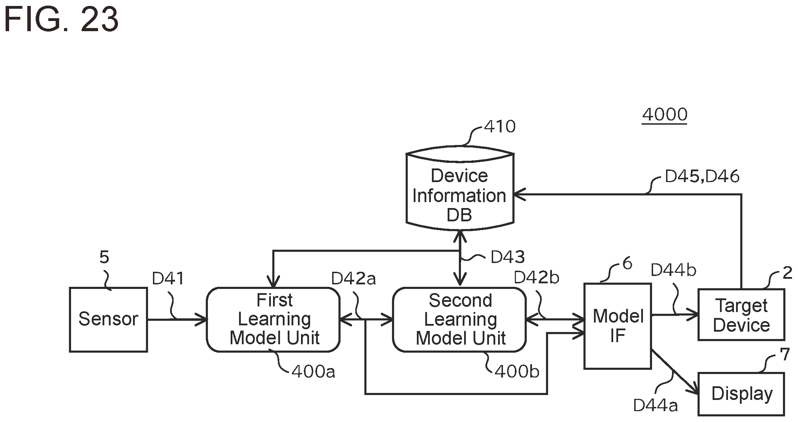

FIG. 23 is a configuration diagram illustrating an example of a control system 4000 according to the fourth embodiment. The control system 4000 illustrated in FIG. 23 is a control system for monitoring a specific work situation using a learning model, and includes a sensor 5, a learning model unit 400a, a learning model unit 400b, a device information storing unit 410 (referred to as device information DB in the drawing), a model interface 6 (referred to as model IF in the drawing), and a display 7.

The sensor 5 acquires data indicating the situation of work to be monitored. Hereinafter, data acquired by the sensor 5 is referred to as sensor data. The sensor data may be, for example, image data obtained by capturing the state of work to be monitored. Alternatively, the sensor data may be, for example, audio data obtained by recording the state of work to be monitored. In addition, the sensor data may be, for example, measurement data obtained by measuring the state such as the position of a person or an object performing the work to be monitored.

It is based on the premise that acquisition of the sensor data by the sensor 5 is always performed, but may be performed on the basis of, for example, a trigger given by a person or another monitoring system. The sensor data acquired by the sensor 5 is input to the learning model unit 400a as the input information D41. Furthermore, the sensor data itself serving as the input information D41 may be given from a person or another monitoring system. In such a case, the sensor 5 can be omitted.

When the input information D41 is input, the learning model unit 400a outputs an analysis result D42a. For example, when the input information D41 is input, the learning model unit 400a outputs the analysis result D42a on the basis of the model information D102. The configuration of the learning model unit 400a may be basically similar to that of the learning model unit 100 of the first embodiment.

In the present embodiment, the learning model unit 400a is a model and an operation environment thereof, the model configured to output the analysis result D42a corresponding to the input information D41 when the input information D41 is input. Furthermore, the learning model unit 400a may be a model and an operation environment thereof, the model configured to, for example when the input information D41 is input, generate and output the analysis result D42a on the basis of the input information D41, device information D43, and other information that can be referred to in the learning model unit 400a (such as the model reference information D104). The learning model unit 400a may refer to and use information regarding the work to be monitored as the model reference information D104. The information regarding the work to be monitored may be, for example, information indicating the position, a person, an object, a procedure, the condition, and the like for performing the work. For example, the learning model unit 400a may use, as the model reference information D104, data of a manual in which conditions, the installation environment, operation procedures, and the like of a device used for the work are described.

In the present embodiment, the input information D41 includes information indicating the situation of work to be monitored. Note that the work to be monitored includes one or more types of work performed by a person or a device. The input information D41 may be, for example, a measurement value, an image, or audio indicating the situation of the work to be monitored, or a combination thereof. The input information D41 may be, for example, a measurement value, an image, or audio indicating the situations of a plurality of types of work to be monitored, or a combination thereof. Furthermore, the input information D41 may include information indicating the situation of work temporally continuously, and in this case, may be time-series data having a predetermined data structure including a measurement value, an image, audio, or a combination thereof indicating the situation as described above. It is based on the premise that the work situation is indicated in a manner that matches an input format of the model used by the learning model unit 400a; however, this is not the case when error processing, correction processing, or conversion processing is included in the preceding stage of the learning model unit 400a.

The analysis result D42a includes information indicating a situation analysis result obtained by analyzing the work situation indicated by the input information D41. The information indicating the situation analysis result may be information indicating an object (environment) present and/or an event occurring in the work situation indicated by the input information D41. The information indicating the situation analysis result can be regarded as information indicating the interpretation of the work situation indicated by the input information D41. The analysis result D42a may be, for example, text indicating the interpretation of the work situation indicated by the input information D41. Furthermore, the analysis result D42a may be, for example, text that focuses on a portion different from the situation at the normal time in the work situation indicated by the input information D41 and indicates interpretation of that portion. Note that the format of the analysis result D42a may be other than text. The format of the analysis result D42a is not particularly limited as long as it is described in a predetermined format that can be discriminated by the learning model unit 400b in the subsequent stage, and may be, for example, text, an image, audio, or a combination thereof.

Examples of interpretation of the work situation include expressing an object present in the work situation by using its attribute, expressing an event occurring in the work situation in predetermined constructions form such as 5W1H or 7W1H, or further summarizing after obtaining such concrete expressions. Other examples include decomposing the work performed in the work situation into a plurality of viewpoints to interpret and to express for each of the viewpoints and, in a case where the work performed in the work situation includes a plurality of subdivided works or steps, decomposing the target work into subdivided work units or step units and giving description for each subdivided work or step. It can be said that the analysis result D42a is obtained by further adding expression in a predetermined format to the work situation indicated by the input information D11 that has been embodied, subdivided, and/or undergone singularity extraction. As described above, in the analysis result D42a, the work situation is easily understood and expressed in an organized state.

When the analysis result D42a is input, the learning model unit 400b outputs an analysis result D42b. For example, when the analysis result D42a is input, the learning model unit 400b outputs the analysis result D42b on the basis of the model information D102. The configuration of the learning model unit 400b may be basically similar to that of the learning model unit 100 of the first embodiment.

In the present embodiment, the learning model unit 400b is a model and an operation environment thereof, the model configured to output the analysis result D42b corresponding to the analysis result D42a when the analysis result D42a is input. Furthermore, for example, the learning model unit 400b may be a model and an operation environment thereof, the model configured to generate and output the analysis result D42b on the basis of the analysis result D42a, the device information D43, and/or information that can be referred to in the learning model unit 400b (model reference information D104 or the like) when the analysis result D42a is input.

The analysis result D42b includes information indicating an improvement method for the work situation that is derived from the analysis result of the work situation by the learning model unit 400a. The information indicating the improvement method of the work situation may be information indicating a recovery method for recovering an abnormal state to a normal state, or may be information indicating a method for solving the problem in a case where some problem is occurring in an environment (work environment) in which the work to be monitored is being performed, such as a case where a person is in trouble or a case where a device has stopped.

The information indicating the improvement method may be, for example, text, an image, or audio indicating the method, or may be a control command (for example, an instruction, a control signal, a control code, and the like) for a device (target device 2) to which the method is to be implemented, a procedure manual describing the method, a sequence diagram, a source code, an execution code, or a controller command for causing a controller to execute the method. The information indicating the improvement method may be text, an image, audio, data written in a predetermined design language, control description (including source codes and information written in a predetermined programming platform language) indicating the method, information written in other platform languages, a control command (including a control instruction, a control signal, a control code, and a controller command), an execution code, or a combination of two or more elements thereof. Examples of the predetermined design language include but are not limited to, Unified Modeling Language (UML).

Hereinafter, the learning model unit 400a may be referred to as first learning model unit 400, and the analysis result D42a may be referred to as first analysis result D42. In addition, the learning model unit 400b may be referred to as second learning model unit 400, and the analysis result D42b may be referred to as second analysis result D42.

As described above, the analysis result D42a includes information indicating the situation analysis result of the work situation indicated by the input information D41. Therefore, the learning model unit 400b may be a model and an operation environment thereof, the model configured to output the analysis result D42b corresponding to the situation analysis result indicated by the analysis result D42a. In a case where the information indicating the situation analysis result is text explaining the work situation indicated by the input information D41, the learning model unit 400b may be a model configured to output the analysis result D42b corresponding to the text explaining the work situation and an operation environment thereof.

Handling of the device information storing unit 410 and the device information D43 is basically similar to that of the device information storing unit 110 and the device information D13 of the first embodiment. Note that in the present embodiment, the device information storing unit 410 stores the device information D43 that is information of a device related to the work to be monitored as the target device 2. Here, the devices related to work widely include devices required for deriving the situation analysis and the improvement method described above. More specifically, not only a device used for the work but also a person who performs the work or a device that may affect the device are included. The device that affects the person or the device performing the work may more specifically be a device that causes a change directly or indirectly to the person or the device performing the work. Examples thereof include a device directly used for the work (including various machines such as a working machine and a conveyance machine, and tools such as a work table and hand tools), a device that controls a device directly used for the work (power supply, relay, switch, controller, etc.), and a device that brings about a change in the work environment (lighting equipment, air conditioning equipment, vacuum cleaner, purifier, etc.).

The device information D43 is used, for example, as additional information when the learning model unit 400a and/or the learning model unit 400b outputs the model output data D103 (analysis result D42a and analysis result D42b). Hereinafter, in the present embodiment, in particular, information indicating the state of the target device 2 may be referred to as state information D45.

In the present embodiment, the learning model unit 400a may be an image learning model such as a VLM that receives input of an image and outputs a result, and the operation environment thereof. Furthermore, the learning model unit 400a may be, for example, a multimodal model that receives input in natural language and an image and obtains an output result, and the operation environment thereof. Furthermore, the learning model unit 400b may be, for example, a language learning model such as LLM that receives input in natural language and obtains an output result, and the operation environment thereof. In this case, the input information D41 may be input in text data, image data, a combination of text data and image data, or a data format (such as audio data or a moving image which is a combination of audio data and image data) that can be converted into the text data, image data, or a combination of text data and image data. Note that the learning model used in the present embodiment is not limited to the above-described model.

The model interface 6 is an interface that outputs model output data (analysis result D42a and analysis result D42b) to a predetermined output destination when the model output data is received from the learning model unit 400a and the learning model unit 400b. The model interface 6 may, for example, convert model output data output from the learning model unit 400a and the learning model unit 400b into data supported by a predetermined output destination and output the data. The model interface 6 may be provided, for example, as an example of the output unit 103 described above. In the present exemplary embodiment, the target device 2 and the display 7 are included as output destinations of the model interface 6.

For example, the model interface 6 may output result information D44a indicating the situation analysis result included in the analysis result D42a and the improvement method included in the analysis result D42b to the display 7, and output result information D44b indicating the improvement method included in the analysis result D42b to the target device 2. At this point, the model interface 6 may extract some data from the analysis result D42a and/or the analysis result D42b, convert the data into a data format matching the output destination, and output the data as the result information D44a and the result information D44b.

In the example illustrated in FIG. 23, the target device 2 and the display 7 are illustrated as the output destinations of the model interface 6; however, the output destinations of the model output data are not limited to the above. For example, in a case where information indicating the control on the target device 2 is included in the improvement method for the situation indicated by the model output data to be output, the model interface 6 can, for example, output the model output data or information indicating the method to a conversion device (not illustrated) that converts the model output data or the information into information that can be received by the target device 2, in addition to directly outputting the model output data or the information indicating the method to the target device 2 as the implementation destination of the method. The conversion device may be, for example, the control system 1000 of the first embodiment that converts input information into a control description or an execution code that can be discriminated by the target device 2.

In addition, the model interface 6 itself may have the function of the conversion device. For example, the model interface 6 may have a function of not only controlling the output of the model output data but also converting the improvement method output by the learning model unit 400b into a code executable by an interpreter and outputting the converted code or controlling a device on the basis of the converted code. In addition, the model interface 6 may have a function of controlling a processing flow such as immediately executing the processing in a case where the improvement method includes processing with a high degree of urgency. In addition, the model interface 6 may have a function of transmitting a prompt input through the display of the display 7, such as a response to a proposal of the method displayed on the display 7, to the learning model unit 400b.

In addition, the model interface 6 may have the functions of the output check unit 202 and the correction check unit 203 described above. For example, the model interface 6 may determine the urgency of the analyzed situation, and in a case where it is determined that there is no urgency, the model interface 6 may check the appropriateness of the improvement method by an inquiry to an observer or by a simulator, and if the improvement method is not appropriate, transmit the fact to the learning model unit 400b to urge to output the improvement method again. At this point, the model interface 6 may issue supplementary information D48 to the model input data of the target learning model unit 400b.

In the present embodiment, the input information D41 corresponds to the model input data D101 of the learning model unit 400a. In addition, the analysis result D42a corresponds to the model output data D103 of the learning model unit 400a. In addition, the analysis result D42a corresponds to the model input data D101 of the learning model unit 400b. In addition, the analysis result D42b corresponds to the model output data D103 of the learning model unit 400b. For example, the learning model unit 400a (in particular, the model control unit 101) may be configured to output the analysis result D42a corresponding to the input information D41 on the basis of the model information D102 and the model reference information D104 as necessary when receiving the input information D41. For example, the learning model unit 400b (in particular, the model control unit 101) may be configured to output the analysis result D42b corresponding to the analysis result D42a on the basis of the model information D102 and the model reference information D104 as necessary when receiving the analysis result D42a.

Furthermore, in such a case, the model generating unit 107 provided corresponding to the learning model unit 400a may generate or update the model information D102 by performing machine learning using, for example, the model training data D105 including candidates for the input information D41 that can be input to the model control unit 101, or may generate or update the model information D102 by performing machine learning using the model training data D105 including candidates for the input information D41 that can be input to the model control unit 101 and candidates for the analysis result D42a corresponding thereto. Furthermore, the model generating unit 107 provided corresponding to the learning model unit 400b may generate or update the model information D102 by performing machine learning using, for example, the model training data D105 including candidates for the analysis result D42a that can be input to the model control unit 101, or may generate or update the model information D102 by performing machine learning using the model training data D105 including candidates for the analysis result D42a that can be input to the model control unit 101 and candidates for the analysis result D42b corresponding thereto.

Although not illustrated, also in the present embodiment, state information D45 and/or feedback information D46 may be acquired from the output destination of the model output data D103 of the learning model unit 400a and the learning model unit 400b and/or information generated on the basis of the model output data D103. For example, the control system 4000 may output the acquired state information D45 and/or feedback information D46 to the user 1, the learning model unit 400a, the learning model unit 400b, or another device (not illustrated) as information indicating the control result. In addition, the control system 4000 may be configured to return an inquiry D47 to the user 1 in a case where the input information D41 includes unclear or uncertain information. Furthermore, the control system 4000 can generate supplementary information D48 for the input and output data of the learning model unit 400a and the learning model unit 400b on the basis of the acquired state information D45 and/or feedback information D46, and issue the supplementary information D48 to the user 1, the learning model unit 400a, the learning model unit 400b, or another device (not illustrated). Handling of the state information D45, the feedback information D46, the inquiry D47, and the supplementary information D48 may be basically similar to that of the first embodiment. Here, the information may be output to the user 1 via, for example, the display 7 or an input and output interface included in the information processing device 10 (not illustrated).

In addition, the control system 4000 may further include a state acquisition unit 430 (not illustrated) that acquires the state information D45 and/or the feedback information D46 and issues the supplementary information D48 as necessary. The state acquisition unit 430 is similar to the state acquisition unit 130 of the first embodiment.

Also in the present embodiment, the target device 2 is not particularly limited. Although it is based on the premise that the target device 2 is a device that can actually be controlled by receiving an analysis result D42b, it is not limited thereto in a case where the aforementioned conversion device is included between the learning model unit 400b and the target device 2.

In the present embodiment, the input information D41 received by the control system 4000 can be referred to as information regarding the situation (in this example, the situation in the environment in which the monitoring work is performed) in the work environment. Therefore, the input information D41 received by the control system 4000 can be regarded as an example of first information indicating the situation in the work environment. In addition, the analysis result D42a and the analysis result D42b can be regarded as information used for the work (monitoring work) corresponding to such input information D41. Hereinafter, the analysis result D42a and/or the analysis result D42b output to a predetermined output destination from the operation environment of the learning model to which model input data based on the input information D41 is input may be referred to as second information.

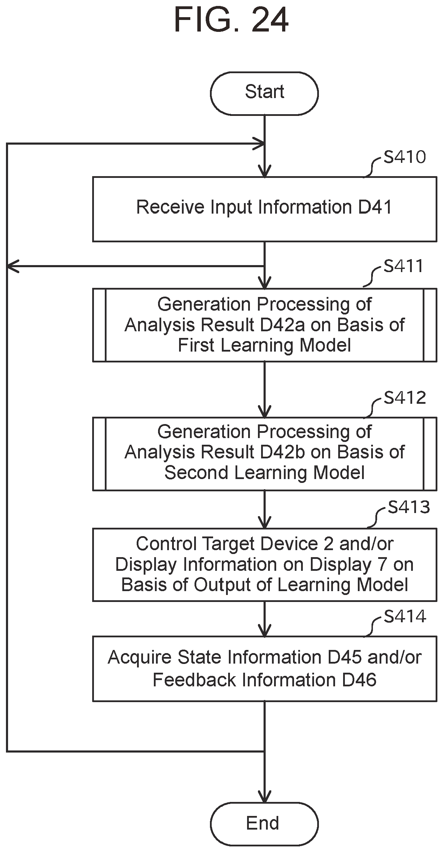

Next, an operation of the control system 4000 of the present embodiment will be described. FIG. 24 is a flowchart illustrating an operation example of the control system 4000.

In the example illustrated in FIG. 24, first, the control system 4000 receives the input information D41 (step S410). For example, the input unit 102 or the input processing unit 201 described above may receive the input information D41. The received input information D41 is input to the learning model unit 400a as the model input data D101.

Next, the control system 4000 performs generation processing of the analysis result D42a using the learning model unit 400a (step S411). In step S411, the learning model unit 400a (more specifically, the model control unit 101) outputs the analysis result D42a corresponding to the input information D41 on the basis of the model reference information D104 including the model information D102 and the input information D41 having been input, as well as the device information D43 as necessary. For example, the learning model unit 400a may generate the analysis result D42a of text data from the input information D41 having been input by using a learning model capable of generating text data.

In step S411, the preprocessing unit 105 and/or the post-processing unit 106 of the learning model unit 400a may further perform the above-described processing.

The analysis result D42a output from the learning model unit 400a is input to the learning model unit 400b. In addition, the analysis result D42a output from the learning model unit 400a is input to the learning model unit 400b and the model interface 6. The analysis result D42a output from the learning model unit 400a may be input to the model interface 6 via the learning model unit 400b. In this case, the learning model unit 400b may output the model output data D103 including the analysis result D42a and the analysis result D42b.

Next, the control system 4000 performs generation processing of the analysis result D42b using the learning model unit 400b (step S412). In step S412, the learning model unit 400b (more specifically, the model control unit 101) outputs the analysis result D42b corresponding to the analysis result D42a on the basis of the model reference information D104 including the model information D102 and the analysis result D42a having been input, as well as the device information D43 as necessary. The learning model unit 400b may generate the analysis result D42b of binary data from the input analysis result D42a using, for example, a learning model capable of generating text data. Furthermore, the learning model unit 400b may generate the analysis result D42b of text data and binary data from the input analysis result D42a using, for example, a learning model capable of generating text data and binary data.

In step S412, the preprocessing unit 105 and/or the post-processing unit 106 of the learning model unit 400b may further perform the above-described processing.

The analysis result D42b output from the learning model unit 400b is input to, for example, the model interface 6.

The model interface 6 controls the target device 2 and/or causes the display 7 to display information on the basis of the analysis results by the learning model unit 400a and the learning model unit 400b (step S413). In step S413, for example, the model interface 6 outputs information based on the analysis result D42a and the analysis result D42b to a predetermined output destination. For example, based on the analysis result D42a and the analysis result D42b, the model interface 6 outputs the result information D44a indicating the situation analysis result and the improvement method to the display 7, and outputs the result information D44b indicating the improvement method based on the analysis result D42b to the target device 2.

The result information D44a may indicate the situation occurring in the work environment and an improvement method by, for example, a character and audio. Furthermore, the result information D44b may indicate the improvement method by, for example, characters or a control signal.

As a result, the display 7 displays the situation analysis result indicated by the analysis result D42a and the improvement method indicated by the analysis result D42b on the basis of the result information D44a, and the target device 2 performs the improvement method indicated by the analysis result D42b on the basis of the result information D44b. Information input to the display 7 and the target device 2 may be directly performed from the control system 4000 (more specifically, the model interface 6), or may be indirectly input via a communication network, another device (server, various conversion devices, and the like), or manually.

The control system 4000 may acquire the state information D45 and the feedback information D46 in a case where there is a change in the state of the target device 2 such as due to control of the target device 2 and there is feedback from the output destination (step S414). Note that the processing in step S414 is not essential and may be omitted as appropriate.

The control system 4000 may repeat the processing of steps S410 to S414 a plurality of times (for example, until a desired state is obtained in a target work environment).

As described above, according to the present embodiment, since the grasping of the situation and the acquisition of the improvement method are performed in two stages using different learning models, the accuracy of the final product can be improved, and as a result, the efficiency of work related to the monitoring of the work situation can be improved.

For example, in a scene where the situation is grasped, it is important to widely detect an abnormal state in the work environment such as "something abnormal has occurred ". On the other hand, in a scene of acquiring an improvement method, specific information such as "Stop this machine, move the position of the workpiece to point A, bring the state of the machine back to state B, and then restart the machine." is important.

In such a case where information to be extracted, namely, the degree of abstraction of target information is different, trying to learn and to extract information at once with one learning model raises concern that the accuracy of the output result may be degraded. In particular, in acquisition of an improvement method, it is required to present a specific method on the basis of knowledge and information of the work environment. In such a case, it is possible to more reliably improve the output accuracy by separating the learning model and giving appropriate domain knowledge (environmental information).

In addition, in a case where a solution for different tasks of grasping the situation and acquiring an improvement method is to be obtained by one learning model, it is conceivable that the problem of hallucination becomes noticeable. This is because there is a possibility that the function of adjusting the solution of another task (grasping the situation) such that the solution of one task (acquiring the improvement method) looks plausible implicitly works in the model algorithm. The present embodiment also works on such a hallucination problem. That is, by dividing the learning model in correspondence with two tasks of grasping the situation and acquiring the improvement method, it is possible to suppress the modal for entering each learning model, and as a result, it is possible to suppress the magnitude of the hallucination, and thus it is possible to improve the accuracy of the final product.

Furthermore, in the present embodiment, since the analysis result D42a and the analysis result D42b, which are output results of the learning model unit 400a and the learning model unit 400b, can be expressed in words and displayed on the display 7, it is possible to suppress hallucination and to implement a method for more reliably improving the situation by a person checking the content thereof.

Note that the control system 4000 of the present embodiment can be used for, for example, monitoring of logistics targets in a logistics system in addition to the above-described monitoring of a control system of a device in a factory.

### Modification 4-1

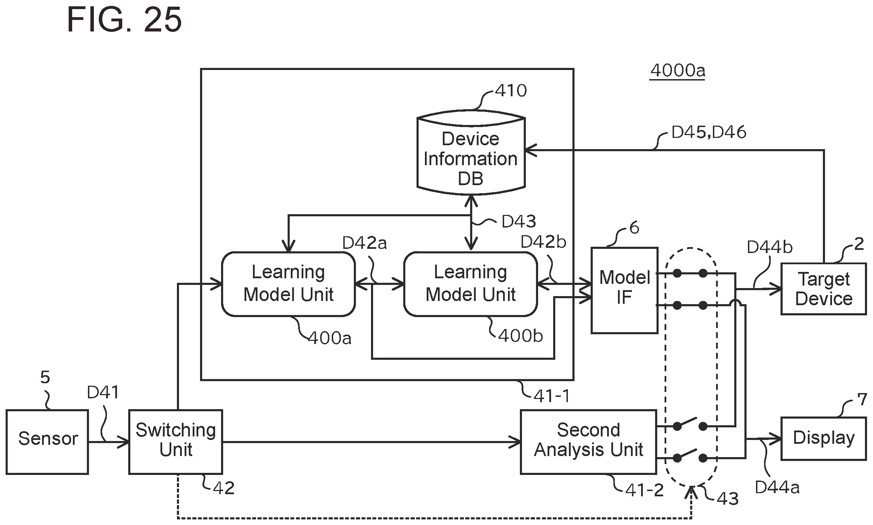

Next, a modification of the control system 4000 will be described. FIG. 25 is a configuration diagram illustrating an example of a control system 4000a as a modification of the control system 4000 according to the present embodiment. Note that the same elements as those of the control system 4000 are denoted by the same reference numerals, and description thereof is omitted.

The control system 4000a illustrated in FIG. 25 is different from the control system 4000 in that two analysis means for analyzing and improving the situation by different methods are provided, and the analysis means used as appropriate is switched depending on the generated situation.

The control system 4000a illustrated in FIG. 25 includes, as a first analysis unit 41-1, a portion for analyzing the situation and acquiring an improvement method using the learning model unit 400a and the learning model unit 400b described above, and further includes a second analysis unit 41-2, a switching unit 42, and an output changeover switch 43.

The second analysis unit 41-2 is not particularly limited as long as it is a means that analyzes the situation and acquires an improvement method from input information D41 by a method different from that of the first analysis unit 41-1. As an example, the second analysis unit 41-2 may be a means for analyzing the situation and acquiring an improvement method on a rule basis. For example, when the input information D41 is input, the second analysis unit 41-2 may determine whether or not the input information D41 matches a predetermined abnormality pattern, and in a case where the input information D41 matches any abnormality pattern, the second analysis unit 41-2 may acquire an improvement method corresponding to the abnormality pattern. The second analysis unit 41-2 outputs an analysis result D42c including at least an improvement method for the situation.

The analysis result D42c may include, for example, information corresponding to the above-described result information D44a and information corresponding to result information D44b. In the present modification, the analysis result D42c includes at least the result information D44b indicating the improvement method obtained by the second analysis unit 41-2.

In the present modification, the second analysis unit 41-2 may be implemented as an internal execution module, for example, by being mounted on a PLC, an information processing device, or the like installed in the work environment.

The switching unit 42 is a means for switching the control destination for the input information D41 depending on a predetermined condition. In the present modification, the switching unit 42 switches the control destination for the input information D41 between the first analysis unit 41-1 and the second analysis unit 41-2. For example, the switching unit 42 may switch the control destination for the input information D41 depending on whether or not the input information D41 satisfies an existing rule. At this point, the switching unit 42 may switch the control destination by switching the output destination of the input information D41 to the second analysis unit 41-2 in a case where the input information D41 satisfies the existing rule, and by switching the output destination of the input information D41 to the first analysis unit 41-1 in a case where the input information D41 does not satisfy the existing rule.

For example, the switching unit 42 may switch the control destination for the input information D41 in accordance with an instruction from an observer. Furthermore, the switching unit 42 may switch the control destination for the input information D41 depending on, for example, time, work content, presence or absence of an observer, or the like. Furthermore, the switching unit 42 may switch the control destination for the input information D41 depending on, for example, whether or not an abnormality is occurring in the work environment. Here, the presence or absence of an abnormality in the work environment may be determined, for example, by whether or not an abnormality signal has been generated. For example, at the time of abnormality, the switching unit 42 may switch the control destination for the input information D41 to the first analysis unit 41-1. Moreover, the switching unit 42 may switch the control destination for the input information D41, for example, depending on the severity or the degree of urgency of the abnormality occurring in the work environment.

In addition, the switching unit 42 may control the output changeover switch 43 that switches the connection path (circuit, communication path, or the like) connecting the output of the first analysis unit 41-1 or the output of the second analysis unit 41-2 and a pair of the target device 2 and the display 7, which are the output destinations of the analysis result, in response to the switching of the control destination for the input information D41.

For example, when the control destination for the input information D41 is switched to the first analysis unit 41-1, the switching unit 42 may control the output changeover switch 43 to turn on the connection path connecting the output of the first analysis unit 41-1 and the pair of the target device 2 and the display 7 and to turn off the connection path connecting the output of the second analysis unit 41-2 and the pair of the target device 2 and the display 7. Similarly, for example, when the control destination for the input information D41 is switched to the second analysis unit 41-2, the switching unit 42 may control the output changeover switch 43 to turn on the connection path connecting the output of the second analysis unit 41-2 and the pair of the target device 2 and the display 7 and to turn off the connection path connecting the output of the first analysis unit 41-1 and the pair of the target device 2 and the display 7.

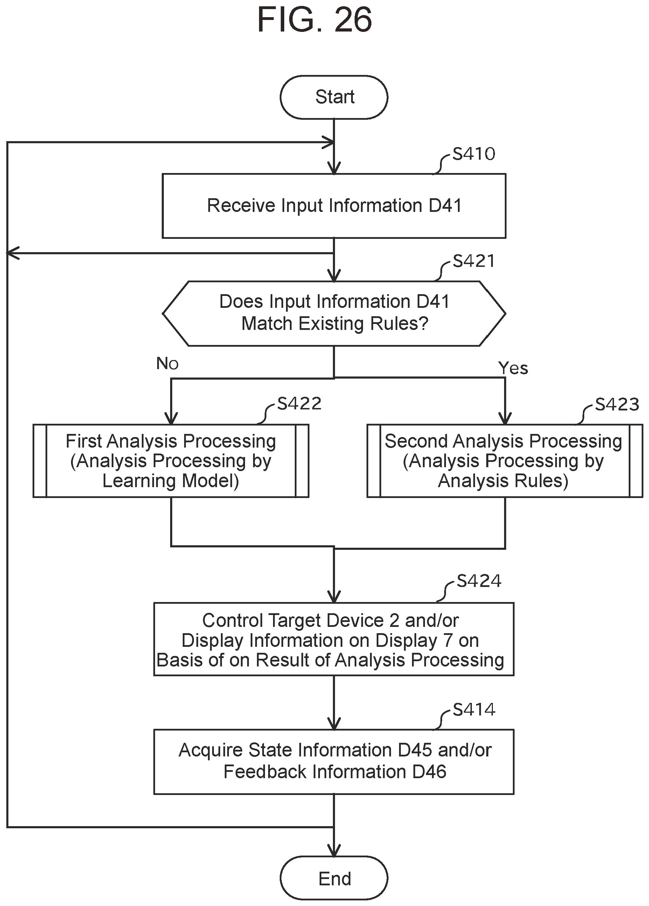

FIG. 26 is a flowchart illustrating an operation example of the present modification. In the example illustrated in FIG. 26, when the control system 4000a receives the input information D41 in step S410, the switching unit 42 switches the control destination for the input information D41 depending on a predetermined condition (step S421). In the example illustrated in FIG. 26, the switching unit 42 determines whether or not the input information D41 satisfies the existing rule, and if it is determined that the input information D41 does not satisfy the existing rule (No in step S421), the process proceeds to first analysis processing (step S422). On the other hand, it is determined that the input information D41 satisfies the existing rule (Yes in step S421), the process proceeds to second analysis processing (step S423).

In the first analysis processing in step S422, the learning model unit 400a and the learning model unit 400b as the first analysis unit 41-1 analyze the situation and acquire an improvement method. The learning model unit 400a and the learning model unit 400b output the analysis result D42a including an analysis result of the situation and the analysis result D42b including the improvement method for the situation as results of the first analysis processing.

In the second analysis processing of step S423, the second analysis unit 41-2 analyzes the situation and acquires the improvement method in accordance with the existing rule. For example, the second analysis unit 41-2 outputs the analysis result D42c including at least the improvement method for the situation as a result of the first analysis processing.

When the result of the analysis processing by the first analysis unit 41-1 or the second analysis unit 41-2 is output, the target device 2 is controlled and/or the display 7 is caused to display information on the basis of the result of either analysis processing depending on the state of the output changeover switch 43 (step S424).

In this example, in a situation where the first analysis unit 41-1 performs analysis processing, the connection path that connects the output of the first analysis unit 41-1 and the pair of the target device 2 and the display 7 is turned on. In this case, based on the analysis result D42a and the analysis result D42b, the model interface 6 may output the result information D44a indicating the situation analysis result and the improvement method to the display 7, and output the result information D44b indicating the improvement method based on the analysis result D42b to the target device 2. On the other hand, in a situation where the second analysis unit 41-2 performs analysis processing, the connection path connecting the output of the second analysis unit 41-2 and the pair of the target device 2 and the display 7 is turned on. In that case, on the basis of the analysis result D42c output from the second analysis unit 41-2, the result information D44a indicating the situation analysis result and the improvement method may be output to the display 7, and/or the result information D44b indicating the improvement method may be output to the target device 2.

The display 7 may display the result information D44b in a form that can be checked by the worker, for example. In this case, the worker may refer to the result information D44b displayed on the display 7, check the improvement method indicated by the result information D44b, and perform work according to the method. In addition, the worker may check the improvement method indicated by the result information D44b and determine the appropriateness thereof. At this point, in a case where the improvement method indicated by the result information D44b is inappropriate, the worker may prompt the learning model unit 400b to acquire another improvement method (reacquire model output data). For example, when receiving information requesting reacquisition of the model output data, the learning model unit 400b may change a part of the input information, some of model parameters, or a reference destination of reference information, and then reacquire the model output data.

The subsequent processing may be similar to that of the other control systems of the present embodiment.

As described above, the present modification includes a plurality of analysis units that analyze the situation and acquire the improvement method by different methods and is configured to switch between the analysis units depending on the situation. Therefore, it is possible to perform control more suitable for the situation. For example, it is made possible that, for a problem whose cause is clear, the second analysis unit with a high processing load immediately analyzes the situation and presents and executes an improvement method, whereas for a problem whose cause is not clear, the first analysis unit using a learning model analyzes a complicated situation and presents and executes a better improvement method.

Note that, in the example described above, an example has been described in which the first analysis unit 41-1 analyzes the situation and acquires the improvement method using two learning models; however, the configuration of the first analysis unit 41-1 is not limited to the example described above. For example, in a case where analysis of the situation is unnecessary, the learning model unit 400a can be omitted. Furthermore, in a case where acquisition of an improvement method is unnecessary, the learning model unit 400b can be omitted. It is also possible to perform analysis of the situation and acquisition of the improvement method by a single learning model unit.

For example, in a case where the first analysis unit 41-1 includes the learning model unit 400b that acquires the improvement method for the situation on the basis of the input information D41, the switching unit 42 may switch the control destination for the input information D41 to the first analysis unit 41-1 at the time of abnormality. In that case, when the input information D41 is input, the learning model unit 400b of the first analysis unit 41-1 is only required to be configured to output information indicating the improvement method corresponding to the abnormality occurrence situation indicated by the input information D41. At this point, the learning model unit 400b may refer to the device information storing unit 410 accessible by the control system and output information indicating the improvement method corresponding to the situation.

### Fifth Embodiment

Next, a fifth embodiment will be described. In the present embodiment, an example will be described in which response work of returning a reaction to information provided from the user 1 in a call center, a product website, or the like is assisted using a learning model. In this example, the information sharing from the user 1 may include an inquiry or an opinion regarding a certain service, information, an event, or an object.

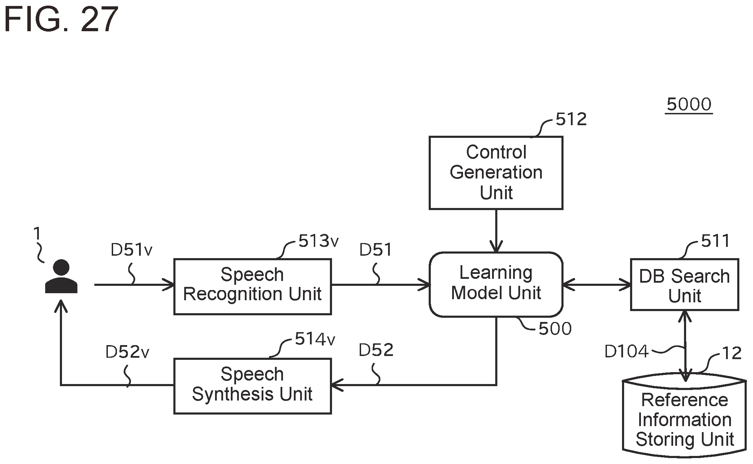

FIG. 27 is a configuration diagram illustrating an example of a control system 5000 according to the fifth embodiment. The control system 5000 illustrated in FIG. 27 includes a learning model unit 500, a reference information storing unit 12, a database search unit 511 (referred to as a DB search unit in the drawing), a control generation unit 512, a speech recognition unit 513v, and a speech synthesis unit 514v. The reference information storing unit 12, the database search unit 511, and the control generation unit 512 may be provided as a part of the learning model unit 500.

When the input information D51 is input, the learning model unit 500 outputs response information D52 indicating the response content. For example, when the input information D51 is input, the learning model unit 500 outputs the response information D52 on the basis of the model information D102. The configuration of the learning model unit 500 may be basically similar to that of the learning model unit 100 of the first embodiment.

In the present embodiment, the learning model unit 500 is a model and an operation environment thereof, the model configured to output the response information D52 corresponding to the input information D51 when the input information D51 is input. Furthermore, the learning model unit 500 may be a model and an operation environment thereof, the model configured to, when the input information D51 is input, generate and output the response information D52 on the basis of the input information D51 and other information that can be referred to in the learning model unit 500.

In the present embodiment, the input information D51 includes information indicating the content shared by the user 1 or others. The input information D51 may include information indicating content for which a reaction is required in a work environment. The input information D51 may be, for example, text, an image, or a speech indicating an inquiry or an opinion regarding a certain service, information, an event, or an object, or a combination thereof. The input information D51 may be, for example, text, an image, or a speech indicating a plurality of inquiries or opinions regarding a certain service, information, an event, or an object, or a combination thereof. Furthermore, the input information D51 may include information indicating the shared content that is temporally continuous, and in this case, may be time-series data having a predetermined data structure including text, an image, a speech, or a combination thereof indicating the shared content as described above. It is based on the premise that the shared content is indicated in a manner that matches an input format of the model used by the learning model unit 500; however, this is not the case when error processing, correction processing, or conversion processing is included in the preceding stage of the learning model unit 500.

The response information D52 includes information indicating a response to the shared content included in the input information D51. The response information D52 may be, for example, information indicating a response to an inquiry or an opinion regarding a service, information, an event, or an object indicated by the shared content included in the input information D51.

The reference information storing unit 12 stores the model reference information D104 to be referred to by the model control unit 101 of the learning model unit 500 for outputting the response information D52. The model reference information D104 includes, for example, information related to a service, information, an event, or an object that can be included in the input information D51. The reference information storing unit 12 may particularly store information regarding a specific service, information, an event, or an object as the model reference information D104. The model reference information D104 may include, for example, a response manual converted into data. Furthermore, the model reference information D104 may include, for example, input information D51 that has been input in the past or a history of shared content included therein. At this point, the reference information storing unit 12 may store, as the model reference information D104, the input information D51 input in the past or history information indicating the shared content included in the input information D51 together with information of the user 1 as an information source (for example, a user identifier, attribute information of the user 1, or others). Hereinafter, in the present embodiment, in particular, information indicating the state of the user 1 as the information source may be referred to as state information D55.

The database search unit 511 is a search engine for the reference information storing unit 12 and other databases. In response to a request from the model control unit 101 of the learning model unit 500, the database search unit 511 searches a database to which the database search unit 511 is connected in an accessible manner and outputs a search result. At this point, the database search unit 511 may have restricted number of accessible databases.

The control generation unit 512 is an interface for setting preconditions for the learning model unit 500 (in particular, the model control unit 101) to generate model output data. The control generation unit 512 may be, for example, an interface used for recognizing control target information to be controlled by the learning model unit 500 and/or setting an output tendency. The control target information is information indicating a target to be focused on in the control in the model control unit 101. For example, the model control unit 101 may be configured to generate the model output data D103 from the model input data D101 on the basis of the control target information indicated by the control generation unit 512. For example, the control generation unit 512 may cause a part of the model input data input by the user 1 to be recognized as the control target information, cause the information generated by the model control unit 101 to be recognized as the control target information, or cause information generated by the model control unit 101 and corrected by another control unit to be recognized as the control target information. The control target information and/or the tendency settings of output may be specified by the user 1, may be specified by an external processing unit, or may be specified by the control generation unit 512 in accordance with a predetermined algorithm.

In a case where input information D51v in a speech format is included in input from the user 1, the speech recognition unit 513v recognizes a speech indicated by the input information D51v, converts the speech into a format matching the data format of the learning model unit 500, and outputs the speech. For example, the speech recognition unit 513v may convert the input information D51v in the speech format into the input information D51 in a text format.

The speech synthesis unit 514v converts the content indicated by the response information D52 into a speech format and outputs the content. For example, in a case where the response information D52 as output from the learning model unit 500 includes a data format other than the speech, the speech synthesis unit 514v converts the content of the portion indicated by the response information D52 into a speech format and outputs the speech format. For example, in a case where the response information D52 has a data structure including designation of a data format, the speech synthesis unit 514v may convert a data element for which a speech format is specified in the designation into a speech format and output the data element. For example, the speech synthesis unit 514v may convert the response information D52 in the text format into the response information D52v in the speech format.

Note that, in the above-described example, an example is illustrated in which data in the speech format is used for input and output from and to the user 1; however, the data format used for input and output from and to the user 1 is not limited to the speech format. In this case, it suffices to include, instead of the speech recognition unit 513v and the speech synthesis unit 514v, a processing unit that converts the data format used for the input from the user 1 into a data format used for the input to the learning model unit 500 and a processing unit that converts the data format used for the output from the learning model unit 500 into a data format used for the input from the user 1.

Furthermore, in a case where the learning model unit 500 can accept a data format used for input from the user 1, the speech recognition unit 513v can be omitted. Furthermore, in a case where the user 1 can accept the data format used for the output from the learning model unit 500, the speech synthesis unit 514v can be omitted.

In the present embodiment, the input information D51 corresponds to the model input data D101. The response information D52 corresponds to the model output data D103. For example, the learning model unit 500 (in particular, the model control unit 101) may be configured to output the response information D52 corresponding to the input information D51 on the basis of the model information D102 and the model reference information D104 as necessary when receiving the input information D51.

Furthermore, in such a case, the model generating unit 107 provided to correspond to the learning model unit 500 may perform machine learning using, for example, the model training data D105 including candidates for the input information D51 that can be input to the model control unit 101, and generate or update the model information D102. Furthermore, the model generating unit 107 may generate or update the model information D102, for example, by performing machine learning using the model training data D105 including a candidate for the input information D51 that can be input to the model control unit 101 and a candidate for the response information D52 corresponding thereto.

Although not illustrated, also in the present embodiment, state information D55 and/or feedback information D56 may be acquired from the output destination of the model output data D103 of the learning model unit 500 and/or information generated on the basis of the model output data D103. For example, the control system 5000 may output the acquired state information D55 and/or feedback information D56 to a predetermined supervisor, the learning model unit 500, or another device (not illustrated) as information indicating a response result. In addition, the control system 5000 may be configured to return an inquiry D57 to the user 1 in a case where the input information D51 includes unclear or uncertain information. Furthermore, the control system 5000 can generate supplementary information D58 for the input and output data of the learning model unit 500 on the basis of the acquired state information D55 and/or feedback information D56, and issue the supplementary information D58 to the user 1, the predetermined supervisor, the learning model unit 500, or another device (not illustrated). Handling of the state information D55, the feedback information D56, the inquiry D57, and the supplementary information D58 may be basically similar to that of the first embodiment.

In addition, the control system 5000 may further include a state acquisition unit 530 (not illustrated) that acquires the state information D55 and/or the feedback information D56 and issues the supplementary information D58 as necessary. The state acquisition unit 530 is similar to the state acquisition unit 130 of the first embodiment.

In the present embodiment, the input information D51 received by the control system 5000 can be referred to as information regarding a request (in this example, shared content requesting a reaction of a response in an environment where a response work is performed in response to the inquiry) in the work environment. Therefore, the input information D51 received by the control system 5000 can be regarded as an example of first information indicating the request in the work environment. In addition, the response information D52 can be regarded as information used for the work (response work) corresponding to such input information D51. Hereinafter, the response information D52 output to a predetermined output destination from the operation environment of the learning model to which model input data based on the input information D51 is input may be referred to as second information.

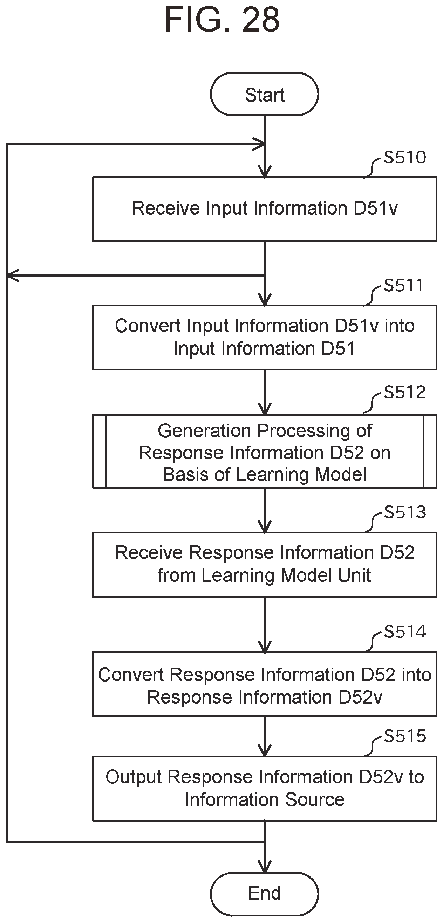

Next, the operation of the control system 5000 of the present embodiment will be described. FIG. 28 is a flowchart illustrating an operation example of the control system 5000.

In the example illustrated in FIG. 28, first, the control system 5000 receives the input information D51v (step S510). For example, the input unit 102 or the input processing unit 201 described above may receive the input information D51v. The received input information D51v is input to the speech recognition unit 513v.

Upon receiving the input information D51v, the speech recognition unit 513v recognizes speech included in the input information D51v and converts the speech into the input information D51 that matches the data format of input to the learning model unit 500 (step S511). The converted input information D51 is input to the learning model unit 500 as the model input data D101.

Note that, in a case where the speech recognition unit 513v is omitted, the received input information D51v may be input to the learning model unit 500 as the model input data D101.

Next, the control system 5000 performs generation processing of the response information D52 using the learning model unit 500 (step S512). In step S512, the learning model unit 500 (more specifically, the model control unit 101) outputs the response information D52 corresponding to the input information D51 on the basis of the model information D102 and the input information D51 having been input, and the model reference information D104 as necessary.

In step S512, the preprocessing unit 105 and/or the post-processing unit 106 of the learning model unit 500 may further perform the above-described processing.

The response information D52 output from the learning model unit 500 is input to, for example, the speech synthesis unit 514v (step S513). The input of the response information D52 to the speech synthesis unit 514v may be directly performed from the control system 5000 (more specifically, the learning model unit 500 or the information processing device 10 or the like as the operation environment thereof), or may be indirectly performed via a communication network, another device (server, various conversion devices, and the like), or manually.

Next, the speech synthesis unit 514v converts the input response information D52 into the response information D52v in a speech format and outputs the response information D52v (step S514). For example, the speech synthesis unit 514v may generate the response information D52v by synthesizing a speech uttering the response content indicated by the response information D52 in a data format other than the speech format. The response information D52v is output to the user 1 as the information source of the input information D51v (step S515).

Note that, in a case where the speech synthesis unit 514v is omitted, the response information D52 output from the learning model unit 500 may be output to the user 1 as the information source of the input information D51v.

As described above, in the present embodiment, the response information D52 can be dynamically generated using the learning model unit 500 and returned to the user 1 who is the information source without preparing an operator or a website or the like in which content to be responded to the shared information from the user 1 in advance, and thus it is possible to improve the efficiency and the performance of the response work.

### Modification 5-1

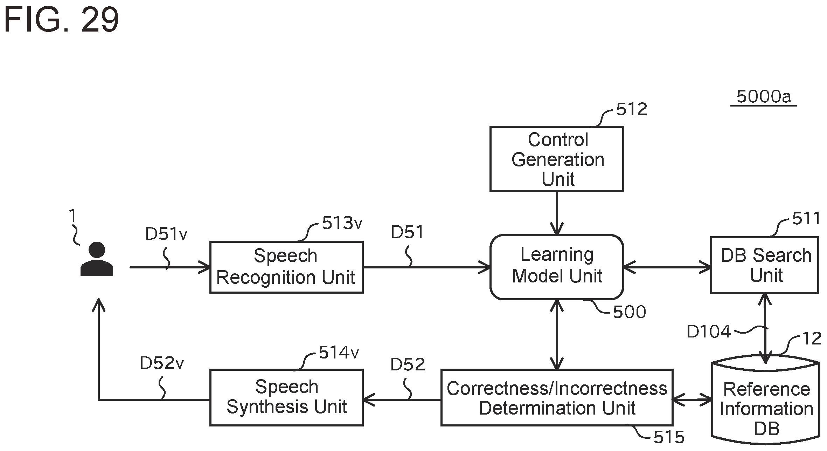

Next, a modification of the control system 5000 will be described. FIG. 29 is a configuration diagram illustrating an example of a control system 5000a as a modification of the control system 5000 according to the present embodiment. Note that the same elements as those of the control system 5000 are denoted by the same reference numerals, and description thereof is omitted.

The control system 5000a illustrated in FIG. 29 is different from the control system 5000 in that a correctness/incorrectness determination unit 515 is included.

The correctness/incorrectness determination unit 515 determines whether or not the content indicated by the response information D52 which is the output from the learning model unit 500 is correct. For example, the correctness/incorrectness determination unit 515 may be set to output the response information D52 to the user 1 or to update the content of the reference information storing unit 12 only in a case where it is determined that the content indicated by the response information D52 is correct.

In addition, for example, when determining that the content indicated by the response information D52 is not correct, the correctness/incorrectness determination unit 515 may prompt the learning model unit 500 to acquire another piece of response information D52 (reacquisition of model output data). The correctness/incorrectness determination unit 515 may be included, for example, as an example of the post-processing unit 106 described above.

Other points may be similar to those of other control systems of the present embodiment.

As described above, according to the present modification, it is determined whether or not the content indicated by the response information, which is the output from the learning model unit 500, is correct, and determination on whether to output to the user 1, reacquisition of the response information, and update of the reference information are performed on the basis of the result, and thus it is possible to further improve the performance of the response work.

### Modification 5-2

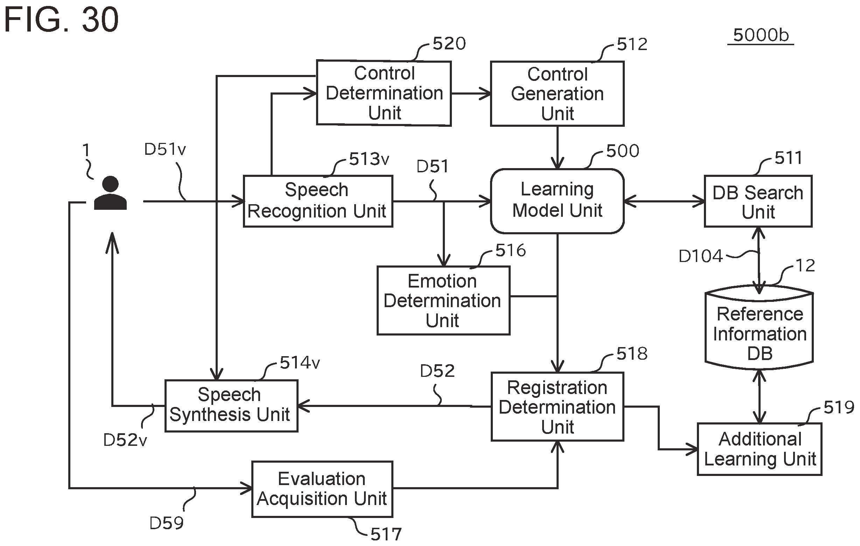

Next, a second modification of the control system 5000 will be described. FIG. 30 is a configuration diagram illustrating an example of a control system 5000b as a modification of the control system 5000 according to the present embodiment. Note that the same elements as those of the control system 5000 and the control system 5000a are denoted by the same reference numerals, and description thereof is omitted.

As illustrated in FIG. 30, the control system 5000b may further include an emotion determination unit 516.

The emotion determination unit 516 determines the emotion of the user 1 who is the information source by using input information D51 and other information. Furthermore, the emotion determination unit 516 may determine the emotion of the user 1 after response information D52 from a learning model unit 500 is output to the user 1.

The emotion of the user 1 determined by the emotion determination unit 516 may be input to the learning model unit 500 as the state information D55 included in the model reference information D104, or may be recorded as a history together with input and output data of a model in the reference information storing unit 12.

As a method of recording in the reference information storing unit 12, for example, the control system 5000b may further include a registration determination unit 518, and the registration determination unit 518 may determine whether or not to record in the reference information storing unit 12 on the basis of the determination result of the emotion of the user 1 by the emotion determination unit 516.

For example, in a case where the determined emotion of the user 1 is positive, the registration determination unit 518 may cause the reference information storing unit 12 to record input and output data of the model as history information as a good case. At this point, in a case where there is a determination result of the emotion of the user 1 before the response information D52 is output from the learning model unit 500, the registration determination unit 518 may cause the reference information storing unit 12 to record input and output data of the model including the emotion information before and after the response as the history information.

Meanwhile, for example, in a case where the determined emotion of the user 1 is negative, the registration determination unit 518 may cause the reference information storing unit 12 to record input and output data of the model as history information as a poor case. At this point, in a case where there is a determination result of the emotion of the user 1 before the response information D52 is output from the learning model unit 500, the registration determination unit 518 may cause the reference information storing unit 12 to record input and output data of the model including the emotion information before and after the response as the history information.

In addition, the control system 5000b may further include an additional learning unit 519, and when updating the content of the reference information storing unit 12, the model reference information D104 stored in the reference information storing unit 12 and other information referred to by the model control unit 101 may be reconstructed (additional learning) on the basis of update information.

Furthermore, the control system 5000b may include an evaluation acquisition unit 517 instead of the emotion determination unit 516 or in addition to the emotion determination unit 516.

The evaluation acquisition unit 517 inquires of the user 1 about evaluation of the response information D52, and acquires evaluation information D59 as a response thereto. The evaluation information D59 can be used, for example, for update of information referred to by the model, additional training, and others, similarly to the emotion of the user 1 described above.

The control system 5000b may further include a control determination unit 520.

The control determination unit 520 specifies control target information and/or specifies the tendency settings of output to the control generation unit 512 on the basis of a speech recognition result for the input information from the user 1, an emotion determination result, and/or an evaluation result of the response information D52, an instruction from an operator (not illustrated), or the like. The speech recognition result for the input information from the user 1 can include information such as an attribute, an emotion, the region, the language, presence or absence of past use, and the use frequency of the user 1. Furthermore, the control determination unit 520 may perform setting of the synthesized speech for the speech synthesis unit 514v on the basis of a speech recognition result for the input information from the user 1, an emotion determination result, and/or an evaluation result of the response information D52, an instruction from an operator (not illustrated), or the like

For example, as an example of the output tendency settings, the control determination unit 520 can specify the difficulty level of explanation in response, the way of talking (intonation, tone), the language, the level of grammar, politeness, the standing position of a speaker, conclusion of the speech, and others. The gender, the intonation, the tone, and others of the synthesized speech can be specified. Furthermore, for example, the control determination unit 520 can specify the gender, the way of talking, the language, the level of grammar, politeness, and others of the synthesized speech as an example of the settings for the synthesized speech. The control determination unit 520 may perform these settings on the basis of, for example, a predetermined settings rule.

Note that the elements of the control system 5000b illustrated in FIG. 30 can be selected as appropriate depending on a desired function.

Other points may be similar to those of other control systems of the present embodiment.

As described above, according to the present modification, since the control determination unit 520 specifies control target information and/or specifies the tendency settings of output on the basis of the information or the like that can be acquired from the control system 5000b, it is possible to generate the response information that easily meets the request of the information source. Therefore, it is possible to further improve the performance of the response work to the user 1.

### Modification 5-3

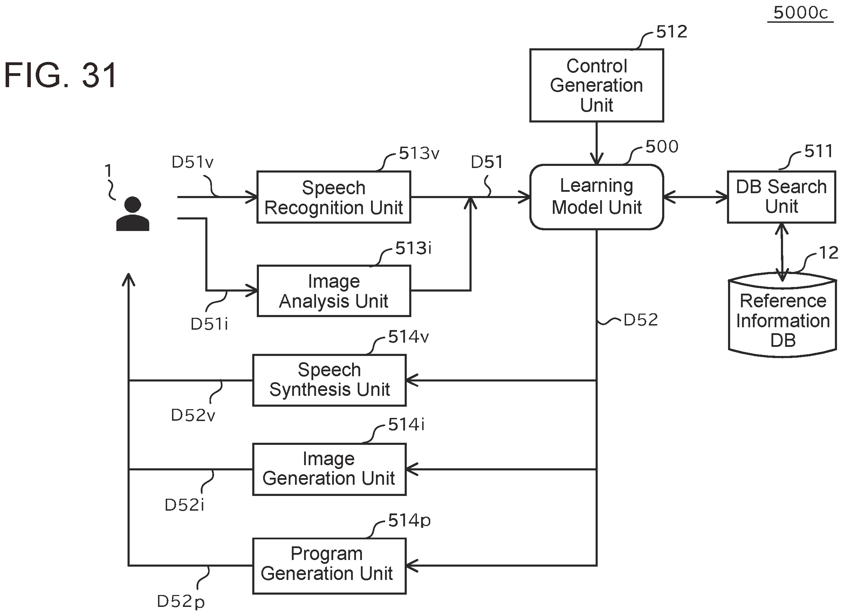

Next, a third modification of the control system 5000 will be described. FIG. 31 is a configuration diagram illustrating an example of a control system 5000c as a modification of the control system 5000 according to the present embodiment. Note that the same elements as those of the control systems 5000, 5000a, and 5000b are denoted by the same reference numerals, and description thereof is omitted.

As illustrated in FIG. 31, the control system 5000c may further include an image analysis unit 513i, an image generation unit 514i, and a program generation unit 514p.

In a case where input information D51i in an image format is included in input from the user 1, the image analysis unit 513i analyzes an image indicated by the input information D51i, converts the image into a format that matches the data format of the learning model unit 500, and outputs the image. For example, the image analysis unit 513i may convert the input information D51i in the image format into input information D51 in a text format.

For example, in a case where the input from the user 1 includes an image obtained by capturing an operation screen of a product possessed by the user 1, the image analysis unit 513i may analyze the image, identify which operation screen of which product the image shows, and what type of operation state the product is in, convert the result into text describing the result, and output text describing the result. Furthermore, for example, in a case where an image obtained by capturing a certain shopping website viewed by the user 1 is included in the input from the user 1, the image analysis unit 513i may analyze the image, identify which operation screen of which website the image shows and what type of operation state the image shows, convert the result into text describing the result, and output the text.

The image generation unit 514i generates and outputs an image on the basis of the response information D52. For example, in a case where the response information D52 as output from the learning model unit 500 includes a data format other than the image format, the image generation unit 514i may generate and output an image indicating the content of the portion indicated by the response information D52. For example, in a case where the response information D52 has a data structure including designation of a data format, the image generation unit 514i may convert a data element for which the image format is specified in the designation into the image format and output the data element. The image generation unit 514i may generate the response information D52v in the image format on the basis of the response information D52 in the text format, for example. For example, the image generation unit 514i may perform synthesis processing of adding the content indicated by the response information D52 in the text format to an image included in the input information D51 as annotation. Furthermore, on the basis of the response information D52 in the text format, the image generation unit 514i may perform processing of highlighting a part of the image included in the input information D51. The image generation unit 514i may generate an image from the input information (response information D52 and input information D51 as necessary) using the learning model.

The program generation unit 514p converts the content indicated by the response information D52 into a data format of a predetermined program and outputs the content. For example, in a case where the response information D52 as output from the learning model unit 500 includes a data format other than the data format of the predetermined program, the program generation unit 514p converts the content of the portion indicated by the response information D52 into the data format of the predetermined program and outputs the content. For example, in a case where the response information D52 has a data structure including designation of a data format, the program generation unit 514p may convert a data element for which the data format of the predetermined program is specified in the designation into the data format of the predetermined program and output the data element. For example, the program generation unit 514p may convert the response information D52 in the text format into the response information D52p in the data format of the predetermined program. The program generation unit 514p may generate the predetermined program from the input information using the learning model.

Image analysis processing by the image analysis unit 513i is performed, for example, in step S511 described above. Furthermore, image generation processing by the image generation unit 514i and program generation processing by the program generation unit 514p are performed, for example, in step S514 described above.

Other points may be similar to those of other control systems of the present embodiment.

As described above, according to the present modification, since an inquiry and a response can be made not only by a speech but also by a speech and an image, it is possible to more effectively respond to an inquiry or the like on an operation screen, for example. In addition, according to the present modification, since a program can also be provided to the information source as the response information in addition to a speech and an image, it is possible to more effectively respond to an inquiry such as trouble handling.

### Modification 5-4

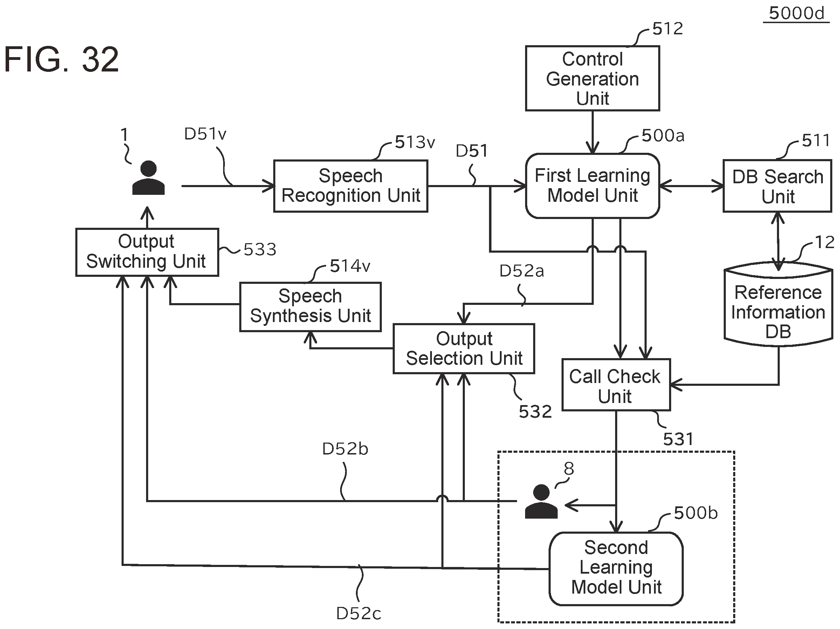

Next, a fourth modification of the control system 5000 will be described. FIG. 32 is a configuration diagram illustrating an example of a control system 5000d as a modification of the control system 5000 according to the present embodiment. Note that the same elements as those of the control systems 5000 to 5000c are denoted by the same reference numerals, and description thereof is omitted.

The present modification has a function of switching to a response by an operator 8 or a response by another learning model on the basis of an inquiry content from the user 1 and/or an output result from a learning model.

As illustrated in FIG. 32, the control system 5000d can further include a call check unit 531 and an output selection unit 532.

It is based on the premise that the control system 5000d includes a learning model unit 500a as a first response function and includes the operator 8 and a communication channel with the operator 8 as a second response function. Furthermore, the control system 5000d may further include another learning model unit 500b having an algorithm or data to be used that is different from that of the learning model unit 500a as a third response function. Note that another learning model unit 500b having an algorithm or data to be used that is different from that of the learning model unit 500a may be included as the second response function. In that case, as the third response function, the operator 8 and the communication channel with the operator 8 may be further included. Note that the type and number of response functions are not particularly limited. For example, the response function switched to may be a response system that does not use a learning model.

In the present example, a case will be described as an example in which the learning model unit 500a serving as the first response function is the learning model unit 500 described above, the second response function is the operator 8 and the communication channel with the operator 8, and the third response function is the other learning model unit 500b having an algorithm or data to be used different from that of the learning model unit 500a.

The learning model unit 500a may be a local learning model that obtains an output result on the basis of local information such as by limiting databases to be referred to, and the learning model unit 500b may be a global learning model that obtains an output result on the basis of global information such as being freely accessible to an external network.

The call check unit 531 switches the processing target on which the response processing is performed on the basis of the inquiry content from the user 1 and/or the output result from the learning model.

The call check unit 531 may call the operator 8 as the second response function, for example, in a case where it is determined that the output by the first response function cannot be expected to be accurate on the basis of the inquiry content from the user 1 and/or the output result from the learning model. For example, the call check unit 531 may call the operator 8 by using the communication channel with the operator 8, and input input information D51 to an operation device of the operator 8. Furthermore, the call check unit 531 may call the operator 8 by using the communication channel with the operator 8, and input the input information D51 to an operation terminal (not illustrated) of the operator 8.

In addition, the call check unit 531 may call the learning model unit 500b as the third response function in a case where it is determined that the call to the second response function is disabled or the output cannot be expected to be accurate. For example, the call check unit 531 may call the learning model unit 500b by inputting the input information D51 to the learning model unit 500b by using an interface with the learning model unit 500b.

Note that the determination of the output accuracy may be made using, for example, an evaluation value or likelihood output by the response function itself, or may be made using the reliability evaluation described above. Furthermore, in a case where the response function itself outputs a message indicating that no answer is found or that it requests calling of another function, it is also possible to determine on the basis of the presence or absence of such a message.

The output selection unit 532 selects the response information D52 to be output to the user 1 on the basis of the switching result of the response processing by the call check unit 531. In a case where the execution subject of the response processing is set to the first response function as a result of switching of the response processing by the call check unit 531, the output selection unit 532 outputs response information D52a, which is output from the first response function, to the user 1. In addition, in a case where the execution subject of the response processing is set to the second response function as a result of switching of the response processing by the call check unit 531, the output selection unit 532 outputs response information D52b, which is output from the second response function, to the user 1. In addition, in a case where the execution subject of the response processing is set to the third response function as a result of switching of the response processing by the call check unit 531, the output selection unit 532 outputs response information D52c, which is output from the third response function, to the user 1.

The output selection unit 532 may output the output from the selected response function to the user 1 by controlling an output changeover switch (not illustrated) that switches the connection path (circuit, communication path, or the like) that connects the response function as the execution subject and the user 1 as the output destination.

Note the connection path between the response function and the user 1 can include various conversion devices such as the speech synthesis unit, the image generation unit, and the program generation unit described above and a predetermined interface as necessary.

For example, in a case where characters input by the operator 8 using the operation terminal are output as the response information D52b, the connection path between the response function and the user 1 may include a speech synthesis unit that converts text into a speech. In addition, the output selection unit 532 can also receive, as output of the second response function or the like, information obtained by correcting the response information D52a output by the first response function. In this case, the operation terminal of the operator 8 includes a text display unit and a text input unit, and the control system 5000d may receive, for example, the response information D52b obtained by correcting a part of the response information D52b output from the operation terminal of the operator 8.

Other points may be similar to those of other control systems of the present embodiment.

As described above, according to the present modification, in addition to generating a response using the learning model unit 500 described above, for example, it is possible to generate a response by the operator or to generate a response using another learning model (including a tandem structure model in which a plurality of models is connected, a multimodal model, or a model learned specifically for a predetermined device or service), and thus, it is possible to further improve the performance of the response work to the user 1.

Note that, in each of the above-described embodiments, an example of the system configuration corresponding to the work of interest has been described; however, the control system according to the present disclosure is not limited to the above-described examples. For example, the control system according to the present disclosure can be implemented by combining one or more of the above-described embodiments as appropriate.

As an example, the control system according to the present disclosure can be a combination of the configuration of the first embodiment and the configuration of the fourth embodiment, and can directly control the target device 2 by inputting information indicating a solution method obtained from sensor data using the function of the fourth embodiment to the control system of the first embodiment to convert the information into a program.

The present embodiments and modifications are not limited to the examples described above, and can be modified as appropriate within the scope of the disclosure.

### INDUSTRIAL APPLICABILITY

A control system according to the present disclosure can be suitably applied as a part of a work assistance system that assists work performed by a person or an object. Furthermore, the control system according to the present disclosure can be suitably applied as a control system that controls a device in a case where some control or work is performed using the device. Here, the control system can also be suitably applied as a control system that controls an FA device, a control system in a home or a building, and a control system that controls an information processing device such as a server device that performs information processing on a network.

### REFERENCE SIGNS LIST

1000, 1000a, 1000b, 1000c, 2000, 3000, 3000a, 3000b, 3000c, 3000d, 3000e, 4000, 4000a, 5000, 5000a, 5000b, 5000d: control system,, 100, 200, 300, 300a, 300b, 400, 400a, 400b, 500, 500a, 500b: learning model unit,, 10, 20: information processing device,, 11: model information storing unit,, 12: reference information storing unit,, 101: model control unit,, 102: input unit,, 103: output unit,, 105: preprocessing unit,, 106: post-processing unit,, 107: model generating unit,, 104, 104a: control unit,, 201: input processing unit,, 202: output check unit,, 203: correction check unit,, 1: user,, 1a: input source,, 2: target device,, 2a: output destination,, 3: operation screen user interface,, 4: controller,, 41-1, 41-2: analysis unit,, 42: switching unit,, 43: output changeover switch,, 5: sensor,, 6: model interface,, 7: display,, 8: operator,, 110, 210, 310, 410: device information storing unit,, 120: execution code generating unit,, 230: state acquisition unit,, 311: input interface,, 312: output interface,, 313: environmental information storing unit,, 511: database search unit,, 512: control generation unit,, 513v: speech recognition unit,, 513i: image analysis unit,, 514v: image synthesizing unit,, 514p: program generation unit,, 515: correctness/incorrectness determination unit,, 516: emotion determination unit,, 517: evaluation acquisition unit,, 518: registration determination unit,, 519: additional learning unit,, 531: call check unit,, 532: output selection unit,, 533: output switching unit,, D101: model input data,, D102: model information,, D103: model output data,, D104: model reference information,, D11, D21, D31, D41, D51, D51v, D51i: input information,, D12: control description,, D22, D34: control command,, D42a, D42b: analysis result,, D52, D52v, D52i, D52p, D52a, D52b, D52c: response information,, D32, D32a, D32b: operation command,, D320: operation information,, D13, D23, D33, D43: device information,, D33a: environmental information,, D14: execution code,, D44a, D44b: result information,, D15, D25, D35, D45: state information,, D16, D26, D36, D46: feedback information,, D17, D27, D37, D47, D57: inquiry,, D18, D28, D38, D48: supplementary information,, D59: evaluation information

## Claims

1. A control system comprising:
a user terminal to generate input information including information indicating control content requested for a device in response to an operation by a user; and
a state acquisition unit to acquire information regarding at least one of a control description generated by a learning model unit that generates the control description on a basis of the input information generated by the user terminal or an operation of the device and to feed back the information to at least one of the user terminal or the learning model unit.

2. The control system according to claim 1, further comprising:
an execution code generating unit to generate an execution code for the device on a basis of the control description generated by the learning model unit, wherein
the learning model unit outputs the generated control description to the execution code generating unit, and
the state acquisition unit acquires information regarding at least one of the control description generated by the learning model unit, the execution code generated by the execution code generating unit, or the operation of the device, and feeds back the information to at least one of the user terminal or the learning model unit.

3. The control system according to claim 1, further comprising:
an execution code generating unit to generate an execution code for the device on a basis of the control description generated by the learning model unit, wherein
the learning model unit outputs the generated control description to the user terminal,
the user terminal, in response to an operation by the user, outputs the control description output by the learning model unit to the execution code generating unit or causes the learning model unit to output the control description to the execution code generating unit, and
the state acquisition unit acquires information regarding at least one of the execution code generated by the execution code generating unit or an operation of the device, and feeds back the information to at least one of the user terminal or the learning model unit.

4. The control system according to any one of claims 1 to 3, wherein the learning model unit uses information, the information stored in a device information storing unit to store information regarding the device, as additional information for generating the control description.

5. The control system according to any one of claims 1 to 4, wherein
the input information generated by the user terminal includes at least one of a document character string describing specifications, specifications, specifications applied to another device, design specifications, an operation command, control codes, or source codes.

6. The control system according to claim 2 or 3,
wherein the user terminal outputs the generated input information to the learning model unit in a case where it is determined that the generated input information does not match a rule, and outputs the generated input information or a corresponding control description to the execution code generating unit in a case where it is determined that the generated input information matches the rule.

7. A control system for assisting work performed by a person or an object using a device, the control system comprising:
an input interface to receive input of first information indicating a situation or a request in a work environment that is an environment in which the work is performed;
a model processing unit provided to be capable of accessing a predetermined learning model; and
an output interface to output second information for assisting the work on a basis of output from the learning model, wherein
the model processing unit inputs model input data based on the first information to the learning model and receives model output data corresponding to the model input data from the learning model,
the model output data includes information used for the work, and
the output interface outputs the second information based on the model output data.

8. The control system according to claim 7, wherein
the first information includes information indicating control content or operation content requested for the device,
the model input data is data in which the control content or the operation content indicated by the first information is indicated in a format matching input to the learning model,
the model output data includes information to be used for control or operation of the device, the information corresponding to the control content or the operation content indicated by the model input data, and
the second information includes information in which the information to be used for the control or the operation of the device and included in the model output data is described in a predetermined format discriminable in an output destination of the output interface.

9. The control system according to claim 8, wherein
the output destination of the output interface is the device or an interface that requests the device to perform control, and
the device is controlled as a result of outputting the second information to the device or the interface requesting the device to perform control.

10. The control system according to claim 8, further comprising:
an execution code generating unit to generate and output an execution code, the execution code executable by the device, wherein
the output destination of the output interface is the execution code generating unit, and
the device is controlled by an execution code generated as a result that the second information is output to the execution code generating unit.

11. The control system according to claim 8, wherein
the output destination of the output interface is a user terminal operated by a user, and
the device is controlled as a result that the second information is output to the user terminal.

12. The control system according to claim 7, wherein
the first information includes information indicating a situation of a work environment,
the model input data is data in which the situation of the work environment indicated by the first information is indicated in a format matching input to the learning model,
the model output data includes information regarding an analysis result of the situation of the work environment indicated by the model input data and/or a method for improving the situation, and
the second information includes information in which the information regarding the analysis result of the situation of the work environment and/or of the method for improving the situation is described in a predetermined format discriminable in the output destination of the output interface.

13. The control system according to claim 7, wherein
the model processing unit is provided to be capable of accessing a first learning model and a second learning model,
the model processing unit inputs first model input data based on the first information to the first learning model, and receives first model output data corresponding to the first model input data from the first learning model, and
the model processing unit inputs second model input data based on the first model output data to the second learning model, and receives second model output data corresponding to the second model input data from the second learning model, and
the output interface outputs the second information based on the second model output data.

14. The control system according to claim 13, wherein
the first information includes information indicating control content or operation content requested for the device,
the first model input data is data in which the control content or the operation content indicated by the first information is indicated in a format matching input to the first learning model,
the first model output data includes information in which the control content or the operation content indicated by the first model input data is indicated by being more generalized or specialized,
the second model input data is data in which the control content or the operation content indicated by the first model output data is indicated in a format matching input to the second learning model,
the second model output data includes information used for control or operation of the device, the information corresponding to the control content or the operation content indicated by the second model input data, and
the second information includes information in which the information used for control or operation of the device included in the second model output data is described in a predetermined format discriminable in the output destination of the output interface.

15. The control system according to claim 13, wherein
the first information includes information indicating a situation of the work environment,
the first model input data is data in which the situation of the work environment indicated by the first information is indicated in a format matching the input to the first learning model,
the first model output data includes an analysis result of the situation of the work environment indicated by the model input data,
the second model input data is data in which the analysis result of the situation of the work environment indicated by the first model output data is indicated in a format matching input to the second learning model,
the second model output data includes information regarding a method for improving the situation of the work environment, the method corresponding to the analysis result of the work indicated by the second model input data, and
the second information includes information in which at least the information regarding the improvement method of the situation of the work environment included in the second model output data is described in a predetermined format discriminable in the output destination of the output interface.

16. The control system according to claim 7, the control system configured for assisting work of response performed by the person or the object using the device, wherein
the first information includes information indicating reaction request content which is content for which a reaction is requested in the work environment,
the model input data is data in which the reaction request content indicated by the first information is indicated in a format matching input to the learning model,
the model output data includes information used for the response, the information corresponding to the reaction request content indicated by the model input data, and
the second information includes information in which the information used for the response included in the model output data is described in a predetermined format discriminable in the output destination of the output interface.

17. The control system according to claim 9, wherein
the output destination of the output interface is a screen operation interface that requests the device to perform control via an operation screen, and
the model output data includes information of the operation screen for actually performing an operation corresponding to the control content or the operation content indicated by the model input data on the device, the information of the operation screen described in a predetermined format discriminable in the output destination of the output interface.

18. The control system according to any one of claims 7 to 17, wherein
the input interface receives input of the first information indicating a request in the work environment from a plurality of users, and
the model processing unit inputs model input data including the first information input from the plurality of users to the learning model and receives model output data corresponding to the model input data from the learning model.

19. The control system according to any one of claims 7 to 18, wherein
the learning model is a language learning model that receives input of a natural language and outputs an output result, an image learning model that receives input of an image and outputs an output result, or a multimodal model that receives input of a natural language and an image and outputs an output result.

20. The control system according to any one of claims 7 to 19, wherein
the model processing unit is provided to be capable of accessing a first learning model and a second learning model,
one of the first learning model or the second learning model is a local learning model in which a reference destination database is limited to internal information, and
another of the first learning model and the second learning model is a global learning model in which a reference destination database is not limited to the internal information.

21. The control system according to any one of claims 7 to 19, wherein
the model processing unit is provided to be capable of accessing a first learning model and a second learning model,
one of the first learning model or the second learning model is a learning model capable of referring to information particularly determined in the work environment, and
another of the first learning model and the second learning model is a learning model incapable of referring to the information particularly determined in the work environment.

22. The control system according to any one of claims 7 to 21, further comprising:
an output check unit to perform a simulation simulating control and a state of the device on a basis of the model output data output from the learning model.

23. The control system according to any one of claims 7 to 22, wherein
additional training of the learning model, correctness and incorrectness determination of output information, or flow control of the output information is performed on a basis of information collected from the output destination of the output interface.

24. The control system according to any one of claims 7 to 23, further comprising:
an input processing unit to inquire an input source in a case where the first information includes unclear or uncertain information.

25. The control system according to any one of claims 7 to 24, wherein
the inquiry includes information indicating correction, addition, or cancellation of content with respect to input and output data of the learning model.

26. The control system according to any one of claims 7 to 25, wherein
the first information is time-series data indicating a situation or a request in the work environment together with time information, the work environment being an environment in which the work is performed.

27. The control system according to any one of claims 7 to 25, further comprising, as an execution environment of the learning model:
a model information storing unit to store information of a model; and
a model control unit to receive the model input data and to output the model output data on a basis of the model input data and information stored in the model information storing.

28. A control method comprising:
by a user terminal, generating input information including information indicating control content requested for a device in response to an operation by a user; and
by a state acquisition unit, acquiring information regarding at least one of a control description generated by a learning model unit that generates the control description on the basis of the input information generated by the user terminal or an operation of the device, and feeding back the information to at least one of the user terminal or the learning model unit.

29. A control method for assisting work performed by a person or an object using a device, the control method comprising:
by an input interface, receiving input of first information indicating a situation or a request in a work environment that is an environment in which the work is performed;
by a model processing unit provided to be capable of accessing a predetermined learning model, inputting model input data based on the first information to the learning model and receiving model output data corresponding to the model input data from the learning model, the model output data including information used for the work; and
by an output interface, outputting second information for assisting the work on the basis of output from the learning model, the second information based on the model output data.
